(19) Europäisches Patentamt
European Patent Office
Office européen des brevets

(11) EP 0 968 507 B1

(12) **EUROPÄISCHE PATENTSCHRIFT**

(45) Veröffentlichungstag und Bekanntmachung des Hinweises auf die Patenterteilung:
**15.12.2004 Patentblatt 2004/51**

(21) Anmeldenummer: **98913727.8**

(22) Anmeldetag: **18.03.1998**

(51) Int Cl.$^7$: **H01G 9/20**

(86) Internationale Anmeldenummer:
**PCT/EP1998/001558**

(87) Internationale Veröffentlichungsnummer:
**WO 1998/048433 (29.10.1998 Gazette 1998/43)**

(54) **PHOTOVOLTAISCHE ZELLE**

PHOTOVOLTAIC CELL

CELLULE PHOTOVALTAIQUE

(84) Benannte Vertragsstaaten:
**DE FR GB NL**

(30) Priorität: **20.03.1997 DE 19711713**

(43) Veröffentlichungstag der Anmeldung:
**05.01.2000 Patentblatt 2000/01**

(73) Patentinhaber: **Covion Organic Semiconductors GmbH
65926 Frankfurt (DE)**

(72) Erfinder:
- **BACH, Udo
CH-1020 Renens (CH)**
- **GRÄTZEL, Michael
CH-1015 St. Sulpice (CH)**
- **SALBECK, Josef
D-65779 Kelkheim (DE)**
- **WEISSOERTEL, Frank
D-65929 Frankfurt am Main (DE)**
- **LUPO, Donald
D-60316 Frankfurt am Main (DE)**

(74) Vertreter: **Luderschmidt, Schüler & Partner GbR
Patentanwälte
Industriepark Höchst,
Gebäude F 821
65926 Frankfurt (DE)**

(56) Entgegenhaltungen:
**EP-A- 0 333 641**
**EP-A- 0 676 461**
**WO-A-97/10617**

EP 0 968 507 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

Printed by Jouve, 75001 PARIS (FR)

## Beschreibung

Aufgrund des weltweit steigenden Bedarfs an elektrischer Energie und der begrenzten Vorräte an Kohle, Öl und Gas, die bei ihrer Verbrennung zudem das Treibhausgas $CO_2$ freisetzen, hat die Erzeugung von elektrischem Strom aus Sonnenlicht in den letzten Jahre erhöhtes Interesse gefunden.
Unter einer photovoltaischen Zelle versteht man ein Bauelement, in dem Licht direkt in elektrische Energie umgewandelt wird. Es enhält neben zwei Elektroden mindestens eine lichtabsorbierende Schicht und eine Ladungstransportschicht. Handelt es sich um Sonnenlicht, spricht man von einer Solarzelle.
Obwohl der photovoltaische Effekt, d. h. das Auftreten einer Spannung über einem pn-Übergang bei Einstrahlung von Licht, bereits 1893 von Becquerel beobachtet wurde, gelang es erst mit der Entwicklung der Halbleitertechnik in den vierziger und fünfziger Jahren dieses Jahrhunderts, die ersten funktionsfähigen Solarzellen herzustellen.
Da die Spannung einer einzelnen Solarzelle im allgemeinen gering ist (typischerweise < 1V), werden Zellen üblicherweise in Serie zu sogenannten Modulen zusammengeschaltet.

Die heute verwendeten Solarzellen enthalten üblicherweise als lichtabsorbierende Schicht ein Halbleitermaterial, in den meisten Fällen Silizium, das für diese Anwendung allerdings höchsten Ansprüchen an die Reinheit und Qualität der Verarbeitung genügen muß. Dadurch sind Solarzellen heute bei vielen Anwendungen aus Kostengründen nicht konkurrenzfähig.
Demgegenüber wird in einer Farbstoff-sensibilisierten Solarzelle, wie sie in den sechziger Jahren von H. Tributsch entwickelt wurde, als Halbleiter ein Material mit sehr großer Bandlücke, wie Titandioxid, verwendet. Ein solcher Halbleiter absorbiert das Sonnenlicht nur wenig, hierfür wird auf den Halbleiter ein Farbstoff (Chromophor) aufgetragen.
Wird in einem Farbstoffmolekül ein Photon absorbiert, so bewirkt dieses die Anregung eines Elektrons in den niedrigsten unbesetzten Molekülzustand. Aus diesem kann es dann in das Leitungsband des Halbleiters injiziert werden. Der Halbleiter dient also überwiegend dem Transport von Elektronen. Hierfür ist keine besondere Reinheit und Perfektion des Materials notwendig. Die Halbleiterschicht kann z. B. aus einer Pulversuspension einfach auf leitfähiges Glas gestrichen werden.

Aus WO 97/10617 ist eine photovoltaische Zelle, die eine Ladungstransportschicht enthaltend ein Lochleitermaterial aufweist, bekannt.

In der EP-A 0 333 641 ist eine photoelektrochemische Zelle beschrieben, die dadurch gekennzeichnet ist, daß sie einen nanoporösen, d. h. eine extrem aufgerauhte und damit vergrößerte Oberfläche aufweisenden Metalloxid-Halbleiter enthält. Der Ladungstransport zwischen Halbleiter/Chromophor-Schicht und Gegenelektrode erfolgt in dieser Zelle durch eine Elektrolytlösung.
Obwohl mit solchen Zellen gute Ergebnisse erzielt werden, ist das Eigenschaftsprofil einer solchen Vorrichtung noch deutlich verbesserungsfähig. Das Elektron wird durch die Diffusion von Ionen an den Farbstoff zurückgeführt. Dadurch kommen nur Redoxsysteme in Frage, die klein genug sind, um in die Poren der nanokristallinen Halbleiterschicht einzudringen. Bei dem bisher besten Redox-System, $I^-/I_3^-$, geht wegen schlechter Anpassung der Energieniveaus zwischen Farbstoff und Redox-System ungefähr 40 % der theoretisch zur Verfügung stehenden Energie als Wärme verloren, und der Wirkungsgrad für die Energiekonversion ist auf ca. 10 % im direkten Sonnenlicht begrenzt.
Ein weiterer Nachteil dieses Redox-Systems ist, daß das chemisch aggressive Triiodid extreme Forderungen an Versiegelungsmittel stellt, sowie auch an Isolierund Leiterbahnen, die für die Serienverschaltung der Zellen in Modulen notwendig sind. Dieser Nachteil bedeutet, daß es sehr aufwendig ist, stabile Zellen und Module herzustellen, und daß wegen der aufwendigen Technik der Versiegelung die Herstellungskosten steigen.

Es wurde nun überraschend gefunden, daß sich die oben beschriebenen Nachteile verringern lassen, wenn der das $I^-/I_3^-$ Redoxsystem enthaltende Elektrolyt in der oben beschriebenen Zelle durch einen Elektrolyten ersetzt wird, in dem eine Lochleiterverbindung die Rolle des Redoxsystems übernimmt.
Gegenstand der Erfindung ist daher eine photovoltaische Zelle, gemäß Anspruch 1 sowie eine Verwendung mit den Merkmalen des Anspruchs 13.
Vorzugsweise besteht das Redoxsystem aus einer oder mehreren Lochleiterverbindungen. Durch die Verwendung einer Lochleiterverbindung anstelle von $I^-/I_3^-$ können die Energieniveaus von Redoxsystem und Farbstoff besser angepaßt werden, um eine bessere Nutzung der absorbierten Energie zu ermöglichen, so daß der Wirkungsgrad für Sonnenlicht verbessert werden kann. Ferner wird mit dem Ersatz des aggressiven Triiodids durch Lochleiterverbindungen die Verwendung von preiswerteren Versiegelungsschichten und Isolier- und Leiterbahnen sowie einfachere Herstellverfahren für Zellen und Module ermöglicht.

In Fig. 1 ist eine bevorzugte Ausführungsform der erfindungsgemäßen Zelle 1 dargestellt (nicht maßstabsgetreu).
Auf einem leitenden Träger 11, der als Elektrode bzw. Kontakt dienen kann und beispielsweise aus einem Metall oder Indium-Zinn-Oxid (ITO) besteht, ist als lichtabsorbierende Schicht ein Halbleiter 12 aufgebracht, der vorzugsweise eine Oberfläche mit einem Rauheitsfaktor > 1 hat. Vorzugsweise enthält die erfindungsgemäße Zelle auf der Oberfläche des Halbleiters einen Chromophor, hier als Chromophorschicht 13 dargestellt. Die Bezeichnung lichtabsorbierende

Schicht umfaßt im Sinne der Erfindung sowohl eine Halbleiterschicht als auch eine Kombination Halbleiter/Chromophor, auch wenn die eigentliche Absorption in diesem Fall nahezu ausschließlich durch den Chromophor erfolgt. Daran schließt sich der Elektrolyt 14 an, der erfindungsgemäß eine Lochleiterverbindung der Formel (I) enthält. Er wird auf der einen Seite durch eine Gegenelektrode 15 begrenzt, die beispielsweise aus einem leitfähigen Glas, leitfähig beschichtetem Kunststoff, aus Metall oder einem anderen leitfähigen, vorzugsweise lichtdurchlässigen Material, bestehen kann. Die Zelle 1 ist oben und unten durch je eine isolierende Schicht 16 bzw. 17 versiegelt. Sie kann einen, in der Figur nicht gezeigten seitlichen Abschluß enthalten, beispielsweise einen Rahmen aus einem elektrisch isolierendem Material, wie Kunststoff oder Glas. Zumindest eine Seite der Zelle muß für das in elektrische Energie zu wandelnde Licht durchlässig sein, so daß dieses zu dem Chromophor bzw. dem Halbleiter gelangen kann.

Die erfindungsgemäße Zelle enthält darüber hinaus in der Figur nicht gezeigte Vorrichtungen zur Abnahme des von der Zelle erzeugten elektrischen Stroms.

Als Lochleiter im Sinne der Erfindung gilt ein Material, das eine positive Ladung leiten kann, die durch das Fehlen eines Elektrons zustande kommt, wobei Massentransport und Ladungstransport im festen Zustand entkoppelt sind. In der erfindungsgemäßen Zelle liegt das erfindungsgemäß eingesetzte Lochleitermaterial der Formel (I) gelöst in der Elektrolytflüssigkeit vor, und der Ladungstransport erfolgt durch die Diffusion der neutralen oder oxidierten Formen des Lochleiters.

Ein Überblick über den Stand der Technik bei Lochleitern kann in *Encyclopedia of Chemical Technology* 18 (1996), S. 837-860 gefunden werden.

Allgemein eignen sich elektronenreiche, vorzugsweise organische Verbindungen, die, vorzugsweise reversibel, oxidierbar sind. Es wird allgemein angenommen, daß der Ladungstransport in einem organischen Lochleitermaterial über die Bildung von Radikalkationen erfolgt.

Das Oxidationspotential ist dabei in weiten Bereichen variabel und kann an die spezifischen Energieniveaus des Halbleiters oder Sensibilisators angepaßt werden. Das erste Oxidationspotential liegt vorzugsweise zwischen dem Energienieveau des Grundzustands und 700, vorzugsweise 400, besonders bevorzugt 300, mV oberhalb des Grundzustands.

Bevorzugt sind Lochleiterverbindungen, die in organischen oder anorganischen Lösungsmitteln löslich sind. Beispiele für organische Lösungsmittel, auf die aber die Erfindung nicht eingeschränkt ist, sind Chloroform, Benzol, Chlorbenzol, Cyclohexanon, Toluol, Tetrahydrofuran, Anisol, Cresol, Xylol, Methyllaktat, Methylenchlorid, Hexan, Nitrilverbindungen, oder andere aliphatische, aromatische oder alkoholische Lösungsmittel, wobei auch voll- oder teilfluorierte Formen bevorzugt sind. Es reicht für die Herstellung einer erfindungsgemäßen Lochleiterschicht, wenn das Lochleitermaterial in einem entsprechenden Lösungsmittel löslich ist. Löslich im Sinne der Erfindung bedeutet dabei eine Löslichkeit von mindestens 1,0 g/l bei 25°C in einem organischen oder anorganischen Lösungsmitel, vorzugsweise in einem der oben aufgeführten Lösungsmittel.

Weiterhin besonders bevorzugt sind Lochleitermaterialien, die auf Grund ihrer Größe in die Poren einer rauhen Halbleiterschicht eindiffundieren können.

Dazu ist es bevorzugt, daß Lochleiterverbindungen, die als Redoxsystem verwendet werden, eine vergleichbare molekulare Dimension wie die, gegebenenfalls verwendeten, Moleküle des Sensibilisators (Chromophor) aufweisen, damit die Moleküle in engen Kontakt mit den in den Poren der Halbleiteroberfläche sitzenden Sensibilisatormolekülen kommen können. Besonders bevorzugt sind die Lochleitermoleküle weniger als den Faktor 20, ganz besonders bevorzugt 10, größer als entsprechende Sensibilisatormoleküle.

Beispiele organischer Lochleiter, auf die die Erfindung nicht eingeschränkt ist, sind Triphenylmethane, Carbazole, und N,N'-Diphenyl-N,N'-bis(3-methylphenyl)-(1,1'-biphenyl)-4,4'-diamine (TPD).

Spiroverbindungen sind Verbindungen in denen zwei Ringsysteme durch ein einziges, vierbindiges Atom verknüpft sind. Dieses Atom wird als Spiroatom bezeichnet, wie in Handbook of Chemistry and Physics $62^{nd}$ ed. (1981-2), CRC Press, S. C-23 bis C-25 ausgeführt ist. Der Begriff Spiroverbindung bedeutet im Sinne der Erfindung monomere und polymere Carbospiro- und Heterospiroverbindungen.

Bevorzugte Verbindungen der Formel (I) sind 9,9'-Spirobifluorenderivate der Formel (II),

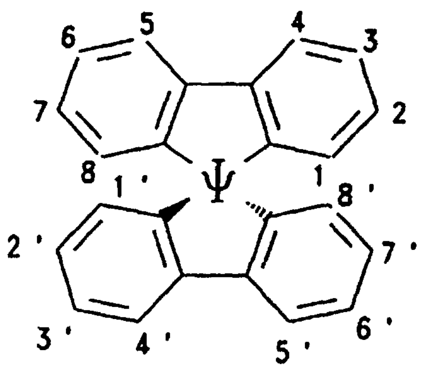

(II)

wobei ψ die oben angegebenen Bedeutungen hat und wobei die Benzogruppen unabhängig voneinander substituiert und/oder anelliert sein können.

Besonders bevorzugt sind Spirobifluorenderivate der Formel (III),

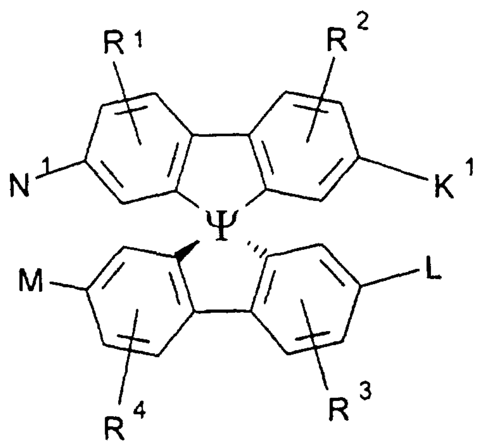

(III)

wobei die Symbole und Indizes folgende Bedeutungen haben:

ψ ist C, Si, Ge oder Sn, vorzugsweise C, Si, Ge, besonders bevorzugt C, Si, ganz besonders bevorzugt C,
$K^1$ , L, M, $N^1$, $R^1$, $R^2$, $R^3$, $R^4$ sind gleich oder verschieden und bedeuten

a) Wasserstoff, $NO_2$, -CN, -F oder -Cl,
b) einen geradkettigen oder verzweigten Alkylrest mit 1 bis 20 C-Atomen, wobei

b1) eine oder mehrere nicht benachbarte $CH_2$-Gruppen durch -O-, -S-, - CO-O-, -O-CO-, -O-CO-O-, $NR^5$ oder -$Si(CH_3)_2$- ersetzt sein können und/oder
b2) eine oder mehrere $CH_2$-Gruppen durch -CH=CH-, -C≡C-, 1,4-Phenylen, 1,4-Cyclohexylen oder 1,3-Cyclopentylen ersetzt sein können und/oder
b3) ein oder mehrere H-Atome durch F und/oder Cl ersetzt sein können und/oder

c) eine der folgenden Gruppen:

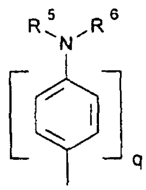

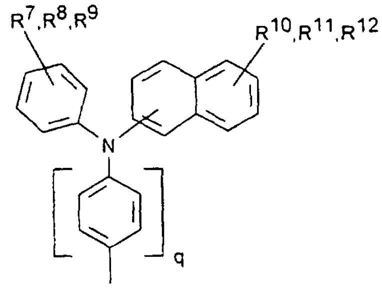

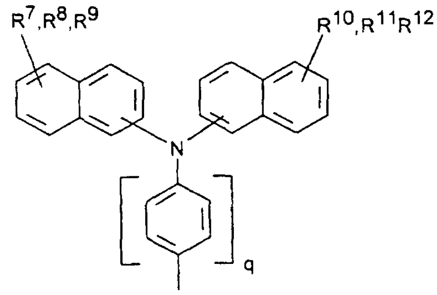

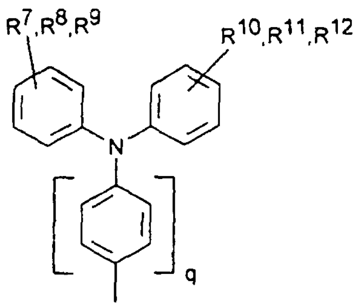

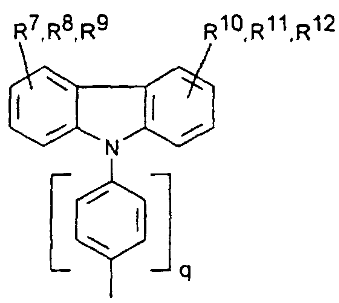

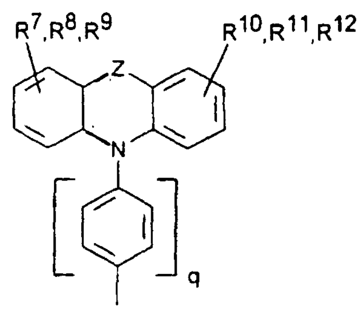

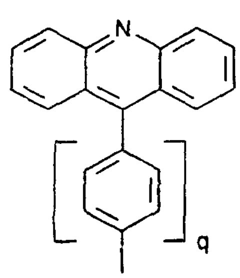

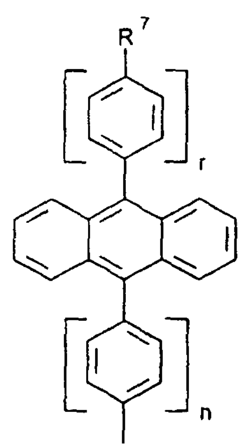

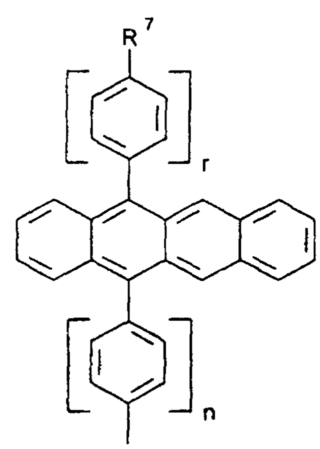

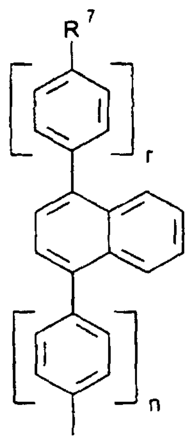

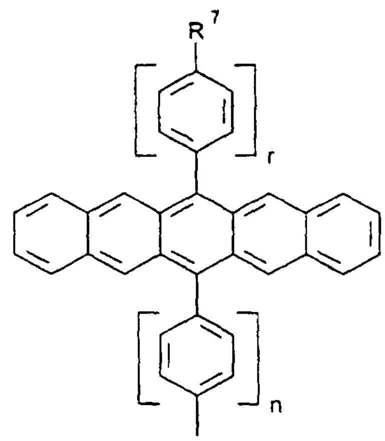

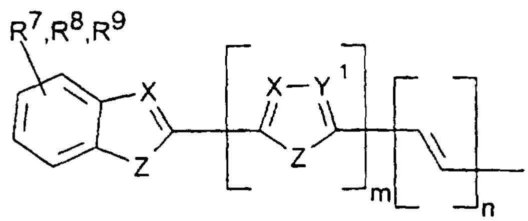

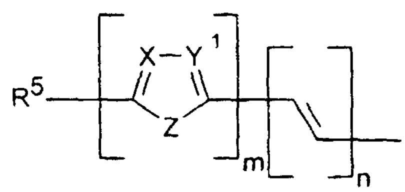

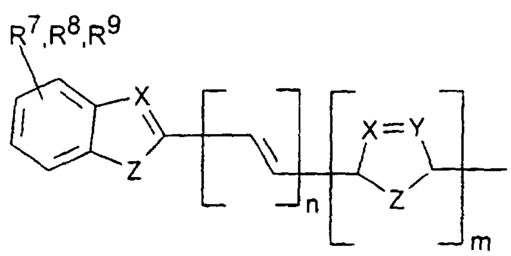

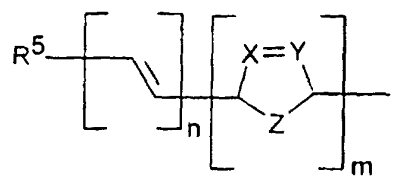

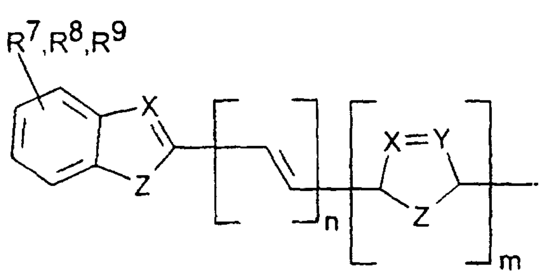

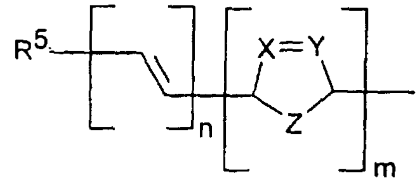

| | |
|---|---|
| X, $Y^1$ | sind jeweils gleich oder verschieden $=CR^7$- oder =N-; |
| Z | ist -O-, -S-, $-NR^5-$, -CRR-, -CR=CR- oder -CR=N-; |
| $R^5$, $R^6$ | sind jeweils gleich oder verschieden |

a) Wasserstoff

b) ein geradkettiger oder verzweigter Alkylrest mit 1 bis 20 C-Atomen, wobei

b1) eine oder mehrere nicht benachbarte und nicht an Stickstoff gebundene $CH_2$-Gruppen durch -O-, -S-, -CO-O-, -O-CO-, - O-CO-O- oder $-Si(CH_3)_2$ ersetzt sein können und/oder
b2) eine oder mehrere $CH_2$-Gruppen durch -CH=CH-, -C≡C-, Cyclopropan-1,2-diyl, 1,4-Phenylen, 1,4-Cyclohexylen oder 1,3-Cyclopentylen ersetzt sein können und/oder
b3) ein oder mehrere H-Atome durch F und/oder Cl ersetzt sein können und/oder
b4) $R^5$ und $R^6$ zusammen auch einen Ring bilden können;

c) Phenyl, Biphenyl, 1-Naphthyl, 2-Thienyl, 2-Furanyl;

$R^7$, $R^8$, $R^9$, $R^{10}$, $R^{11}$, $R^{12}$ sind gleich oder verschieden

a) Wasserstoff, -CN, -F, $NO_2$ oder -Cl
b) ein geradkettiger oder verzweigter Alkylrest mit 1 bis 20 C-Atomen, wobei

b1) eine oder mehrere nicht benachbarte $CH_2$-Gruppen durch -O-, -S-, -CO-O-, -O-CO-, -O-CO-O-, $-NR^5$ oder $-Si(CH_3)_2$- ersetzt sein können und/oder
b2) eine oder mehrere $CH_2$-Gruppen durch -CH=CH-, -C≡C-, Cyclopropan-1,2-diyl, 1,4-Phenylen, 1,4-Cyclohexylen oder 1,3-Cyclopentylen ersetzt sein können und/oder
b3) ein oder mehrere H-Atome durch F und/oder Cl ersetzt sein können;

c) Phenyl, Biphenyl, 1-Naphthyl, 2-Naphthyl, 2-Thienyl, 2-Furanyl, -O-Phenyl, -O-Biphenyl-, -O-1-Naphthyl, -O-2-Naphthyl, -O-2-Thienyl, -O-2-Furanyl;

m, n, p, q, r sind jeweils gleich oder verschieden 0, 1, 2, 3, 4, 5 oder 6, vorzugsweise 0, 1, 2, 3, 4, 5 oder 6, vorzugsweise 0, 1, 2, 3, 4, besonders bevorzugt 0, 1, 2 oder 3.

Ganz besonders bevorzugt sind Spirobifluorenderivate der Formeln (IV) a-c

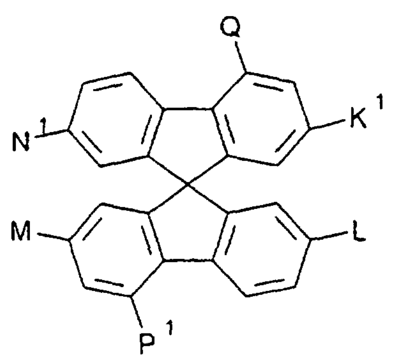

(IV)

wobei die Symbole folgende Bedeutungen haben:
IV.a)$K^1$=L=M=$N^1$=

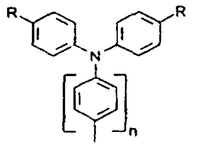
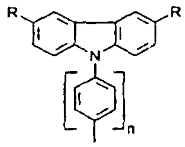
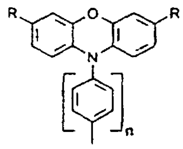
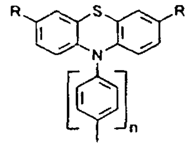

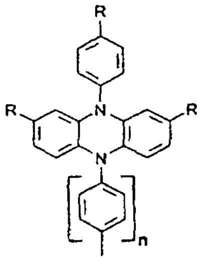
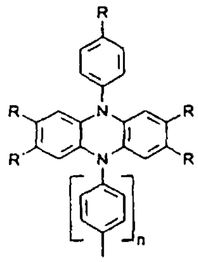
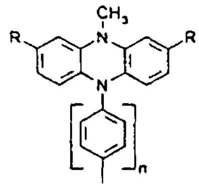
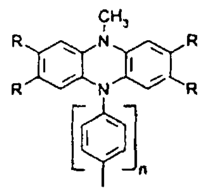

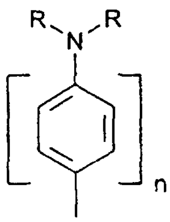
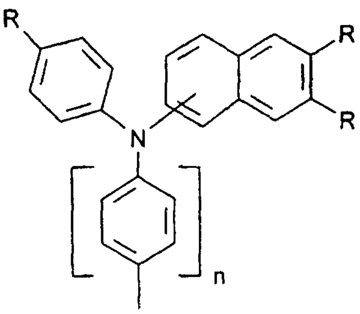
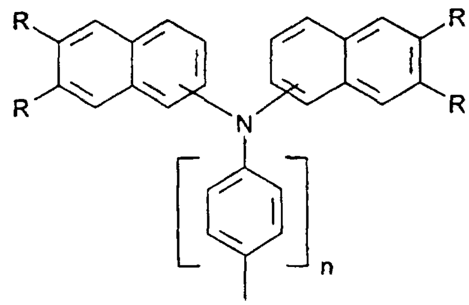
.

R gleich oder verschieden H, Alkyl, -O-Alkyl, -S-Alkyl, mit jeweils 1 bis 20 C-Atomen, vorzugsweise 1 bis 4 C-Atomen, Phenyl, Biphenyl, 1-Naphthyl, 2-Naphthyl, 2-Thienyl, 2-Furanyl, -O-Phenyl, -O-Biphenyl, -O-1-Naphthyl, -O-2-Naphthyl, -O-2-Thienyl, -O-2-Furanyl, -CN, $NR_2^+$, wobei O-Alkyl/Aryl, S-Alkyl/Aryl, CN und $NR_2$ nicht an Stickstoff gebunden sein dürfen ;

n = 0,1,2,3,4.

und Q, $P^1$ sind gleich oder verschieden und aus der Gruppe
H, COOR, $CH_2OR$,

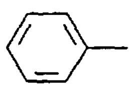
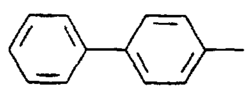
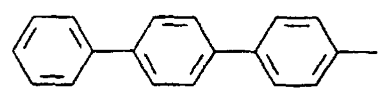

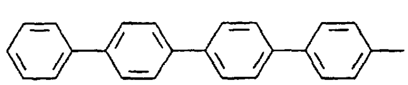
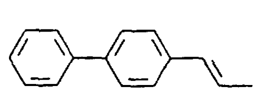
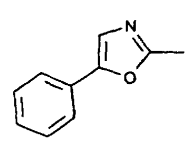

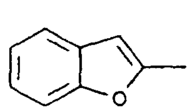
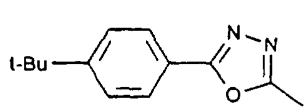
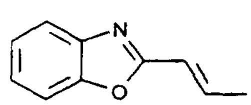

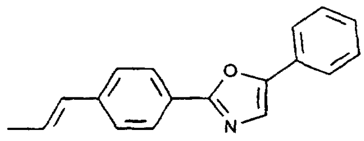
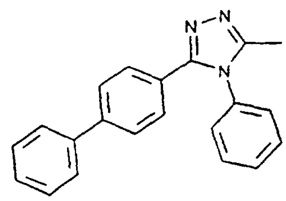
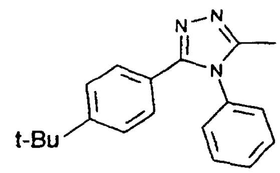

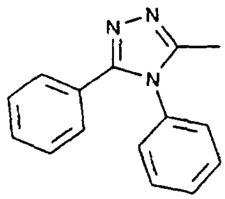
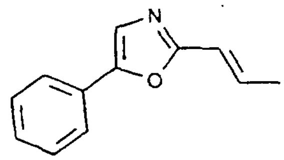
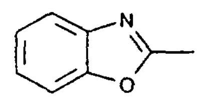

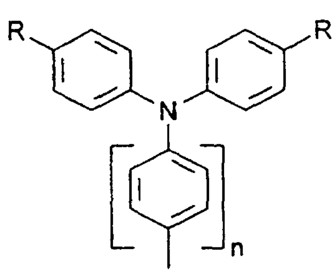
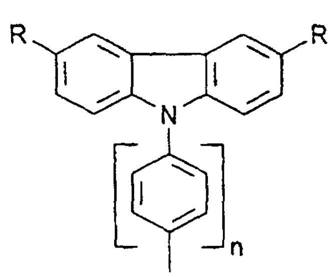
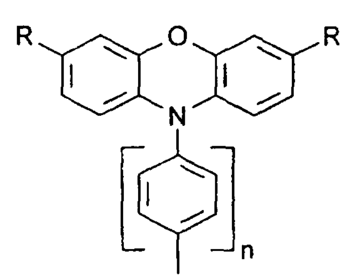

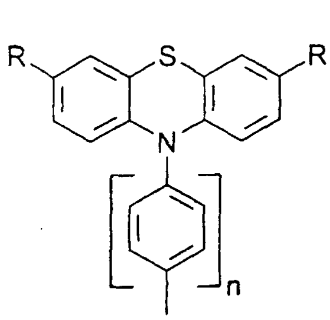
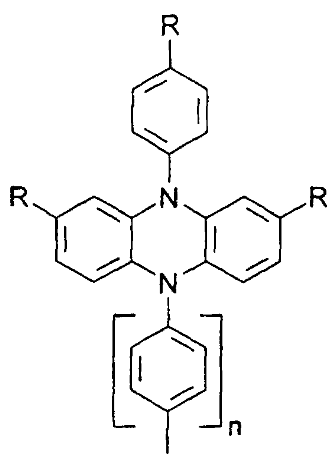
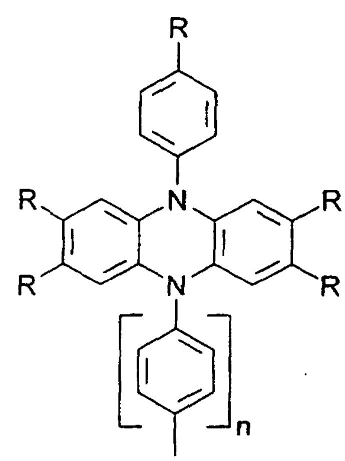

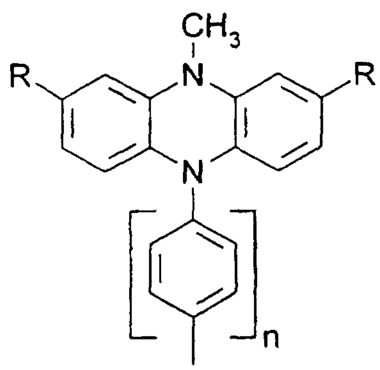

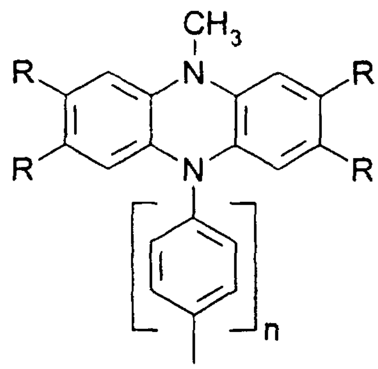

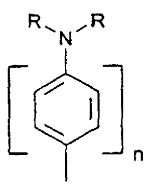

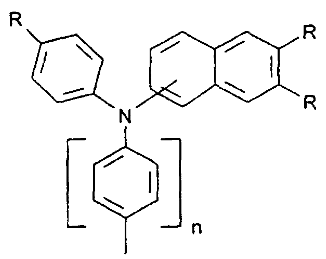

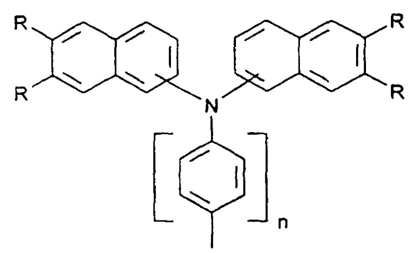

wobei die Symbole und Indizes die oben angegebenen Bedeutungen haben

IV.b) $K^1 = N^1$ und ist aus der Gruppe

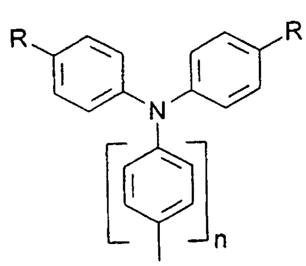

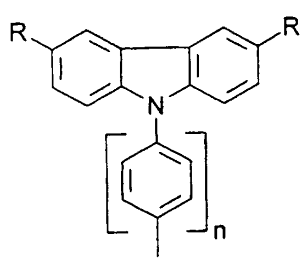

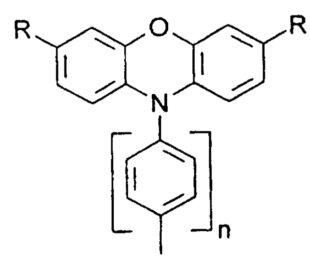

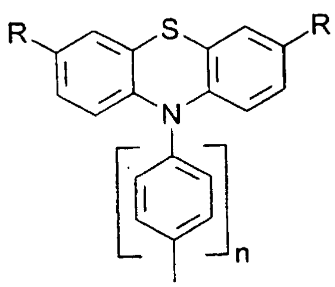

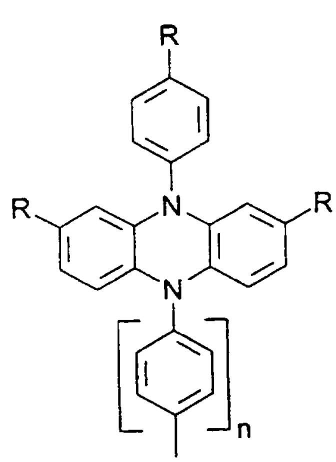

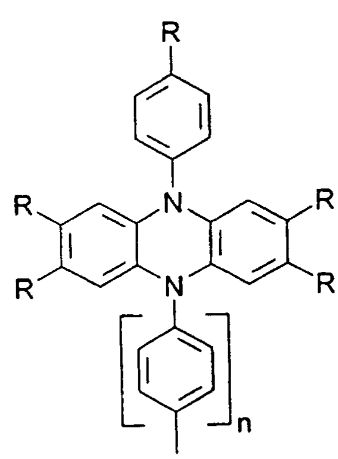

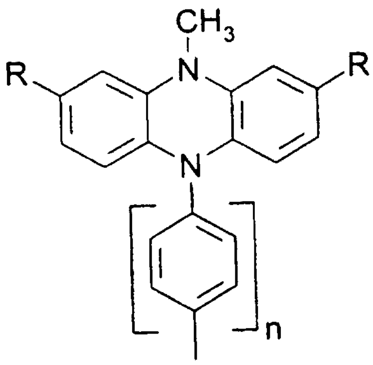

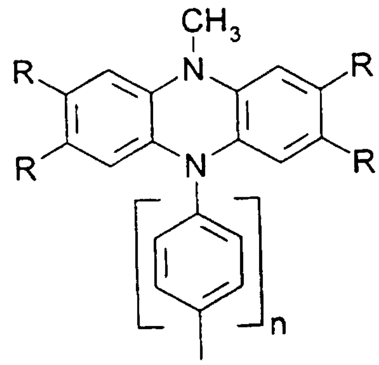

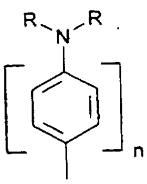

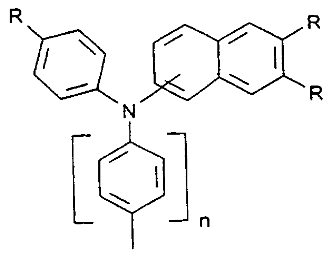

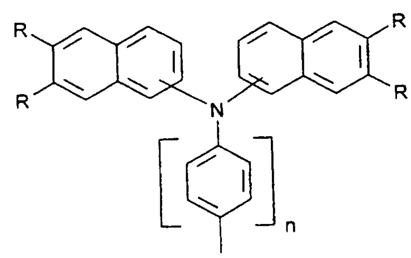

und L = M und ist aus der Gruppe
H, COOR, $CH_2OR$,

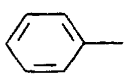

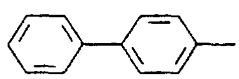

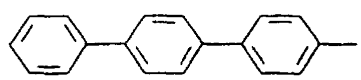

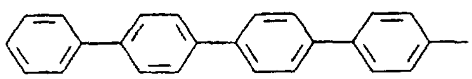

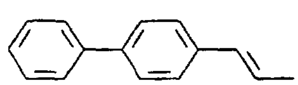

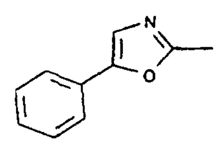

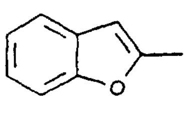

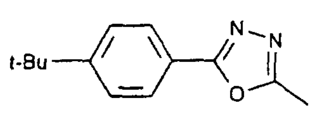

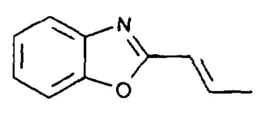

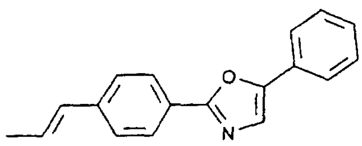
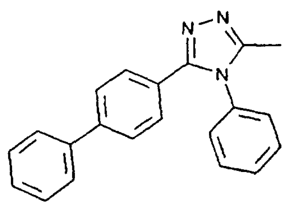
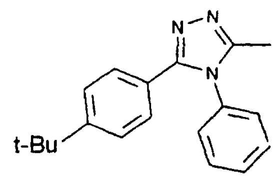

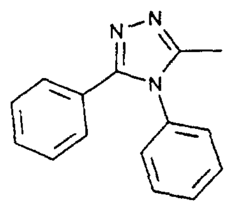
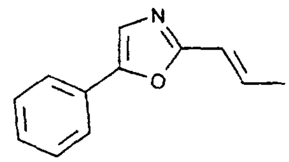
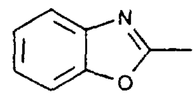

und Q, $P^1$ sind gleich oder verschieden aus der Gruppe

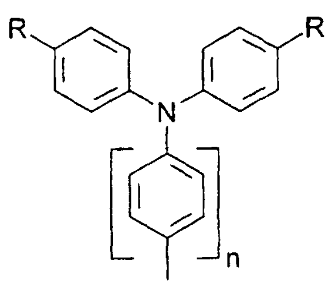
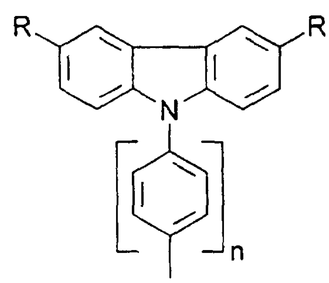
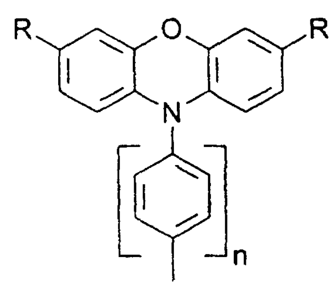

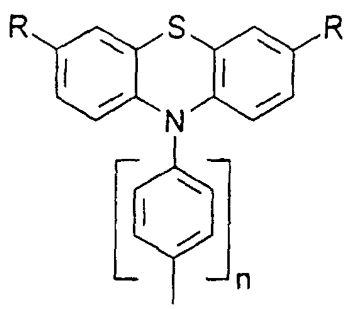
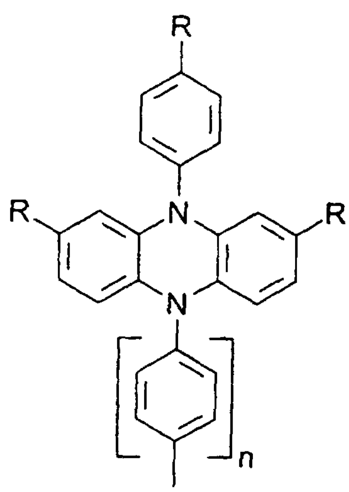
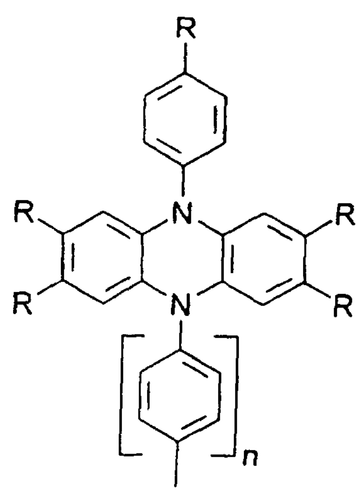

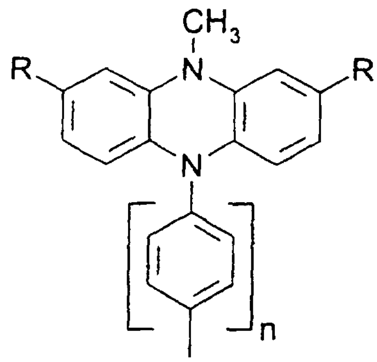
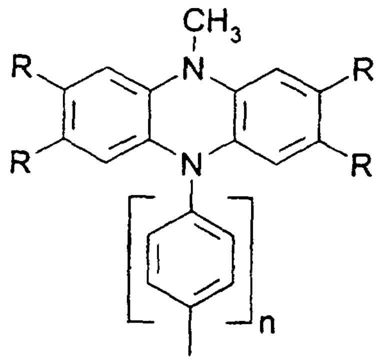

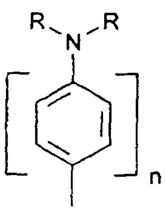
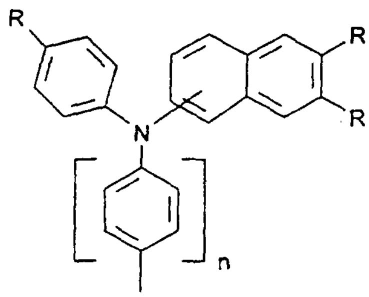
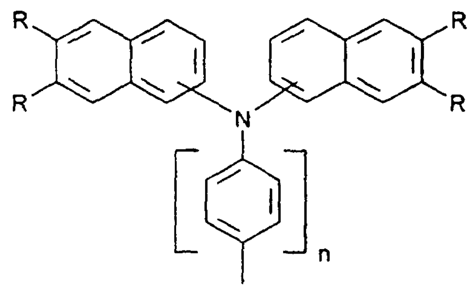

H, COOR, $CH_2OR$,

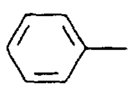
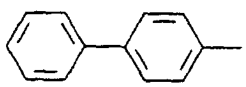
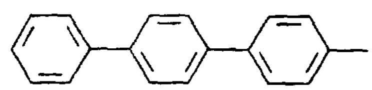

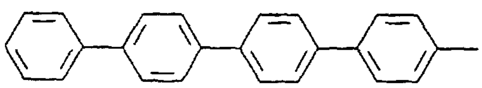
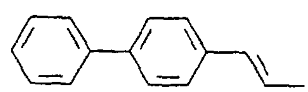
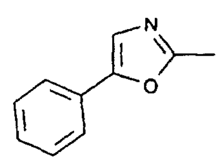

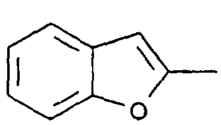
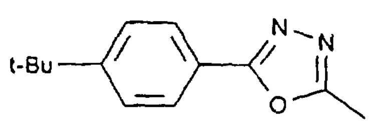
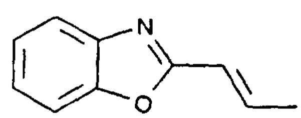

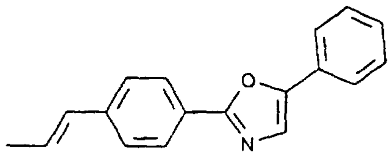
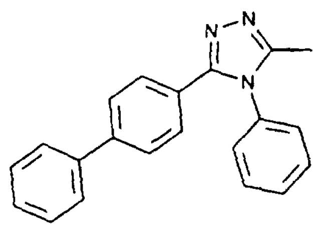
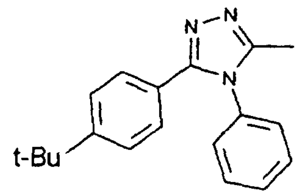

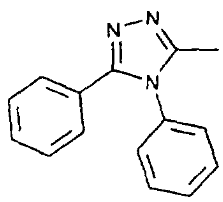
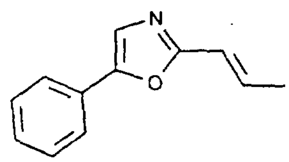
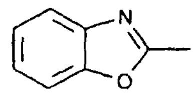

wobei die Symbole und Indizes die oben angegebenen Bedeutungen haben;

IVc) $K^1$ = M und ist aus der Gruppe

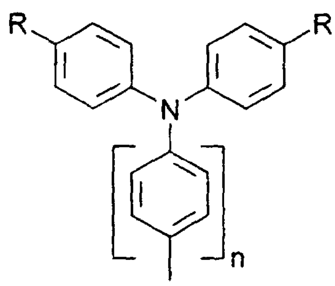
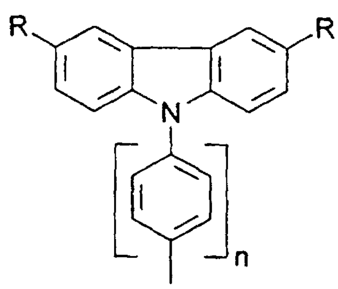
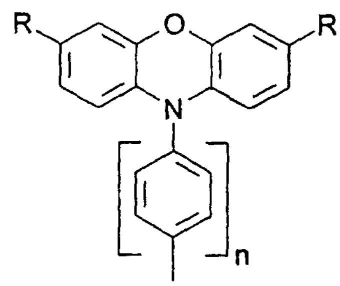

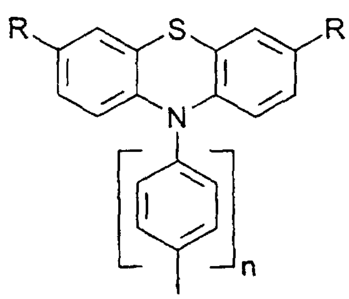
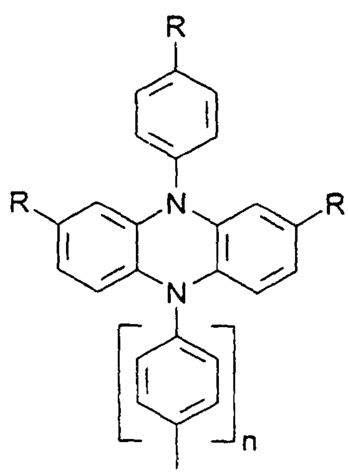
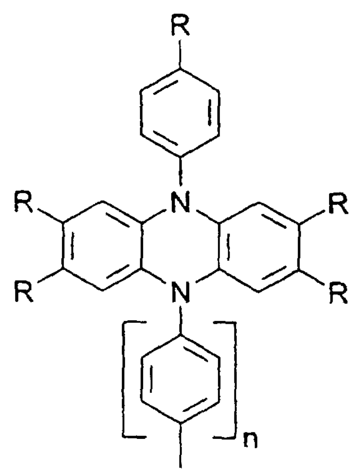

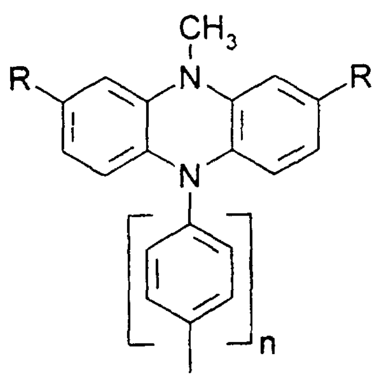
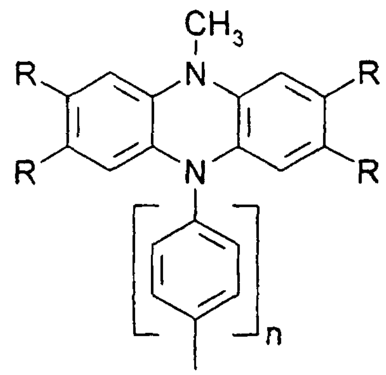

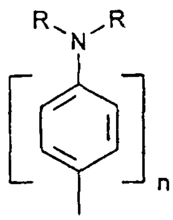
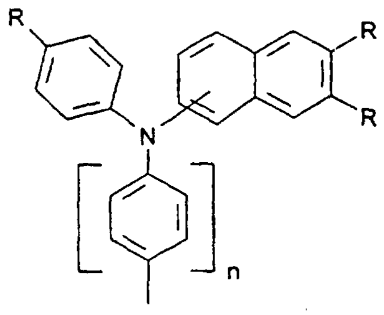
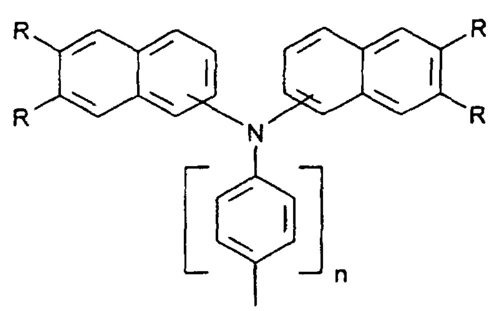

und $M = N^1$ ist und aus der Gruppe
H, COOR, $CH_2OR$,

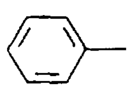
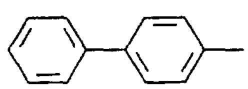
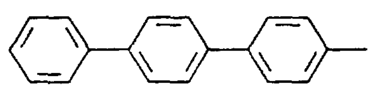

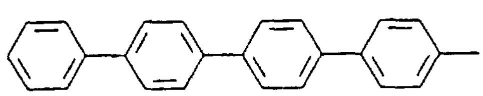
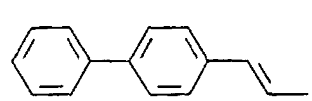
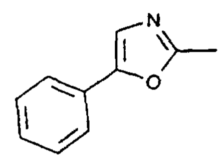

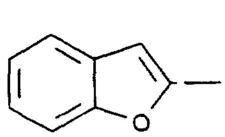
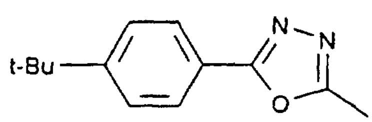
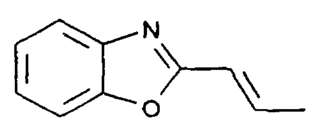

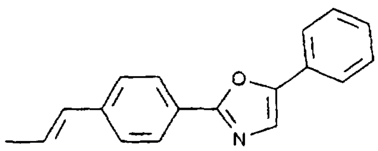
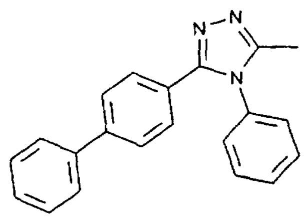
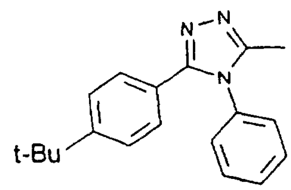

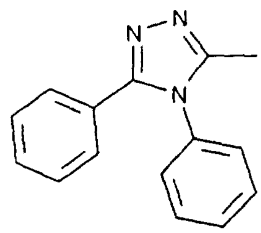
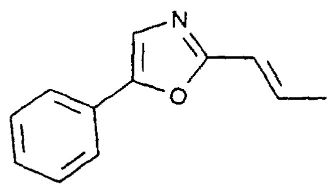
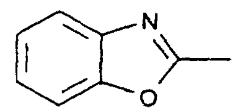

und Q, $P^1$ sind gleich oder verschieden aus der Gruppe

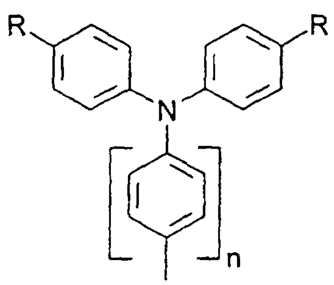
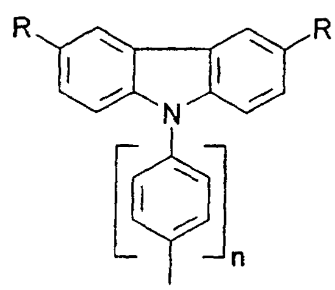
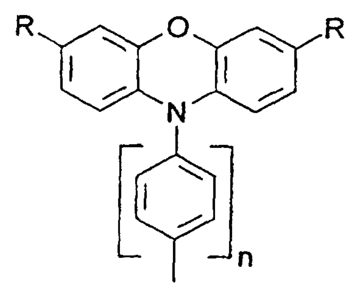

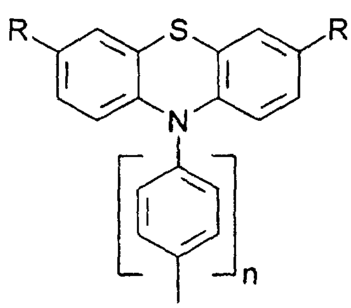
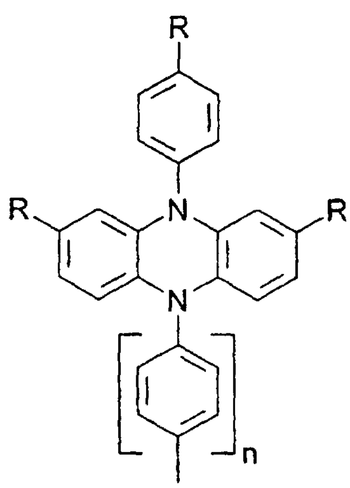
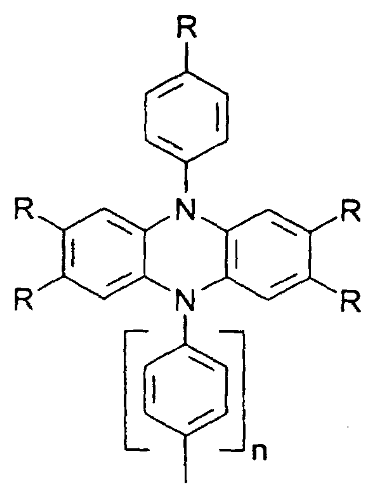

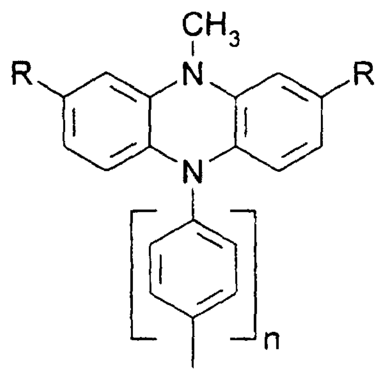

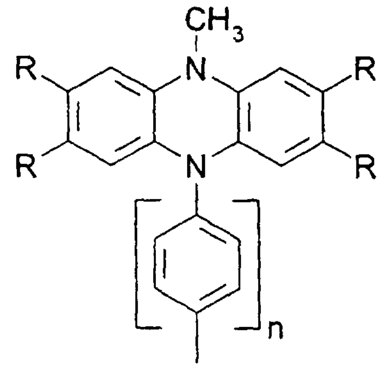

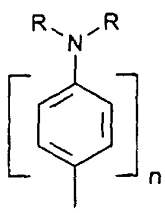

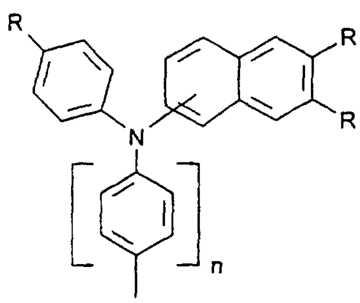

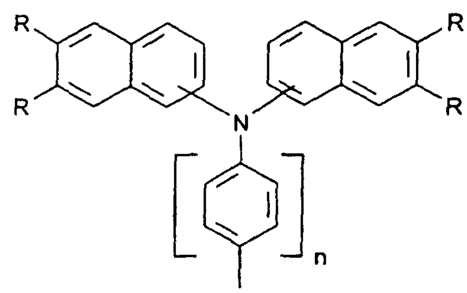

H, COOR, $CH_2OR$,

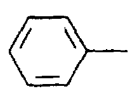

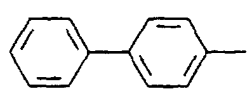

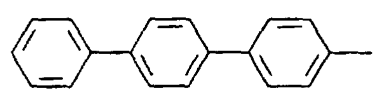

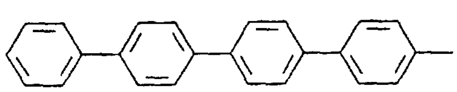

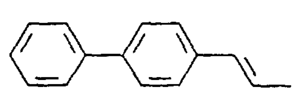

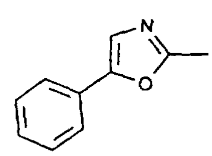

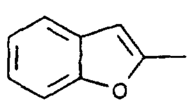

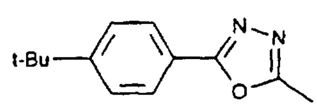

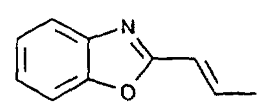

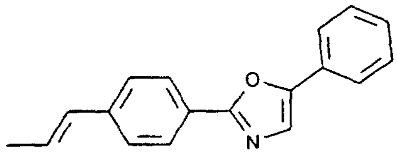
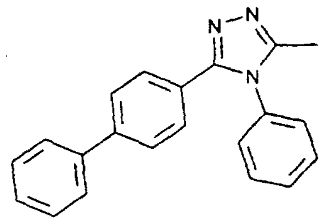
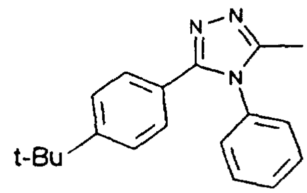
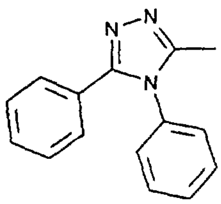
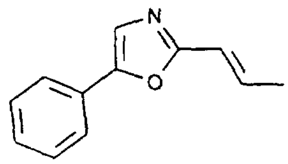
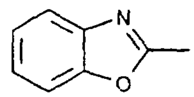

wobei die Symbole und Indizes die oben angegebenen Bedeutungen haben.

Insbesondere bevorzugt sind folgende Verbindungen der Formel (IV):

IV.aa) $K^1 = L = M = N^1$ und ist aus der Gruppe:

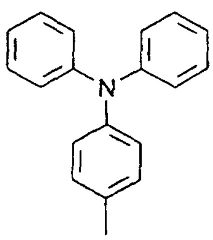
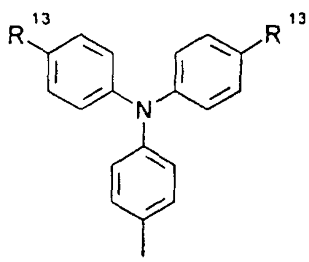
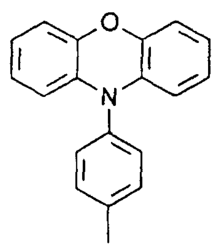
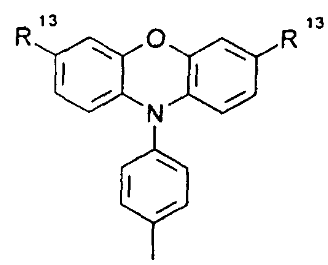
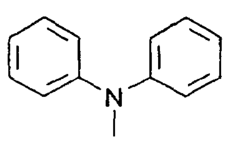
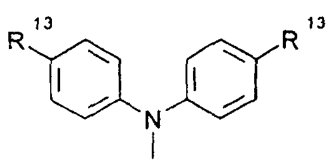
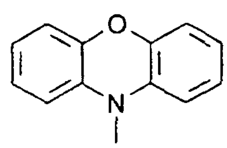
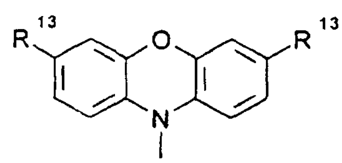
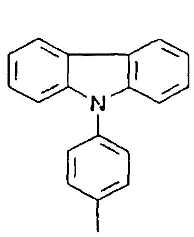
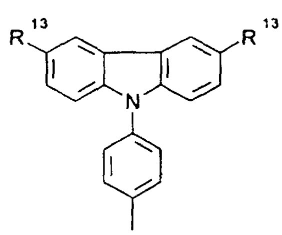
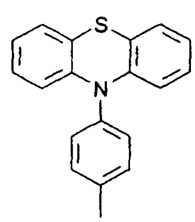
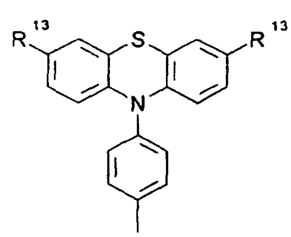

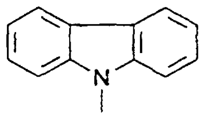
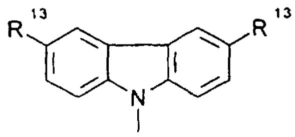
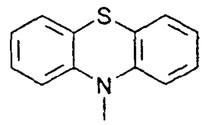
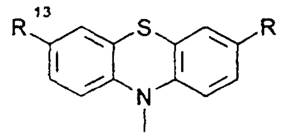
.

wobei $R^{13}$ $-O-CH_3$, $-O-C_2H_5$, $-S-CH_3$, $-S-C_2H_5$, vorzugsweise $-O-CH_3$, $-S-CH_3$, besonders bevorzugt $-O-CH_3$, bedeutet; und Q = $P^1$ und ist aus der Gruppe
H, $COOR^{14}$ , $CH_2OR^{14}$,

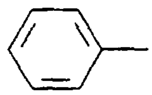
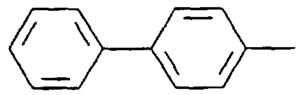
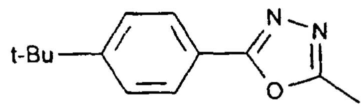

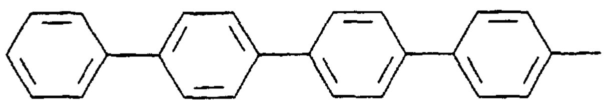
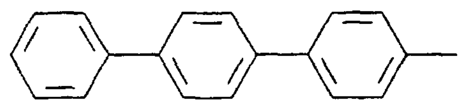

wobei $R^{14}$ eine geradkettige oder verzweigte Alkylgruppe mit 1 bis 12, vorzugsweise 1 bis 4 C-Atomen ist;

IV.ba) $K^1$ = L = M = $N^1$ = Q = $P^1$ und ist aus der Gruppe

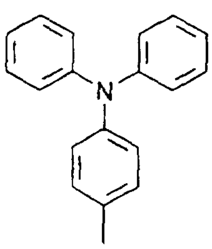
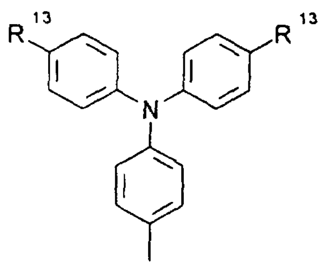
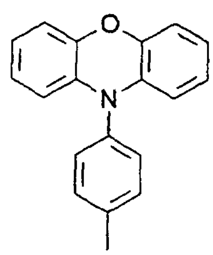
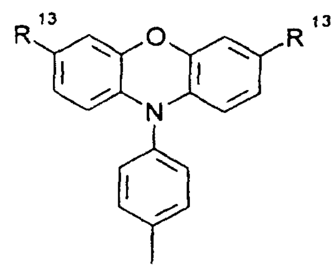

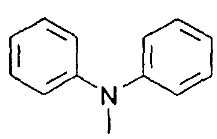
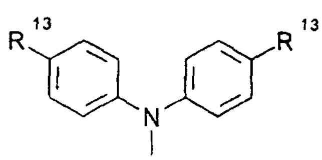
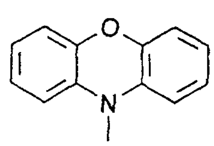
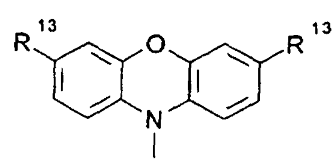

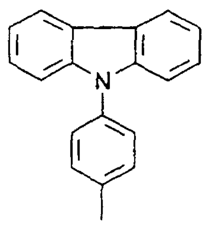 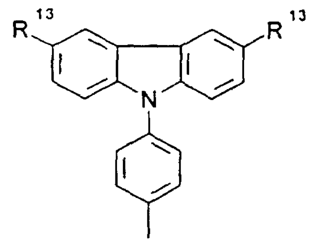 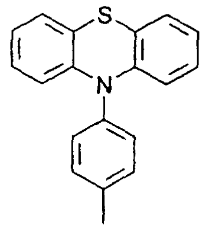 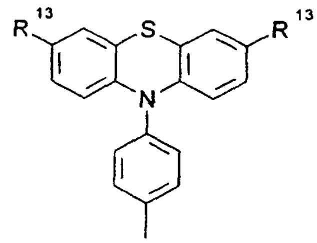

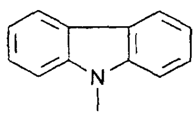 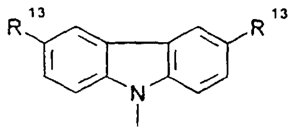 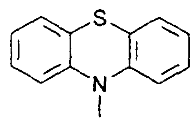 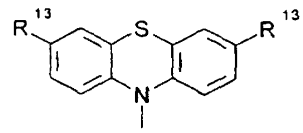

wobei $R^{13}$ die oben angegebenen Bedeutungen hat;

IV.ca) $K^1 = L = M = N^1$ und ist aus der Gruppe

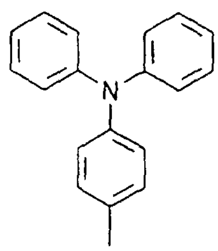 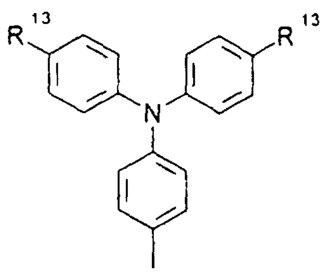 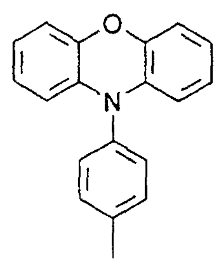 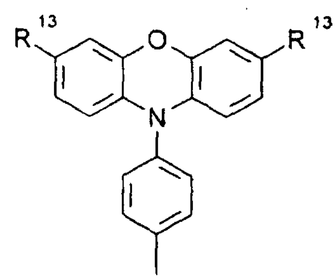

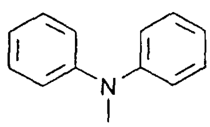 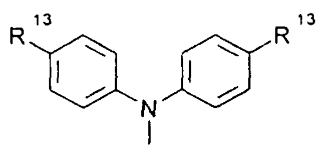 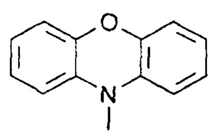 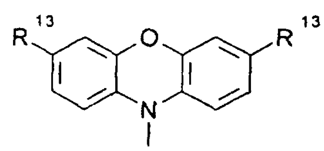

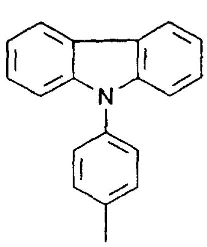 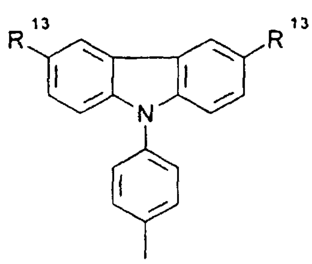 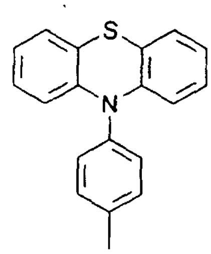 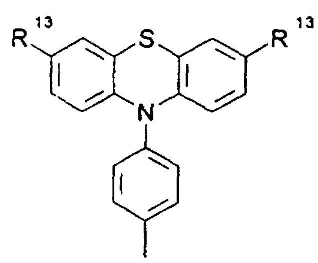

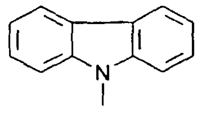 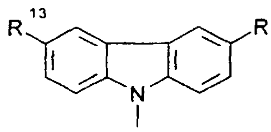 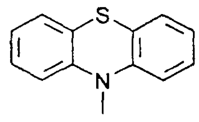 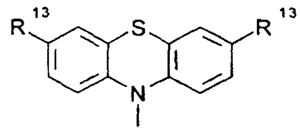

und Q = H und $P^1$ ist aus der Gruppe
H, $COOR^{14}$, $CH_2OR^{14}$,

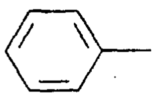 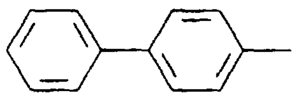 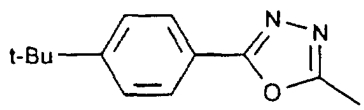

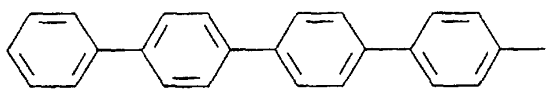 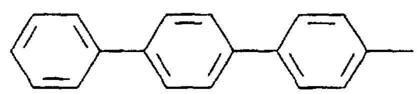

wobei $R^{13}$, $R^{14}$ die oben angegebenen Bedeutungen haben.

Die Herstellung der erfindungsgemäß verwendeten Spiroverbindungen erfolgt nach an sich literaturbekannten Methoden, wie sie in Standardwerken zur Organischen Synthese, z.B. Houben-Weyl, Methoden der Organischen Chemie, Georg-Thieme-Verlag, Stuttgart und in den entsprechenden Bänden der Serie "The Chemistry of Heterocyclic Compounds" von A. Weissberger und E.C. Taylor (Herausgeber) beschrieben werden.

Die Herstellung erfolgt dabei unter Reaktionsbedingungen, die für die genannten Umsetzungen bekannt und geeignet sind. Dabei kann auch von an sich bekannten, hier nicht näher erwähnten Varianten Gebrauch gemacht werden.

a) Carbospiroverbindungen

Verbindungen der Formel (IV) werden beispielsweise ausgehend vom 9,9'-Spirobifluoren erhalten, dessen Synthese z.B. von R. G. Clarkson, M. Gomberg, J. Am. Chem. Soc. 1930, 52, 2881, beschrieben ist.

Die Herstellung von Verbindungen der Formel (IVa) kann beispielsweise ausgehend von einer Tetrahalogenierung in den Positionen 2,2',7,7' des 9,9'-Spirobifluorens und anschließender Substitutionsreaktion erfolgen (siehe z.B. US 5,026,894) oder über eine Tetraacetylierung der Positionen 2,2',7,7' des 9,9'-Spirobifluorens mit anschließender C-C-Verknüpfung nach Umwandlung der Acetylgruppen in Aldehydgruppen oder Heterocyclenaufbau nach Umwandlung der Acetylgruppen in Carbonsäuregruppen erfolgen.

Die Herstellung von Verbindungen der Formel (IVb) kann beispielsweise analog zu denen der Formel (IVa) erfolgen, wobei die stöchiometrischen Verhältnisse bei der Umsetzung so gewählt werden, daß die Positionen 2,2' bzw. 7,7' funktionalisiert werden (siehe z.B. J. H. Weisburger, E. K. Weisburger, F. E. Ray, J. Am. Chem. Soc. 1959, 72 4253; F. K. Sutcliffe, H. M. Shahidi, D. Paterson, J. Soc. Dyers Colour 1978, 94, 306 und G. Haas, V. Prelog, Helv. Chim. Acta 1969, 52 1202).

Die Herstellung von Verbindungen der Formel (IVc) kann beispielsweise über eine Dibromierung in 2,2' Stellung und anschließende Diacetylierung in 7,7' Stellung des 9,9'-Spirobifluorens mit anschließender Umsetzung analog zu den Verbindungen (IVa) erfolgen.

Verbindungen der Formeln (IV) mit $K^1$, L, Q, $P^1$ = H und M = $N^1$ oder Q, $P^1$ = H, $K^1$ = L und M = $N^1$ sind beispielsweise durch Wahl geeignet substituierter Ausgangsverbindungen beim Aufbau des Spirobifluorens herstellbar, z.B. kann 2,7-Dibromspirobifluoren aus 2,7-Dibromfluorenon und 2,7-Dicarbethoxy-9,9'spirobifluoren durch Einsatz von 2,7-Dicarbethoxyfluorenon aufgebaut werden. Die freien 2',7'-Positionen des Spirobifluorens können dann unabhängig weiter substituiert werden.

Für die Synthese der Gruppen $K^1$, L, M, N, $N^1$, $P^1$ sei beispielsweise verwiesen auf DE-A 23 44 732, 24 50 088, 24 29 093, 25 02 904, 26 36 684, 27 01 591 und 27 52 975 für Verbindungen mit 1,4-Phenylen-Gruppen;
DE-A 26 41 724 für Verbindungen mit Pyrimidin-2,5-diyl-Gruppen;
DE-A 40 26 223 und EP-A 0 391 203 für Verbindungen mit Pyridin-2,5-diyl-Gruppen;

DE-A 32 31 462 für Verbindungen mit Pyridazin-3,6-diyl-Gruppen; N. Miyaura, T. Yanagi und A. Suzuki in Synthetic Communications 1981, 11, 513 bis 519, DE-A-39 30 663; M. J. Sharp, W. Cheng, V. Snieckus, Tetrahedron Letters 1987, 28 , 5093; G. W. Gray, J. Chem. Soc. Perkin Trans II 1989, 2041 und Mol. Cryst. Liq. Cryst. 1989, 172, 165; Mol. Cryst. Liq. Cryst. 1991, 204, 43 und 91; EP-A 0 449 015; WO 89/12039; WO 89/03821; EP-A 0 354 434 für die direkte Verknüpfung von Aromaten und Heteroaromaten.

Die Herstellung disubstituierter Pyridine, disubstituierter Pyrazine, disubstituierter Pyrimidine und disubstituierter Pyridazine findet sich beispielsweise in den entsprechenden Bänden der Serie "The Chemistry of Heterocyclic Compounds" von A. Weissberger und E. C. Taylor (Herausgeber).

Aminogruppen enthaltende Verbindungen der Formel (I) können über Varianten der Ullmann-Reaktion (J. March, Adv. Org. Chem., 4. Aufl., S. 665, John Wiley & Sons, New York 1992) aufgebaut werden, wie sie bsp. in Chem. Lett. 1989, 1145; Mol. Cryst. Liq. Cryst. 1994, 242, 127 und insbesondere bei J. Salbeck et al., 213th ACS National Meeting, San Francisco 1997, Book of Abstracts S. 199, beschrieben ist. Weiterhin möglich ist ein aus US 5,576,460 bekanntes Verfahren. Bevorzugt ist die Herstellung solcher Verbindungen nach einem in der deutschen Patentanmeldung 197 38 860.4 mit dem Titel "Verfahren zur Herstellung von Aryloligoaminen" offenbarten Verfahren.

b) Heterospiroverbindungen

Solche Verbindungen der Formel (III) werden beispielsweise ausgehend vom Bis-[biphenyl-2,2'-diyl]silan (=9,9'-Spirobi(9H-)-silafluoren) (V) erhalten, dessen Synthese z.B. von H. Gilman, R. D. Gorsich, J. Am. Chem. Soc. 1958, 80, 3243, beschrieben ist.

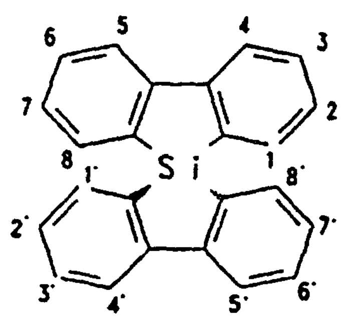

(V)

Die Herstellung von Heterospiroverbindungen der Formel (IIIa) kann beispielsweise ausgehend von einer Tetrahalogenierung in den Positionen 2,2',7,7' des 9,9'-Spirobi-9-silafluorens und anschließender Substitutionsreaktion erfolgen, die von analogen C-Spiroverbindungen bekannt (siehe z.B. US 5,026,894) oder über eine Tetraacetylierung der Positionen 2,2',7,7' des 9,9'-Spirobi-9-silafluorens mit anschließender C-C-Verknüpfung nach Umwandlung der Acetylgruppen in Aldehydgruppen oder Heterocyclenaufbau nach Umwandlung der Acetylgruppen in Carbonsäuregruppen erfolgen.

Die Herstellung von Verbindungen der Formel (IIIb) kann beispielsweise analog zu denen der Formel (IIIa) erfolgen, wobei die stöchiometrischen Verhältnisse bei der Umsetzung so gewählt werden, daß die Positionen 2,2' bzw. 7,7' funktionalisiert werden (siehe z.B. J. H. Weisburger, E. K. Weisburger, F. E. Ray, J. Am. Chem. Soc. 1959, 72, 4253; F. K. Sutcliffe, H. M. Shahidi, D. Paterson, J. Soc. Dyers Colour 1978, 94, 306 und G. Haas, V. Prelog, Helv. Chim. Acta 1969, 52, 1202).

Die Herstellung von Verbindungen der Formel (IIIc) kann beispielsweise über eine Dibromierung in 2,2'-Stellung mit anschließender Diacetylierung in 7,7'-Stellung des 9,9'-Spirobi-9-silafluorens und anschließender Umsetzung analog zu der der Verbindungen (IIIa) erfolgen.

Verbindungen der Formel (IIIe)-(IIIg) sind beispielsweise herstellbar durch Wahl geeignet substituierter Ausgangsverbindungen beim Aufbau des Spirosilabifluorens entsprechend den beiden folgenden Reaktionsschemata:

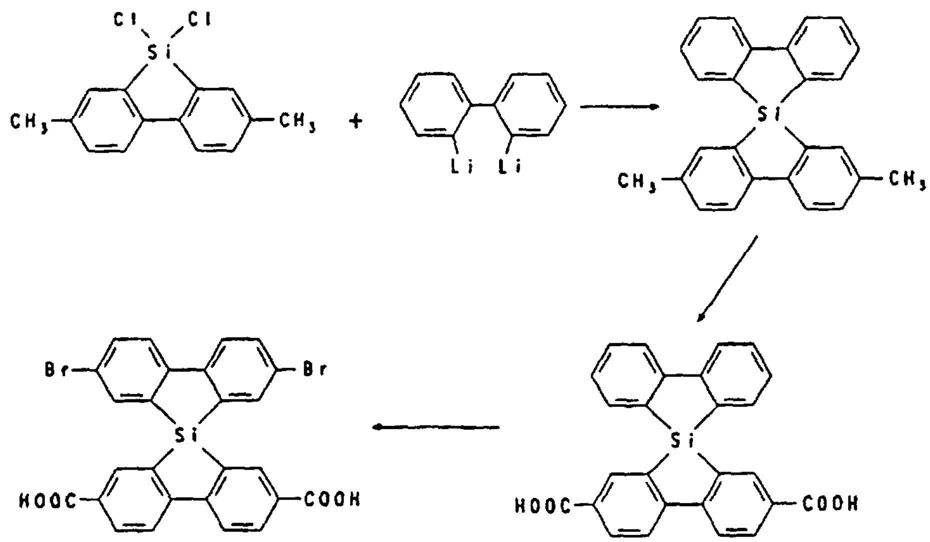

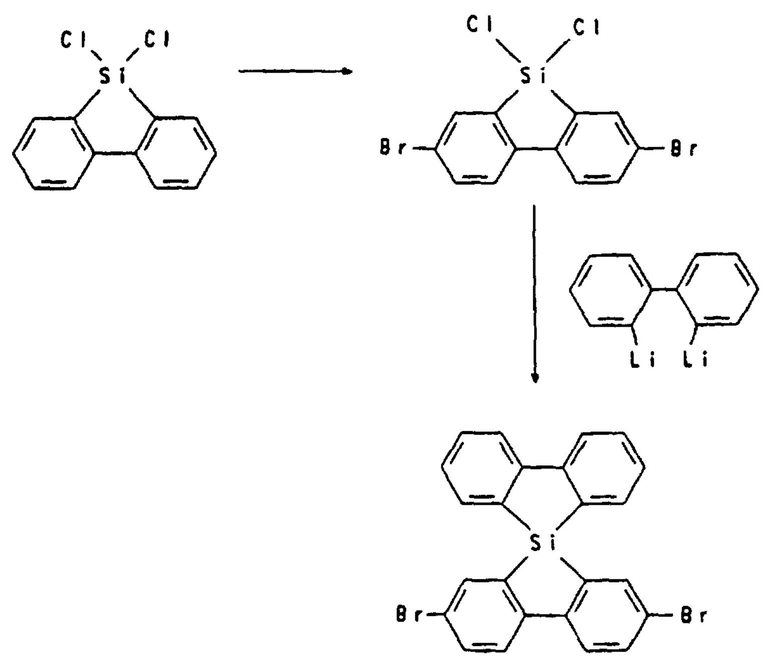

Darüber hinaus sind die dem Fachmann geläufigen Synthesesequenzen wie Nitrierung, Reduzierung, Diazotierung und Sandmeyer-Reaktion einzusetzen. Für die Synthese der Gruppen $K^1$, L, M, $N^1$, P, Q sei auf die entsprechenden Carbospiroverbindungen verwiesen.

Grundsätzlich ist es auch möglich, Oligo- oder Polymere mit den entsprechenden Spiroeinheiten einzusetzen, solange die Verbindungen in der Lage sind, in die Poren des nanokristallinen Halbleiters einzudringen. Solche Verbindungen sind in der EP-A 0 707 020; WO-A 96/17 036;
DE-A 196 06 511; DE-A 196 14 971 und DE-A 196 15 128 beschrieben.

Das in der Elektrolytflüssigkeit gelöste Lochleitermaterial der Formel (I) dient in einer erfindungsgemäßen photovoltaischen Zelle aufgrund seines Redox-Potentials als reine Relais-Substanz für den Ladungstransport. Durch Transfer eines Elektrons aus dem Grundzustand einer erfindungsgemäßen Lochleiterverbindung an das oxidierte Farbstoffmolekül wird der Grundzustand des Halbleiters bzw. Sensibilisatorfarbstoffs regeneriert. An der Gegenelektrode wird durch einen weiteren Elektronentransfer von der Elektrode an das Lochleitermolekül der Grundzustand dieses

Moleküls regeneriert.

Bei der Wahl des Lösungsmittels für den Elektrolyten müssen mehrere Eigenschaften berücksichtigt werden. Gewünscht sind Lösungsmittel mit niedriger Viskosität und niedrigem Dampfdruck; in der Praxis will man einen Kompromiß zwischen Viskosität und Dampfdruck. Das Lösungsmittel sollte auch über einen Potentialbereich von 3,0 V, nämlich mindestens von +1,5 V bis -1,5 V, gemessen gegen eine wäßrige gesättigte Kalomelelektrode, stabil gegen Redoxreaktionen sein. Bevorzugt sind Lösungsmittel, deren anodischen Grenzpotentiale noch positiver sind. Besonders bevorzugt sind Lösungsmittel, deren anodisches Grenzpotential gleich oder über 2,5 V liegt. Beispiele geeigneter Lösungsmittel, auf die sich die Erfindung keineswegs beschränkt, sind Acetonitril, Glutarodinitril, Ethylencarbonat, Propylencarbonat, Chlorbenzol und 3-Methyl-2-oxazilidinon sowie deren Mischungen miteinander oder mit anderen Lösungsmitteln.

Die Konzentration einer erfindungsgemäßen Lochleiterverbindung im Elektrolyten beträgt üblicherweise 0,1 - 3,0 M (M = Mol/l), vorzugsweise 0,2 - 1,0 M. Vorzugsweise kann zusätzlich zur neutralen, reduzierten Form der Verbindung das oxidierte Radikalkation in der Elektrolytlösung vorkommen, beispielsweise durch Zugabe von Anfang an. In diesem Fall beträgt die Konzentration der oxidierten Form vorzugsweise 0,001 - 0,2 M, besonders bevorzugt 0,02 - 0,1 M.

Es ist weiterhin bevorzugt, dem Elektrolyten ein Leitsalz zur Erhöhung der Leitfähigkeit beizumischen. Beispiele geeigneter Leitsalze, auf die sich die Erfindung nicht beschränkt, sind

1.

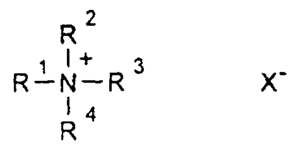

2

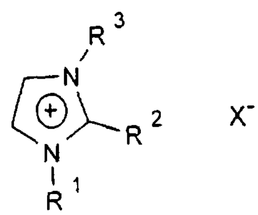

3.

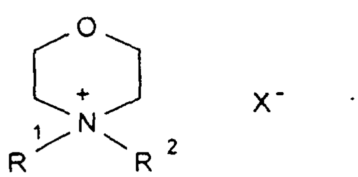

4.

$Li^+X^-$

5.

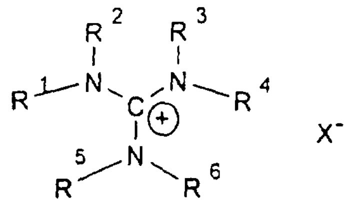

wobei die Symbole folgende Bedeutungen haben:

- $R^{1-6}$ sind gleich oder verschieden eine geradkettige oder verzweigte Alkylgruppe mit 1 bis 12 C-Atomen, die auch teil- oder perfluoriert sein kann, und
- X ist ein Anion, vorzugsweise $ClO_4^-$, Triflat oder Bistriflylimid.

Die erfindungsgemäße photovoltaische Zelle enthält als lichtabsorbierende Schicht vorzugsweise einen Halbleiter, der vorzugsweise eine sehr große Bandlücke, besonders bevorzugt mindestens 3,0 eV, besonders bevorzugt über 3,0 eV, aufweist.

Damit eignen sich vorzugsweise Metalloxid-Halbleiter, insbesondere die Oxide der Übergangsmetalle, sowie der Elemente der dritten Hauptgruppe und der vierten, fünften und sechsten Nebengruppe (des periodischen Systems der Elemente) von Titan, Zirkon, Hafnium, Strontium, Zink, Indium, Yttrium, Lanthan, Vanadium, Niob, Tantal, Chrom, Molybdän, Wolfram, aber auch Oxide von Zink, Eisen, Nickel oder Silber, Perovskite wie $SrTiO_3$, $CaTiO_3$, oder Oxide von anderen Metallen der zweiten und dritten Hauptgruppe oder Mischoxide oder Oxidgemische dieser Metalle. Es kann aber auch jedes andere Metalloxid mit Halbleitereigenschaften und großem Energieabstand (Bandlücke) zwischen Valenzband und Leitungband verwendet werden.
Besonders bevorzugt als Halbleitermaterial ist Titandioxid.

Der Halbleiter weist vorzugsweise einen Rauheitsfaktor von größer als 1, besonders bevorzugt von größer als 20, ganz besonders von größer als 150 auf.

Der Rauheitsfaktor ist definiert als das Verhältnis einer wirklichen/effektiven Oberfläche zur Fläche der Projektion dieser Oberfläche eines Körpers, in diesem Fall also der Oberfläche des Halbleiters.

Der Rauheitsfaktor kann z.B.durch gravimetrische Adsorptionsmethoden bestimmt werden, wie z.B. in F. Kohlrausch, Praktische Physik, Band 1,
S. 397 (Stuttgart: B.G. Teubner, 1985) beschrieben wird. Im allgemeinen beträgt die Größe der Poren 5-200 nm, vorzugsweise 10-50 nm.

Ein Verfahren zum Herstellen von polykristallinen Metalloxid-Halbleiterschichten mit dem Sol-Gef-Verfahren (beschrieben in Einzelheiten z. B. in Stalder und Augustynski, J. Electrochem. Soc. 1979, 126, 2007), wo beim Verfahrensschritt der Hydrolyse des Metall-Alkoholats die prozentuale relative Feuchtigkeit der Umgebungsatmosphäre in einem Bereich von 30 % bis 80 % liegen kann und innerhalb von ± 5 %, vorzugsweise ± 1 %, konstant gehalten wird, ergibt Metalloxid-Halbleiterschichten, mit denen in erfindungsgemäßen photovoltaischen Zellen eine besonders hohe elektrische Ausbeute erzielt werden kann.
Die rauhe Oberfläche mit polykristalliner Struktur bietet eine um den Rauheitsfaktor größere Fläche für eine, vorzugsweise, monomolekulare Oberflächenschicht des Chromophors. Damit wird erreicht, daß das auf eine Fläche bestimmter Größe einfallende Licht mit bedeutend höherer Ausbeute in elektrische Energie gewandelt wird. Der Halbleiter kann als für den einfallenden Lichtstrom durchsichtig betrachtet werden. Licht wird aber teilweise auf der Oberfläche reflektiert und gelangt z. T. auf benachbarte Oberflächen. Das in den Halbleiter eindringende und nicht absorbierte bzw. gewandelte Licht trifft z. T. direkt und zu einem anderen Teil indirekt und zu einem weiteren Teil indirekt nach Totalreflexion an der Oberfläche, auf der Austrittsseite auf Chromophormoleküle, womit es gelingt, eine bedeutend höhere Lichtausbeute zu erzielen.

Als Beispiel für die Herstellung einer Titanoxydschicht ($TiO_2$) mit hohem Rauheitsfaktor auf einem Titansubstrat, wird nachfolgend das Sol-Gel-Verfahren beispielhaft beschrieben.
Das Titansubstrat aus reinem Titanium von etwa 99,5 % Reinheit wird zuerst während etwa 30 Minuten in etwa 18 %iger kochender HCl gereinigt. Die Titan-Ethoxyd-Lösung kann z. B. durch die Lösung von 21 mMol $TiCl_4$ in 10 ml sehr reinem Ethanol (puriss.) erhalten werden. Diese Lösung wird dann mit sehr reinem Methanol (puriss.) verdünnt, um eine Titankonzentration im Bereich von etwa 25 bis 50 mg/ml zu erhalten. Auf das Titansubstrat gibt man einen Tropfen der Lösung und das Titan-Alkoxid wird bei Raumtemperatur während ca. 30 Minuten bei einer Feuchtigkeit von 48 ± 1 % hydrolysiert. Danach wird das Substrat mit der hydrolysierten Schicht während ca. 15 Minuten auf ca.

450°C erhitzt. Dieser Prozeß wird mehrmals wiederholt. Nach 10- bis 15-maliger Wiederholung hat die $TiO_2$-Schicht eine Dicke von etwa 20 µm erreicht. Danach wird das Substrat mit der Schicht bei etwa 500°C während etwa 30 Minuten in einer Rein-Argon-Atmosphäre (z. B, 99,997 %) ausgeheizt. Die so hergestellte $TiO_2$-Schicht hat einen Rauheitsfaktor im Bereich von 200. Derartige Metalloxyd-Halbleiter-Schichten (auch anderer Metalle) können nach analogen Verfahren auf anderen Substraten erzeugt werden. Die oberen Schichten des Halbleiters können gegebenenfalls, wie z. B. in der WO-A 91/16719 beschrieben, mit einem divalenten oder trivalenten Metall dotiert sein.

Die Empfindlichkeit, d. h. die photoelektronische Ausbeute für sichtbares Licht, also auch für Sonnenlicht, kann erhöht werden, indem auf der Oberfläche des Halbleiters sog. Chromophore, auch Sensibilisatoren oder Dyes genannt, als Ladungsträger chemisch an- oder eingelagert (chemisorbiert) werden. Die beiden Funktionen der Lichtabsorption und der Ladungsträger-Trennung sind bei diesen photoelektronischen Systemen getrennt. Die Lichtabsorption wird vom Chromophor im Oberflächenbereich übernommen, und die Trennung der Ladungsträger erfolgt an der Grenzschicht Halbleiter/Chromophor.

Verschiedene Chromophore haben unterschiedliche spektrale Empfindlichkeiten. Die Wahl des Chromophors kann somit der spektralen Zusammensetzung des Lichts der Lichtquelle angepaßt werden, um die Ausbeute möglichst zu vergrößern.

Als Chromophore, d. h. Sensibilisatoren, eigenen sich insbesondere die Komplexe von Übergangsmetallen vom Typ Metall ($L_3$), Metall ($L_2$) von Ruthenium und Osmium (z. B. Ruthenium-tris-(2,2'-bipyridyl-4,4'-dicarbonsäure) und deren Salze, Ruthenium cis diaqua bipyridyl Komplexe, wie Ruthenium cis-diaqua bis(2,2'bipyridyl-4,4'dicarboxylate) sowie Porphyrine (z. B. Zink tetra (4-carboxyphenyl) Porphyrin) und Cyanide (z. B. Eisen-Hexacyanid-Komplexe) und Phthalocyanine.

Die Chromophore können im Bereich der Oberfläche des Metalloxyd-Halbleiters chemisorbiert, adsorbiert oder sonstwie fest angelagert sein. Günstige Resultate wurden beispielsweise mit Chromophoren erzielt, die mit Carbonsäure- oder Phosphonsäure-Liganden an die Oberfläche des Metalloxid-Halbleiters gebunden sind.

Geeignete Chromophore sind beispielsweise in Chem. Rev. 1995, 49-68 beschrieben.

Besonders bevorzugt sind Ruthenium-tris-(2,2'-bipyridyl-4,4'-dicarbonsäure), deren Salze und die Chromophore (VIII) und (IX),

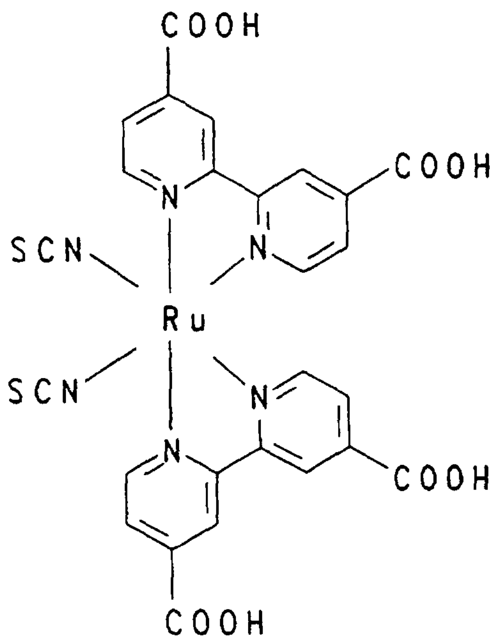

(VIII)

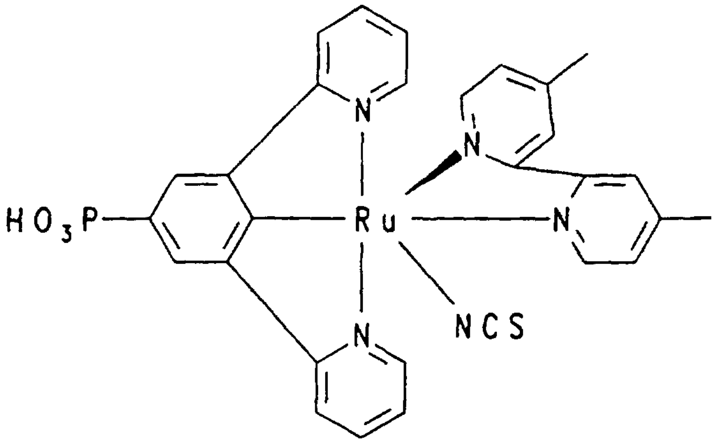

(IX)

deren Synthese und Eigenschaften in J. Chem. Soc. Chem. Comm. 1995, 65 beschrieben sind.

Das Aufbringen des Chromophors, beispielsweise Ruthenium-tris-(2,2'-bipyridyl-4,4'dicarbonsäure) oder ein Salz davon, erfolgt z. B. durch Eintauchen des Substrats mit der Oxidschicht in eine Lösung, beispielsweise eine wäßrige oder alkoholische, vorzugsweise ethanolische, während etwa einer Stunde. Die Konzentration der Lösung ist vorzugsweise 0,1 bis 10 molar, besonders bevorzugt 1 bis 5 molar, beispielsweise 2 molar. Andere Chromophore lassen sich nach analogen Verfahren auf Titanoxid oder andere Metalloxid-Halbleiter aufbringen.

Als Elektrode 15 eignen sich stabile, metallisch leitende Substanzen, z. B. Au, Ag, Pt, Cu, oder andere Metalle. Es können aber auch für einige Anwendungen vorzugsweise lichtdurchlässige leitfähige Substanzen, wie dotierte Metalloxide, z. B. Indium-Zinn-Oxid, Sb-dotiertes Zinnoxid oder Al-dotiertes Zinkoxid, verwendet werden.

Die Elektrode kann, wie in der EP-A 0 333 641 beschrieben, auf ein transparentes Substat, z. B. Glas, aufgebracht werden und mit der Elektrolytschicht verbunden sein.

Gegebenenfalls kann die Elektrode auch, wie in der WO-A 93/19479 beschrieben, mit einem weiteren Halbleiter beschichtet sein.

Als elektrisch isolierende Materialien 16 und 17 bzw. gegebenenfalls als seitlicher Rahmen für die erfindungsgemäße Zelle eignen sich beispielsweise Kunststoff oder Glas.

Gegenstand der Erfindung ist auch ein Verfahren zur Herstellung einer photovoltaischen Zelle, dadurch gekennzeichnet, daß man auf einem leitfähigen festen Träger

a) ein Halbleiterkolloid aufbringt,

b) darauf gegebenenfalls einen Farbstoff (Chromophor) aufbringt,

c) darauf einen Elektrolyten, enthaltend eine Lochleiterverbindung als Redoxsystem, aufbringt,

d) darauf die Gegenelektrode einschließlich isolierende Schicht aufbringt.

Falls gewünscht kann die Zelle z. B. mit einem Kleber oder einer Folie versiegelt werden.

Die erfindungsgemäße photovoltaische Zelle hat im allgemeinen eine Dicke von 5 bis 20 mm (mit Substrat). Sie kann zur Vermeidung von Reflexionsverlusten mit einer ein-, zwei- oder mehrlagigen Antireflexschicht versehen sein.

Zur Erhöhung der Lichtausbeute kann die Rückseite der Zelle so konstruiert sein, daß Licht diffus in die Zelle zurückreflektiert wird.

Eine weiter Erhöhung der Lichtausbeute kann beispielsweise dadurch erzielt werden, daß das einfallende Sonnenlicht beispielsweise durch Spiegel oder Fresnellinsen konzentriert wird.

Die erfindungsgemäße Zelle kann auch Teil einer Tandemzelle sein; bei solchen Vorrichtungen wandeln mehrere Teilzellen Licht aus unterschiedlichen Spektralbereichen in elektrische Energie um.

Die erfindungsgemäße Zelle wird als Photozelle verwendet, d. h., sie dient zum Erzeugen von elektrischer Energie aus Licht. Vorzugsweise handelt es sich um eine Solarzelle, d. h. eine Vorrichtung zum Erzeugen elektrischer Energie aus Sonnenlicht.

Die Erfindung wird durch die Beispiele näher erläutert, ohne sie dadurch beschränken zu wollen.

Synthesebeispiele

Beispiel 1

9,9'-Spirobifluoren (1)

7,63 g Magnesiumspäne und 50 mg Anthracen wurden in 100 ml trockenem Diethylether in einem 11 Dreihalskoben mit Rückflußkühler unter Argon vorgelegt und mit 75 g 2-Brombiphenyl gelöst in 60 ml trockenem Diethylether umgesetzt. Anschließend wurden 56,77 g 9-Fluorenon gelöst in 500 ml trockenem Diethylether unter Rühren zugetropft. Nach beendeter Zugabe wurde 2 Stunden weiter gekocht. Der ausgefallene gelbe Magnesiumkomplex wurde abgesaugt und mit Ether gewaschen. Der abfiltrierte gelbe Magnesiumkomplex wurde dann in einer Lösung aus 48 g Ammoniumchlorid in 800 ml Eiswasser hydrolysiert .Nach 60 min. Rühren wurde das gebildete Fluorenol abgesaugt, mit Wasser gewaschen, und trockengesaugt Das getrocknete Produkt wurde dann in ca. 800 ml Eisessig unter Zugabe von 3 ml HCl conc. aufgenommen und nach Erhitzen 2 h am Rückfluß gekocht. Nach Abkühlung wurde das Produkt abgesaugt, mit Wasser gewaschen und getrocknet. Zur weiteren Reinigung wurde einmal aus Aceton umkristallisiert. Man erhielt 86 g 9,9'-Spirobifluoren als farblose Kristalle
(82 % Ausbeute).

Beispiel 2

Synthese von 2,2',4,4',7,7'-Hexabromo-9,9'-spirobifluoren (2)

Zu einer Lösung von 3,16 g (10 mmol) 9,9'-Spirobifluoren in 20 ml Methylenchlorid wurden 200 mg wasserfreies $FeCl_3$ gegeben und mit Ultraschall behandelt. Der Reaktionskolben wurde mit Al-Folie vor Lichtzutritt geschützt. Anschließend wurden in der Siedehitze 9,85 g (3,15 ml, 62 mmol) Brom in 5 ml Methylenchlorid innerhalb von 15 min zugetropft. Die Lösung wurde weitere 20 h am Rückfluß gekocht und mit Ultraschall behandelt. Nach Abkühlung wurde mit Petrolether versetzt und abgesaugt. Zur weiteren Reinigung wurde aus THF / Methanol umkristallisiert und 5 h bei 80°C getrocknet. Ausbeute 6,15 g (77 %) farblose Kristalle.

Beispiel 3

2,2',7,7'-Tetrajod-9,9'-spirobifluoren (3)

In einem 100 ml Zweihalskolben mit Rückflußkühler und Trockenrohr wurden 3,16 g (10 mmol) 9,9'-Spirobifluoren, gelöst in 30 ml Chloroform, bei Raumtemperatur mit 5,8 g (22,8 mmol) Iod versetzt und anschließend 10,75g (25 mmol) Bis-(trifluoracetoxy)-iodbenzol zugegeben. Das Reaktionsgemisch erwärmte sich auf ca 40°, unter Bildung eines hellen Niederschlags. Nach 1,5 h wurde das bereits ausgefallene Produkt abgesaugt, mit Chloroform nachgewaschen und getrocknet.

Die Chloroformlösungen wurden vereinigt und nacheinander mit gesättigter Natriumsulfitlösung, gesättigter Natriumcarbonatlösung und Wasser gewaschen. Nach dem Trocknen über Natriumsulfat wurde eingeengt und eine zweite Produktfraktion erhalten. Beide Produktfraktionen wurden vereinigt, in Aceton aufgekocht und nach Abkühlung abgesaugt. Man erhielt 2,2',7,7'-Tetrajod-9,9'-spirobifluoren als feinkristallines farbloses Pulver mit 8,1 g in nahezu quantitativer Ausbeute.
$^1$H-NMR ($CDCl_3$, ppm): 6.98 (d, J = 1,48 Hz, 4 H, H-1,1',8,8'); 7.54 (dd, J = 7.88, 1.48 Hz, 4 H, H-3,3',6,6'); 7.72 (d, J = 7.88 Hz, 4 H, H-4,4',5,5').

Beispiel 4

2,2',7.7'-Tetrakis-(diphenylamino)-9,9'-spirobifluoren (4)

Zu einem Gemisch (5,01 g, 6,11 mmol), Diphenylamin (5,36 g, 31,7 mmol), aktiviertem Kupfer (1,52 g, 23,9 mmol), Kaliumcarbonat (6,60 g, 47,8 mmol) und 18-crown-6 (499 mg, 1,89 mmol) in einem 100 mL-Dreihalskolben mit Rückflußkühler und Stickstoffventil wurden 25 mL o-Xylol gegeben und das Reaktionsgemisch 82 h zum Rückfluß erhitzt, wobei sich der Ansatz braun färbte. Das festgewordene Reaktionsgemisch wurde solange in 15 mL Toluol erhitzt, bis es wieder flüssig war. Danach wurde abfiltriert und der feste anorganische Rückstand noch mit 15 mL Toluol gewaschen. Filtrat und Rückstand wurden getrennt voneinander aufgearbeitet.
Der getrocknete anorganische Rückstand wurde in 20 mL Wasser aufgekocht, wobei sich die anorganischen Salze auflösten. Nach Abkühlen auf RT wurde der Rückstand abgesaugt und nach dem Trocknen in 20 mL Toluol gelöst.

Man erhitzte zum Rückfluß (15 min), ließ abkühlen, saugte ab und wusch den Rückstand (Kupfer) mit 15 mL Toluol. Das Filtrat wurde eingeengt und der getrocknete organische Rückstand in 15 mL Aceton 5 min gekocht. Nach Abkühlen im Eisbad wurde abgesaugt und mit wenig kaltem Aceton gewaschen. Das Rohprodukt wurde im Vakuum bei 50°C getrocknet. Die Rohausbeute der ersten Fraktion betrugt 1,48 g.

Das Filtrat wurde bis zur Trockne eingeengt, und der feste Rückstand 30 min in 15 mL Aceton gekocht. Nach Abkühlen im Eisbad wurde abgesaugt und mit Aceton gewaschen. Das Rohprodukt wurde im Vakuum bei 50°C getrocknet. Die Rohausbeute der zweiten Fraktion betrug 2,07 g. Insgesamt betrug die Rohausbeute 3,55 g (3,60 mmol, 59 %).

Zur weiteren Reinigung wurden die beiden Fraktionen vereinigt und in der Wärme in Chloroform gelöst. Man saugte zweimal durch eine G4-Fritte, um fein verteiltes Kupfer abzutrennen. Das Filtrat wurde eingeengt, und der getrocknete Rückstand mit 3 - 4 Tropfen Hydrazinhydrat in 20 mL Diethylether 15 min gekocht. Nach Abkühlen im Eisbad wurde abgesaugt und gewaschen. Anschließend wurde zur Kristallisation der Feststoff in Chloroform aufgenommen und in der Siedehitze mit Diethylether gefällt. Nach Abkühlen im Eisbad wurde der ausgefallene, teilkristalline, hellgelbe Feststoff abgesaugt und mit Diethylether gewaschen. Das Reinprodukt wurde im Vakuum bei 80°C getrocknet.

Ausbeute: 2,81 g (2,85 mmol, 47 %), leicht gelblich gefärbtes Pulver bzw. Nädelchen.

Beispiel 5

2,2',7,7'-Tetrakis-(N,N-di-p-methoxyphenylamin)-9,9'-spirobifluoren (5)

Zu einem Gemisch der Substanz aus Beispiel 3 (5,01 g, 6,11 mmol), 4,4'-Dimethoxy-diphenylamin (7,26 g, 31,7 mmol), aktiviertem Kupfer (1,52 g, 23,9 mmol), Kaliumcarbonat (6,60 g, 47,8 mmol) und 18-krone-6 (499 mg, 1,89 mmol) in einem 100 mL-Dreihalskolben mit Rückflußkühler und Stickstoffventil wurden 25 mL o-Xylol gegeben und das Reaktionsgemisch 70 h am Rückfluß gekocht, wobei der Ansatz eine rötliche Färbung annahm.

Man saugte den anorganischen Rückstand ab und wusch so lange mit o-Xylol nach, bis die Waschlösung farblos war. Anschließend wurde das Filtrat bis zur Trockne eingeengt. Im folgenden wurden die beiden Fraktionen getrennt voneinander aufgearbeitet.

Die Reaktionslösung wurde bis zur Trockne eingeengt, der feste Rückstand in 10 mL Methanol aufgenommen und gekocht. Hierbei entstand eine klebrige, zähflüssige Masse. Der Feststoff wurde abgesaugt, scharf getrocknet und in 40 mL Methanol unter Zugabe von 2 Tropfen Hydrazinhydrat für ca. 3 h gekocht. Man saugte ab, wusch nach und löste in der Siedehitze in Aceton (nicht gelöste Substanz wurde abfiltriert). Danach gab man diese Lösung unter Rühren zu 250 mL kaltem Methanol. Der ausgefallene gelbe Feststoff wurde abgesaugt, gewaschen und im Vakuum bei 50°C getrocknet. Die Rohausbeute betrug 5,21 g (4,25 mmol, 70 %).

290 mg ließen sich noch durch folgende Aufarbeitung isolieren. Zum getrockneten, anorganischen Rückstand gab man 20 mL Wasser und kochte ca. 10 min, wobei sich die anorganischen Salze auflösten. Nach Abkühlen auf RT wurde abgesaugt und der feste Rückstand (Kupfer und Produkt) in 10 mL Aceton 20 min gerührt. Man saugte ab und engte die Mutterlauge ein. Danach wird der getrocknete Feststoff in 5 mL Methanol aufgenommen und unter Zugabe von 2 Tropfen Hydrazinhydrat ca. 20 min gekocht. Man saugte ab, wusch nach und trocknete im Vakuum bei 50 °C.

Zur weiteren Reinigung wurde das Rohprodukt ca. 2 h in einer Mischung aus 50 mL Methanol und 5 mL Aceton gekocht. Nach Abkühlen im Eisbad wurde abgesaugt, mit Methanol gewaschen, getrocknet und 2 h in einer Mischung aus 50 mL Isopropanol und 5 mL Aceton gekocht. Nach Abkühlen im Eisbad saugte man ab, wusch mit Isopropanol nach und kochte den getrockneten Feststoff 2 h in 60 mL Hexan. Im folgenden wurde die Lösung vom ungelösten Feststoff immer heiß abgesaugt. Danach kochte man 1,5 h in einer Mischung aus 75 mL Hexan und 6 mL Aceton. Nach Absaugen und Waschen mit Hexan wurde im Vakuum getrocknet. Anschließend kochte man in 75 mL Heptan 4 h unter Zugabe von 3 Tropfen Hydrazinhydrat. Danach wurde abgesaugt, gewaschen und im Vakuum bei 50°C getrocknet.

Anwendungsbeispiele

Beispiel 6

Zur Präparation einer erfindungsgemäßen photovoltaischen Zelle wurde eine nach der Sol-Gel-Methode hergestellte nanokristalline Dispersion von $TiO_2$ mittels Siebdruck auf einen leitfähigen, mit fluordotiertem Zinndioxid beschichteten Glasträger aufgetragen und im Luftstrom bei ca. 450°C 30 Minuten getempert. Die Dicke der $TiO_2$ Schicht betrug ca. 5 µm. Als Sensibilisator wurde eine Monolage Tris-(2,2'-bipyridyl-4,4'-dicarbonsäure)-ruthenium(II)chlorid aus einer $5 \times 10^{-3}$ M wäßrigen Lösung bei pH 4 adsorbiert. Als Elektrolyt wurde eine 250g /l Lösung von N,N'-Diphenyl-N, N'-bis (3-methylphenyl)-(1,1'-biphenyl)-4,4'diamin (TPD) in einem 4:1 Volumenverhältnis Gemisch von Toluol und Acetonitril mit 100 g/l Tetrabutylammoniumtetrafluoroborat als Leitsalz verwendet. Die Gegenelektrode bestand aus einem F-dotierten $SnO_2$ beschichteten Glassubstrat, das mit ca. 3 A Platin beschichtet wurde.

Die so präparierte Zelle wurde kurzgeschlossen und mit monochromatischem Licht, erzeugt durch eine Hochdrucklampe mit Monochromator, bestrahlt. Die Anzahl der einstrahlenden Photonen wurde durch einen Photodetektor, der einen abgezweigten Teil des Strahls mißt, ermittelt und mit dem erzeugten Strom bei der Bestrahlungswellenlänge verglichen. Durch Teilen der Anzahl der erzeugten Elektronen durch die Anzahl der einstrahlenden Photonen wurde die sogenannte Integrated Photon to Current Efficiency (IPCE) als Funktion der Wellenlänge ermittelt. Es wurde eine IPCE bis 0,7% bei 440 nm gemessen.

Beispiel 7

Eine Zelle wurde wie in Beispiel 6 beschrieben präpariert. Als Sensibilisator wurde $RuL_3^{4-}$ verwendet. Der Elektrolyt bestand aus einer 50 g/l Lösung der Substanz aus Beispiel 4 als Redoxsystem in Chloroform und ca. 25 g/l Diethylimidiazoliumtrifluorsulfonat (lmTfl) als Leitsalz. Die IPCE der Zelle betrug ca. 3% bei 440 nm. Bei Bestrahlung mit dem vollen Sonnenspektrum und 1000 W/m$^2$ betrug der Kurzschlußstrom ca. 165 µAlcm$^2$.

Beispiel 8

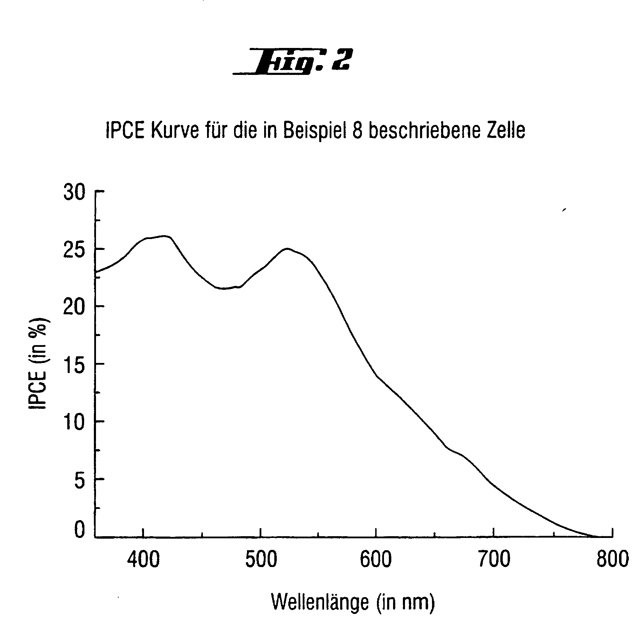

Eine Zelle wurde wie in Beispiel 6 beschrieben präpariert. Als Sensibilisator wurde Bis-(2,2'-bipyridyl-4,4'-dicarbonsäure)-bis-thiocyanato -ruthenium(II)chlorid(VIII), das aus einer 5 x $10^{-4}$ molaren ethanolischen Lösung adsorbiert wurde, verwendet. Der Elektrolyt bestand aus einer ca. 25 g/l Lösung der Substanz aus Beispiel 5 als Redoxsystem in Chloroform und ca. 25 g/l Ethylmethylimidiazoliumtrifluorsulfonat (lmTfl) und ca. 10 g/l $Li(CF_3SO_2)_2N)$ als Leitsalzen. Die IPCE der Zelle (s. Abb. 2) betrug ca. 35% bei 440 nm. Bei Bestrahlung mit dem vollen Sonnenspektrum und 1000 W/m$^2$ betrug der Kurzschlußstrom ca. 5,6 mA/cm$^2$. Der Gesamtwirkungsgrad für Energieumwandlung betrug ca. 2,5%.

Beispiel 9

Eine Zelle wurde wie in Beispiel 6 beschrieben präpariert. Als Sensibilisator wurde Bis-(2,2'-bipyridyl-4,4'-dicarbonsäure)-bis-thiocyanato-ruthenium(II)chlorid (VIII), das aus einer 5 x $10^{-4}$ molaren ethanolischen Lösung adsorbiert wurde, verwendet. Der Elektrolyt bestand aus einer ca. 15 g/l Lösung von der Substanz aus Beispiel 5 als Redoxsystem in Glutaronitril und ca. 25 g/l Ethylmethylimidiazoliumtrifluorsulfonat ((mTfl) als Leitsalz. Die IPCE der Zelle beträgt ca. 38% bei 440 nm. Bei Bestrahlung mit dem vollen Sonnenspektrum und 1000 W/m$^2$ betrug der Kurzschlußstrom ca. 5.5 mA/cm$^2$. Der Gesamtwirkungsgrad für die Energieumwandlung betrug ca. 2,5%.

## Patentansprüche

**1.** Photovoltaische Zelle (10), **gekennzeichnet durch** einen Elektrolyten (14), der eine gelöste" Spiro- oder Heterospiro-Lochleiterverbindung der Formel (I),

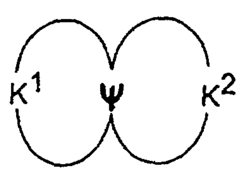

(I)

wobei
ψ C, Si, Ge oder Sn und
$K^1$ und $K^2$ unabhängig voneinander konjugierte Systeme bedeuten, als Redoxsystem enthält.

**2.** Zelle gemäß Anspruch 1, **dadurch gekennzeichnet, daß** die Spiro- oder Heterospiroverbindung ein Spirofluorenderivat der Formel (II) ist,

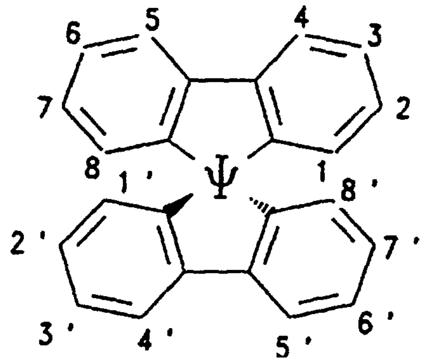

(II)

wobei ψ C, Si, Ge oder Sn ist und wobei die Benzogruppen unabhängig voneinander substituiert und/oder anelliert sein können.

**3.** Zelle gemäß Anspruch 2, **dadurch gekennzeichnet, daß** das Spirofluorenderivat eine Verbindung der Formel (III) ist,

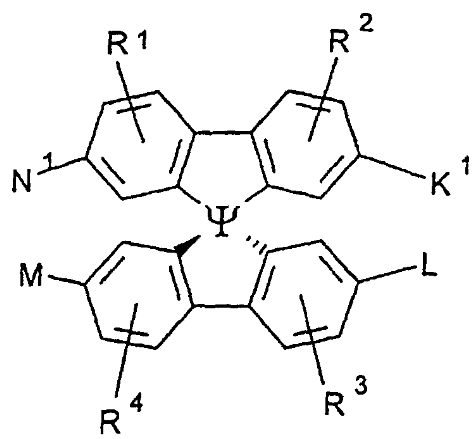

(III)

wobei die Symbole und Indizes folgende Bedeutungen haben:

ψ ist C, Si, Ge oder Sn,
$K^1$, L, M, $N^1$, $R^1$, $R^2$, $R^3$, $R^4$ sind gleich oder verschieden und bedeuten

a) Wasserstoff, $NO_2$, -CN, -F oder -Cl,
b) einen geradkettigen oder verzweigten Alkylrest mit 1 bis 20 C-Atomen, wobei

b1) eine oder mehrere nicht benachbarte $CH_2$-Gruppen durch -O-, -S-, -CO-O-, -O-CO-, -O-CO-O-, $NR^5$ oder $-Si(CH_3)_2-$ ersetzt sein können und/oder
b2) eine oder mehrere $CH_2$-Gruppen durch -CH=CH-, -C≡C-, 1,4-Phenylen, 1,4-Cyclohexylen oder 1,3-Cyclopentylen ersetzt sein können und/oder
b3) ein oder mehrere H-Atome durch F und/oder Cl ersetzt sein können und/oder

c) eine der folgenden Gruppen:

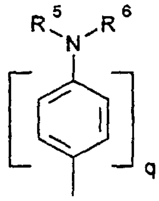

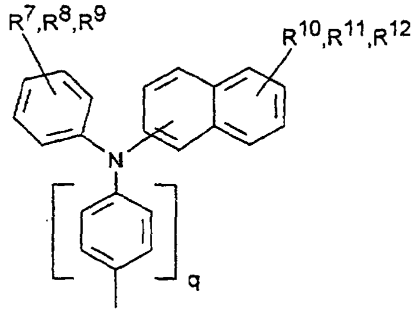

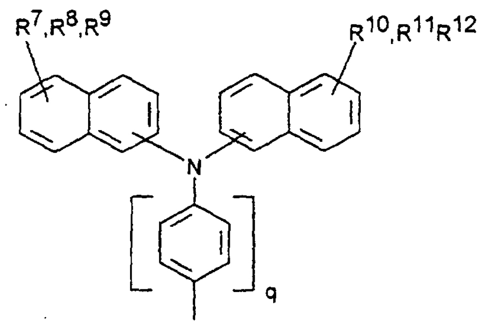

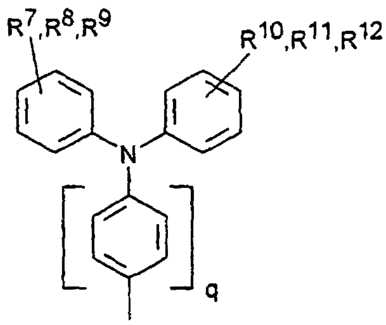

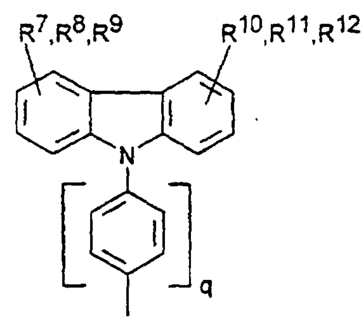

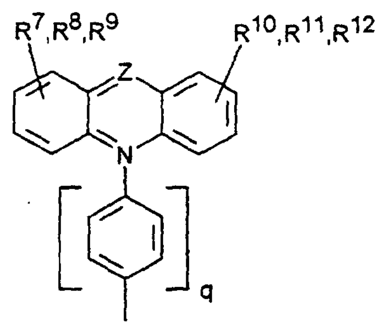

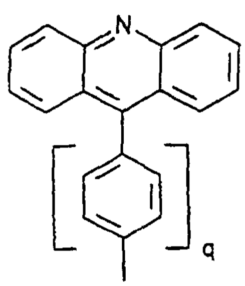

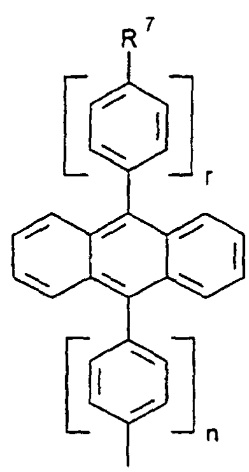

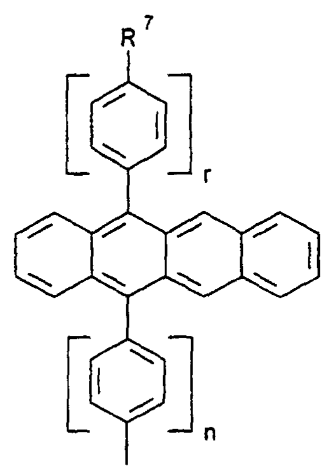

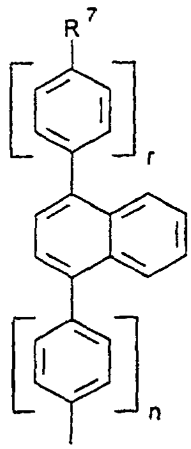
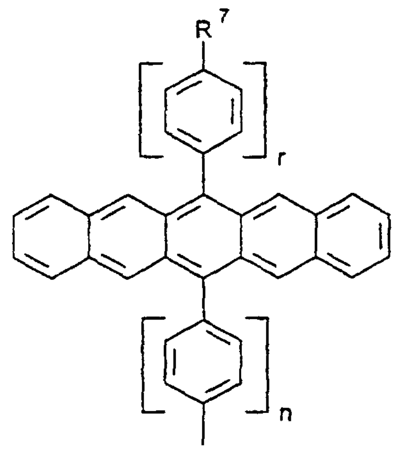

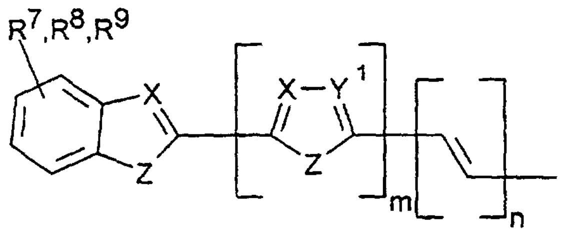
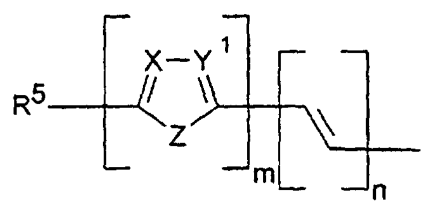

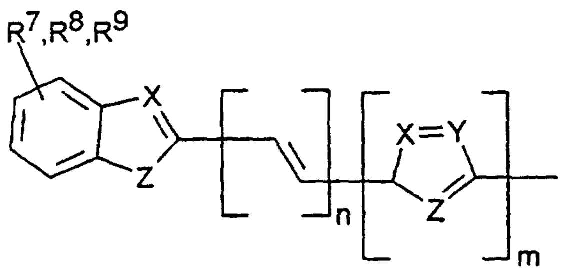
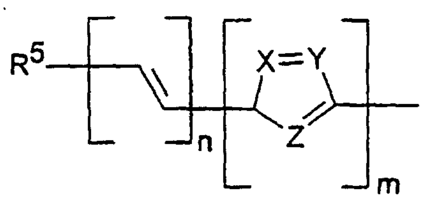

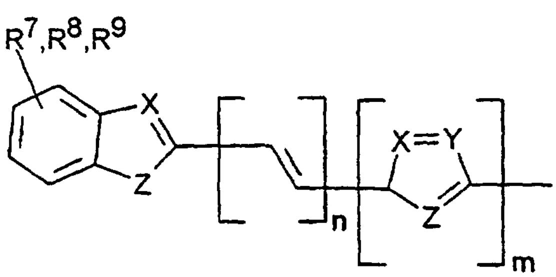
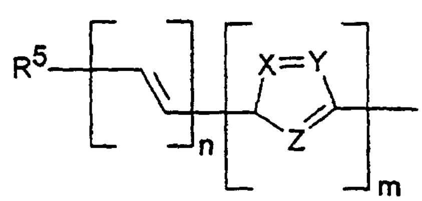

| | |
|---|---|
| X, $Y^1$ | sind jeweils gleich oder verschieden $=CR^7-$ oder =N-; |
| Z | ist -O-, -S-, $-NR^5-$, -CRR-, -CR=CR- oder -CR=N-; |
| $R^5$, $R^6$ | sind jeweils gleich oder verschieden |

a) Wasserstoff

b) ein geradkettiger oder verzweigter Alkylrest mit 1 bis 20 C-Atomen, wobei

b1) eine oder mehrere nicht benachbarte und nicht an Stickstoff gebundene $CH_2$-Gruppen durch -O-, -S-, -CO-O-, -O-CO-, - O-CO-O- oder $-Si(CH_3)_2$ er-

setzt sein können und/oder

b2) eine oder mehrere $CH_2$-Gruppen durch -CH=CH-, -C≡C-, Cyclopropan-1,2-diyl, 1,4-Phenylen, 1,4-Cyclohexylen oder 1,3-Cyclopentylen ersetzt sein können und/oder

b3) ein oder mehrere H-Atome durch F und/oder Cl ersetzt sein können und/oder

b4) $R^5$ und $R^6$ zusammen auch einen Ring bilden können;

c) Phenyl, Biphenyl, 1-Naphthyl, 2-Naphthyl, 2-Thienyl, 2-Furanyl;

$R^7$, $R^8$, $R^9$, $R^{10}$, $R^{11}$, $R^{12}$ sind gleich oder verschieden

a) Wasserstoff, -CN, -F, $NO_2$ oder -Cl

b) ein geradkettiger oder verzweigter Alkylrest mit 1 bis 20 C-Atomen, wobei

b1) eine oder mehrere nicht benachbarte $CH_2$-Gruppen durch -O-, -S-, -CO-O-, -O-CO-, -O-CO-O-, $-NR^5$ oder $-Si(CH_3)_2-$ ersetzt sein können und/oder

b2) eine oder mehrere $CH_2$-Gruppen durch -CH=CH-, -C≡C-, Cyclopropan-1,2-diyl, 1,4-Phenylen, 1,4-Cyclohexylen oder 1,3-Cyclopentylen ersetzt sein können und/oder

b3) ein oder mehrere H-Atome durch F und/oder Cl ersetzt sein können;

c) Phenyl, Biphenyl, 1-Naphthyl, 2-Naphthyl, 2-Thienyl, 2-Furanyl, -O-Phenyl, -O-Biphenyl, -O-1-Naphthyl, -O-2-Naphthyl, -O-2-Thienyl, -O-2-Furanyl;

m, n, p, q, r sind jeweils gleich oder verschieden 0, 1, 2, 3, 4, 5 oder 6.

4. Zelle gemäß Anspruch 3, **dadurch gekennzeichnet, daß** das 9,9'-Spirobifluorenderivat eine Verbindung der Formel (IV) ist,

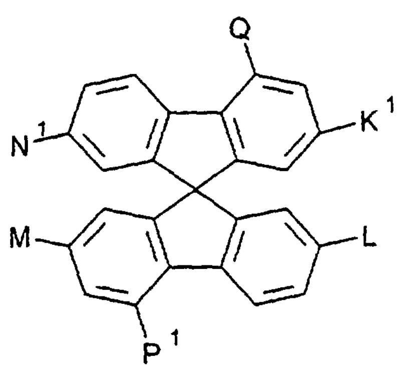

(IV)

wobei die Symbole folgende Bedeutungen haben:

IV.a) $K^1 = L = M = N^1 =$

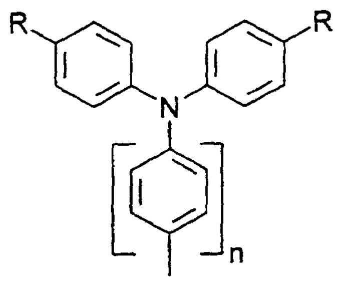

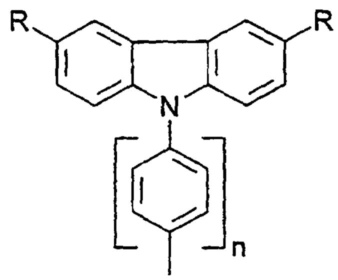

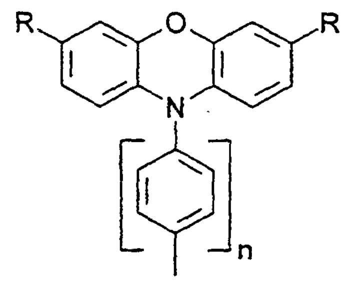

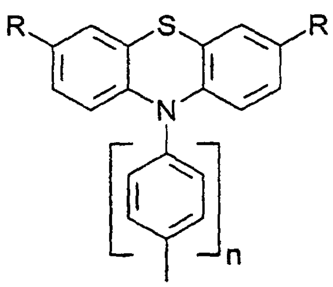

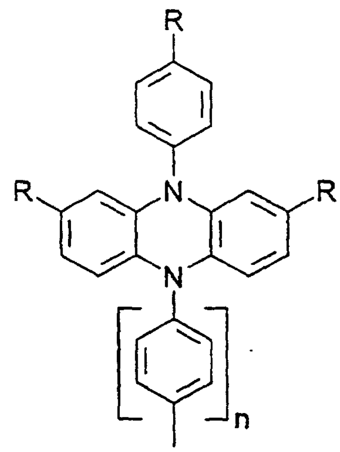

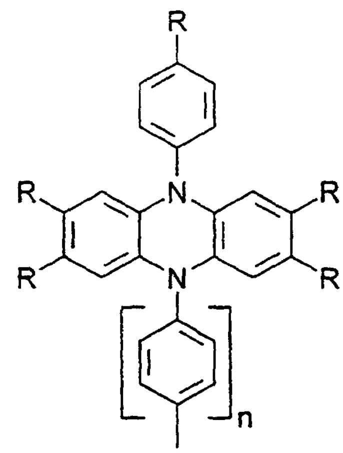

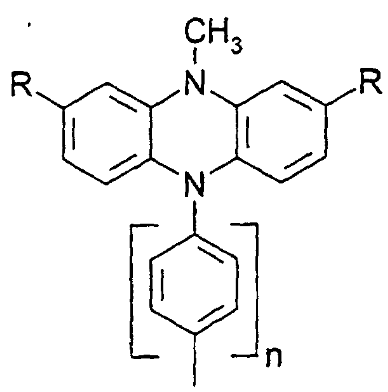

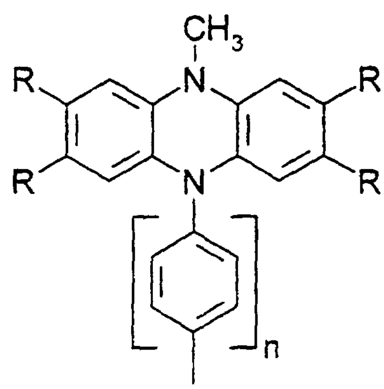

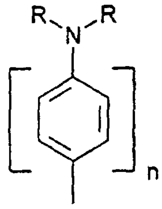

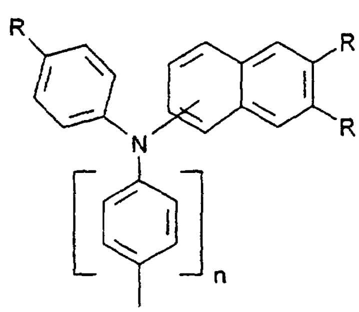

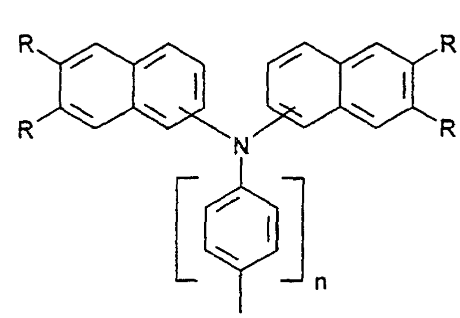

R gleich oder verschieden H, Alkyl, -O-Alkyl, -S-Alkyl, mit jeweils 1 bis 20 C-Atomen, Phenyl, Biphenyl, 1-Naphthyl, 2-Naphthyl, 2-Thienyl, 2-Furanyl, -O-Phenyl, -O-Biphenyl, -O-1-Naphthyl, -O-2-Naphthyl, -O-2-Thienyl, -O-2-Furanyl, -CN, $NR_2^+$, wobei -O-Alkyl/Aryl, -S-Alkyl/Aryl, CN, $NR_2$ nicht an Stickstoff gebunden sein darf;

n = 0,1,2,3,4.

und Q, $P^1$ sind gleich oder verschieden und aus der Gruppe H, COOR, $CH_2OR$,

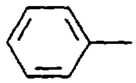
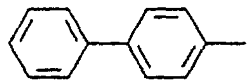
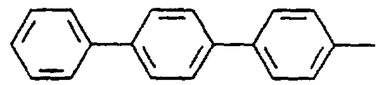

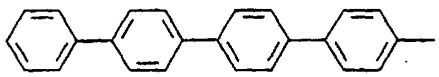
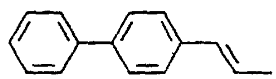
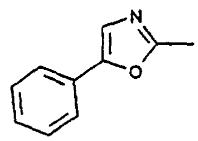

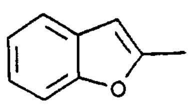
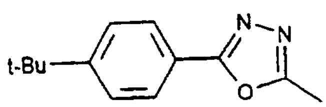
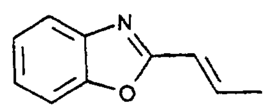

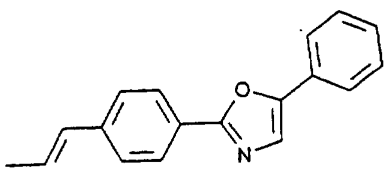
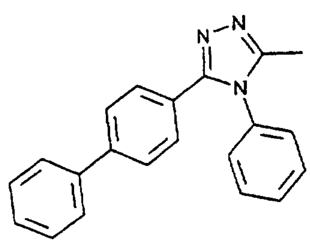
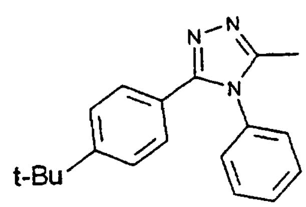

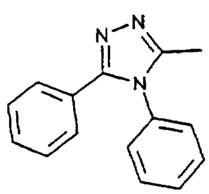
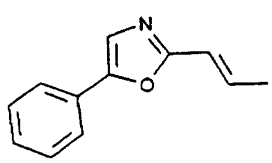
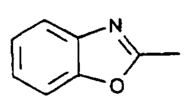

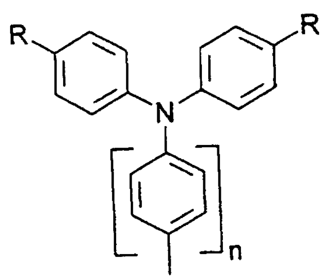

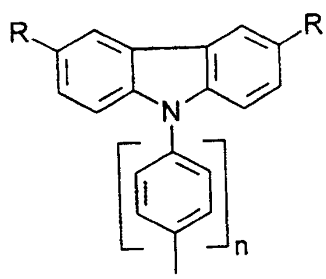

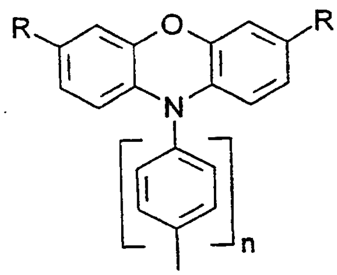

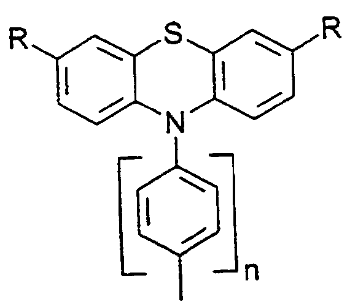

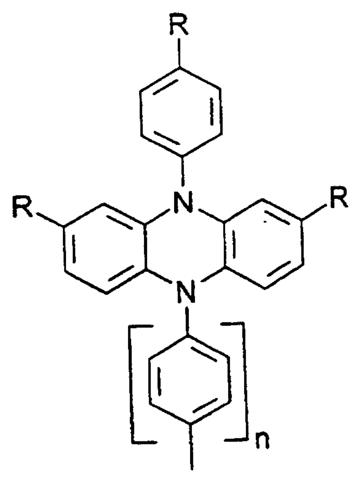

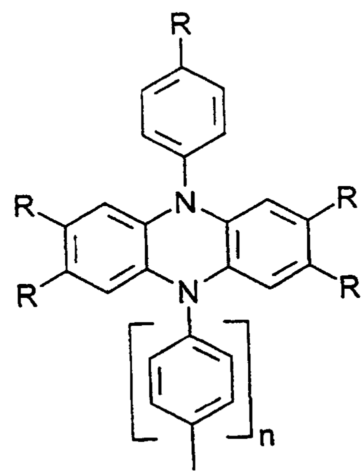

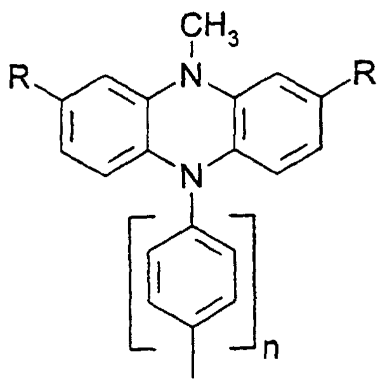

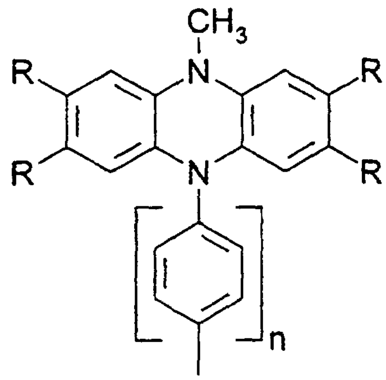

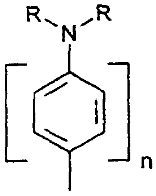

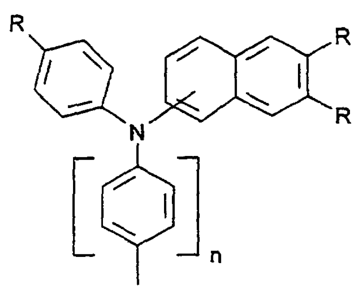

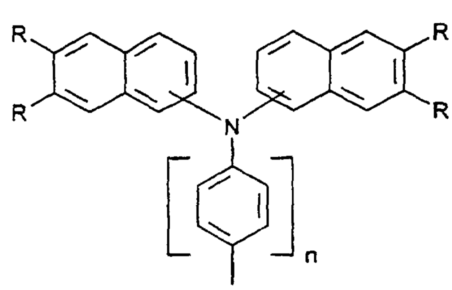

wobei die Symbole und Indizes die oben angegebenen Bedeutungen haben

IV.b) $K^1 = N^1$ und ist aus der Gruppe

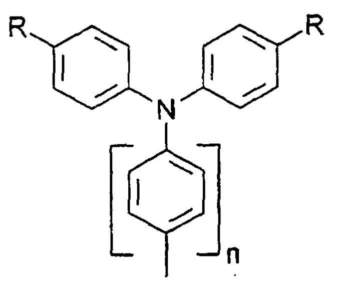

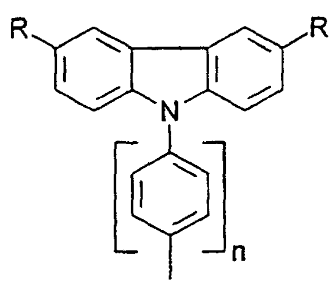

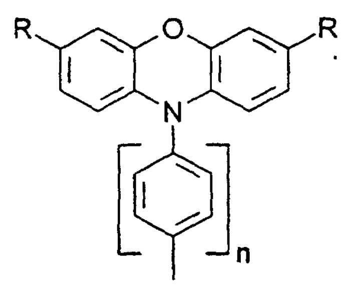

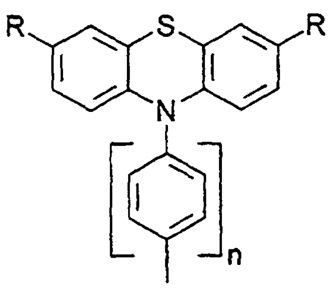

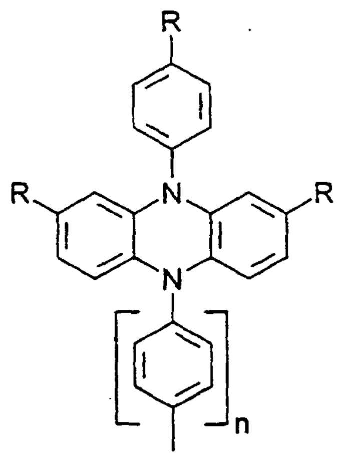

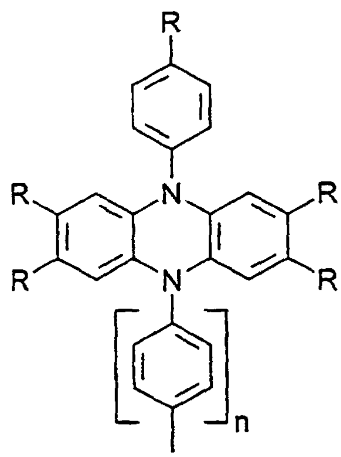

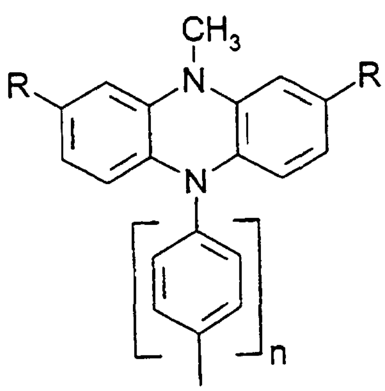

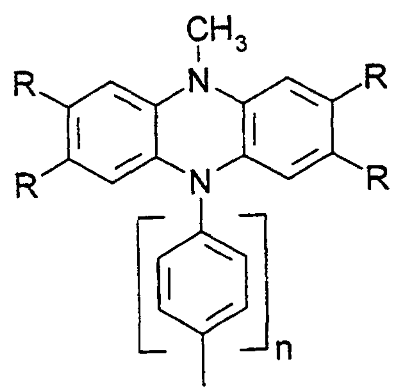

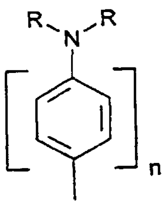
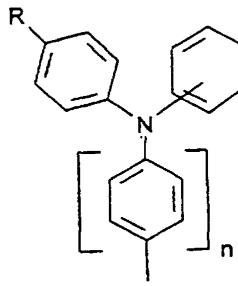
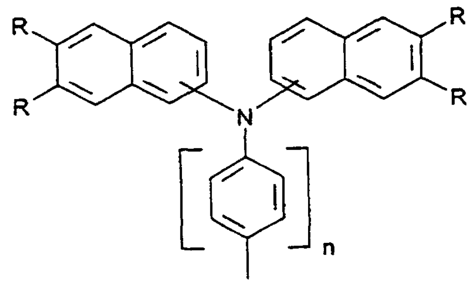

und L = M und ist aus der Gruppe
H, COOR $CH_2OR$,

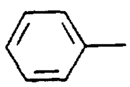
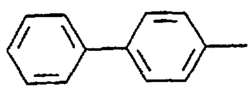
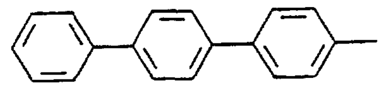
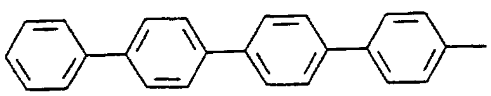
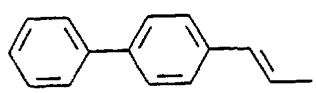
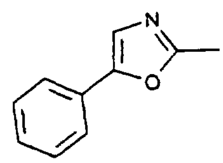
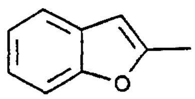
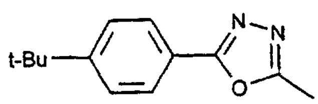
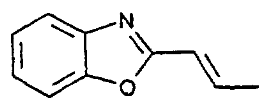
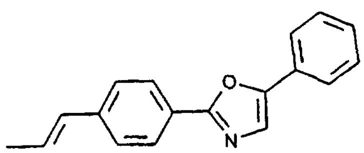
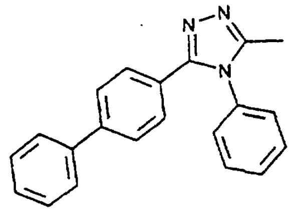
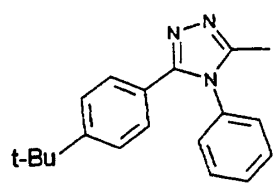
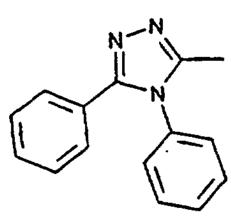
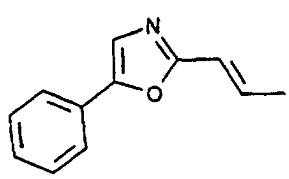
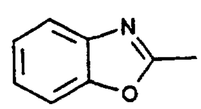

und Q, $P^1$ sind gleich oder verschieden aus der Gruppe

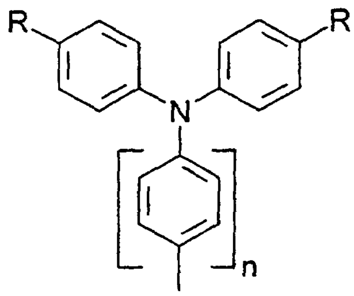
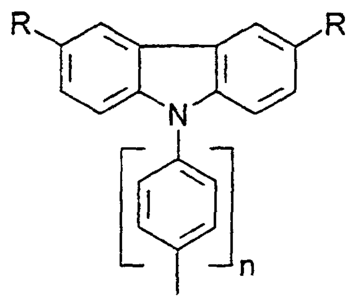
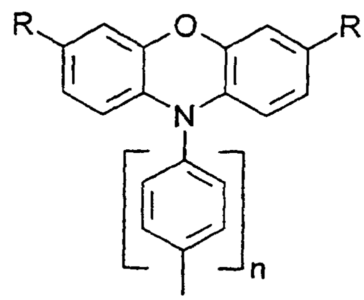

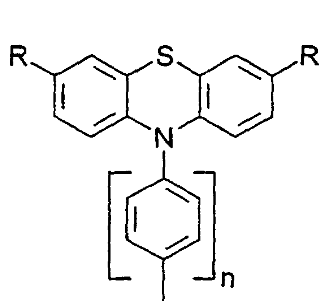
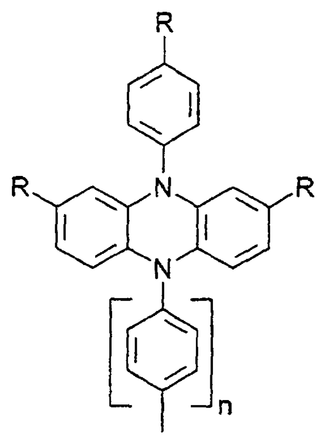
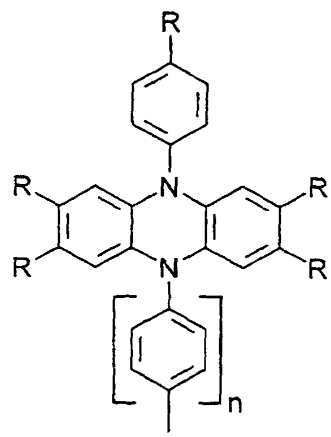

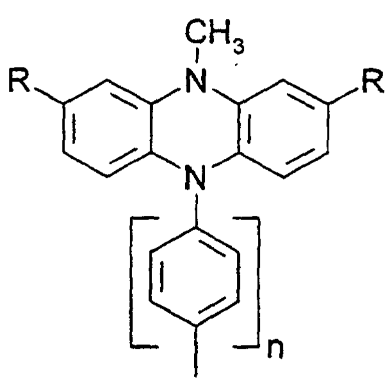
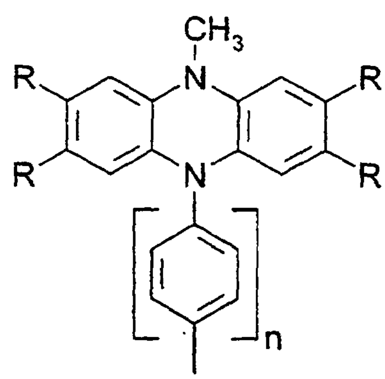

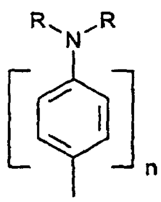
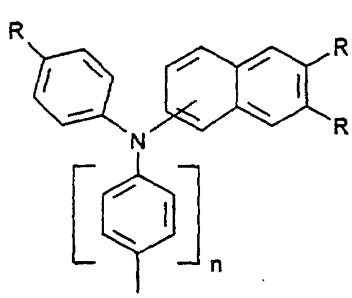
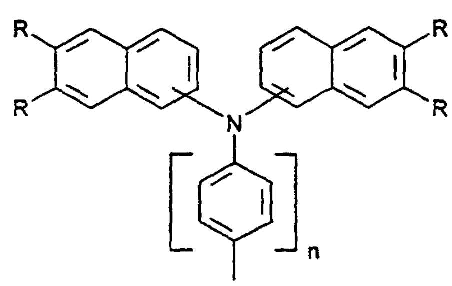

H, COOR $CH_2OR$,

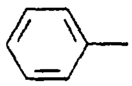
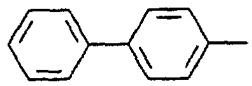
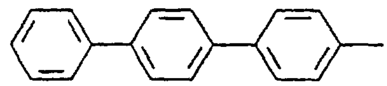

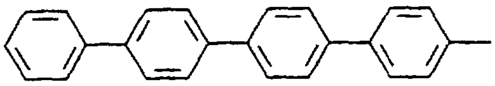
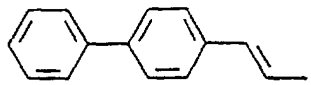
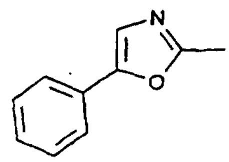

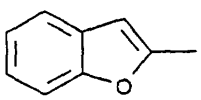
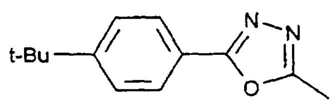
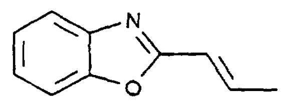

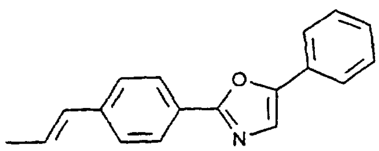
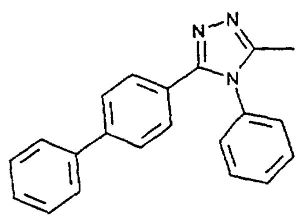
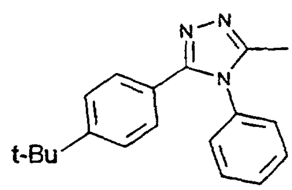

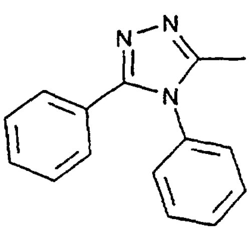
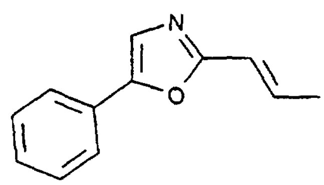
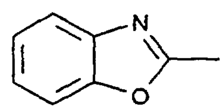

wobei die Symbole und Indizes die oben angegebenen Bedeutungen haben,

IVc) $K^1$ = M und ist aus der Gruppe

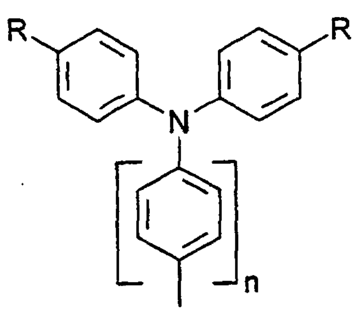
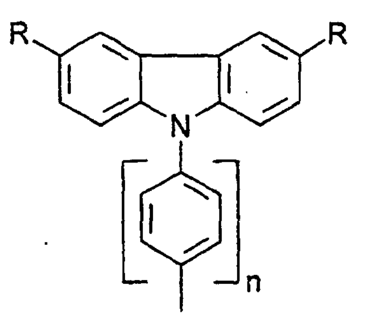
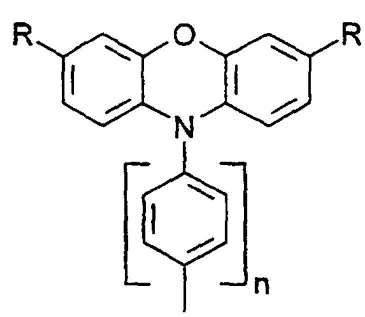

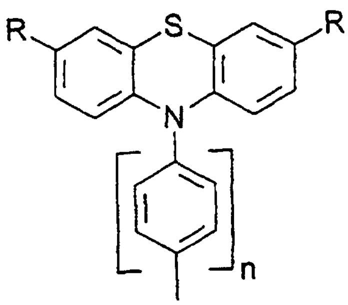
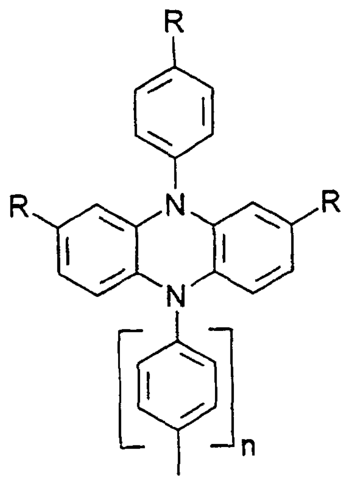
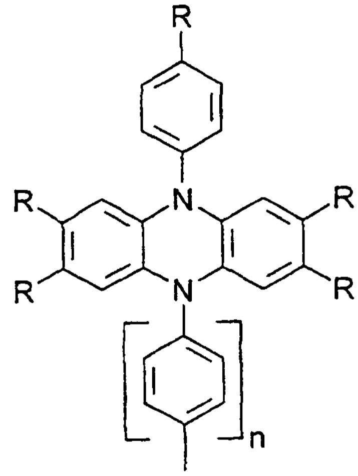

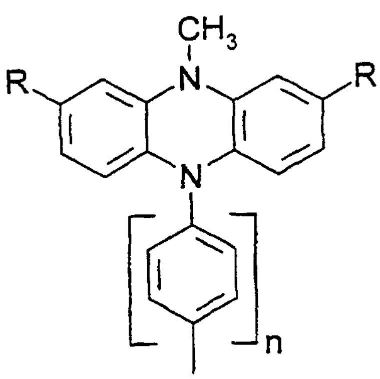
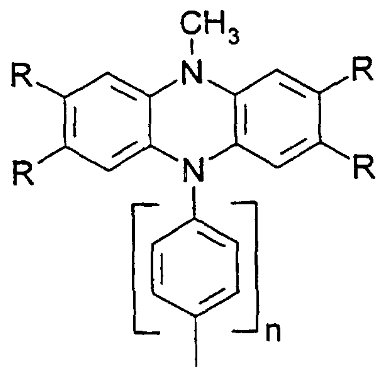

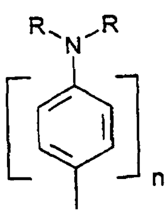
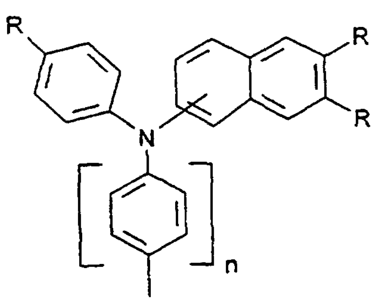
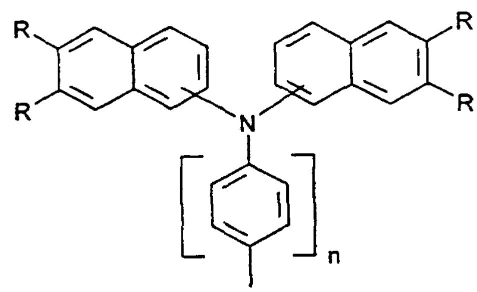

und M = $N^1$ ist und aus der Gruppe
H, COOR, $CH_2OR$,

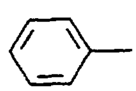
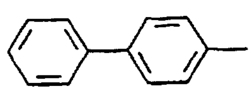
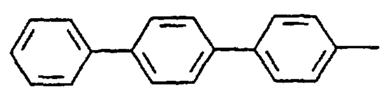

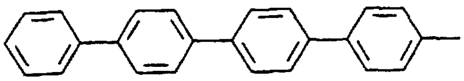

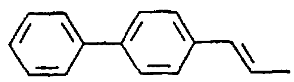

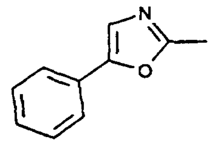

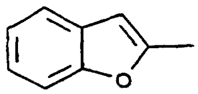

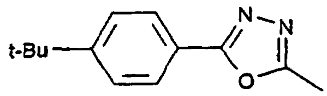

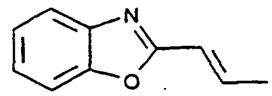

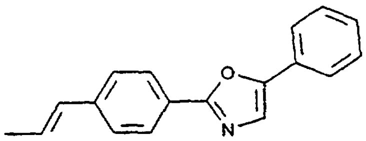

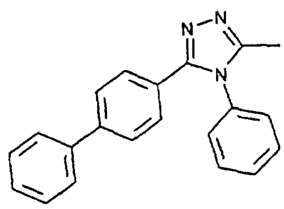

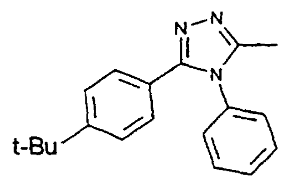

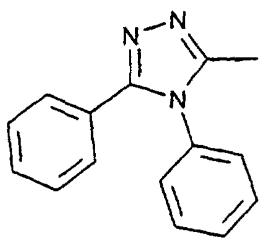

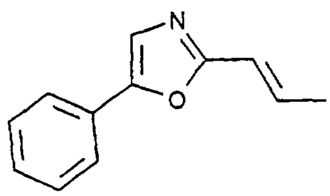

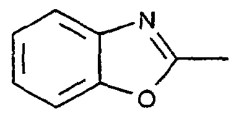

und Q, $P^1$ sind gleich oder verschieden aus der Gruppe

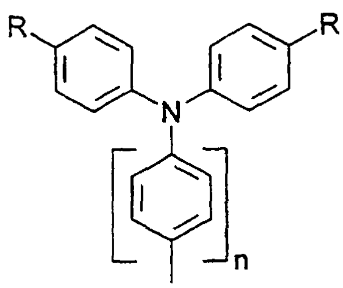

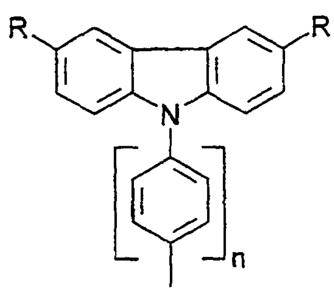

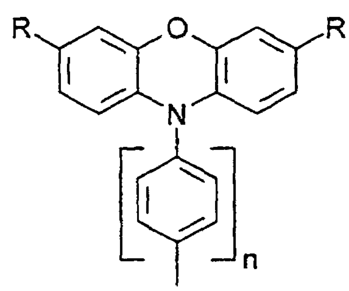

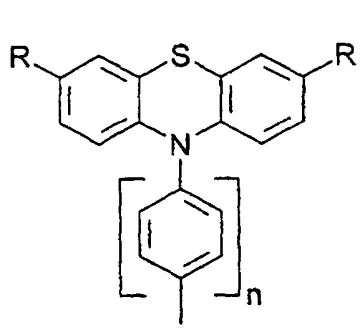

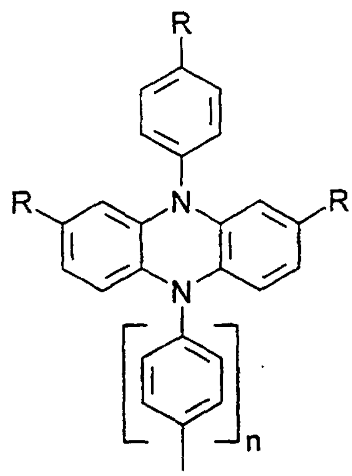

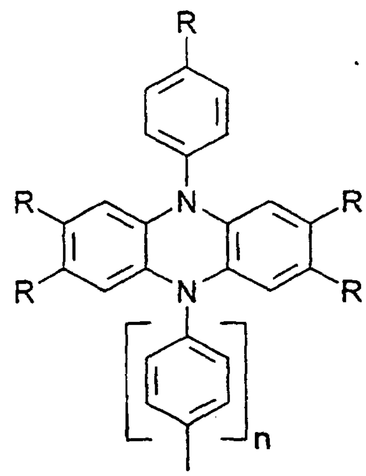

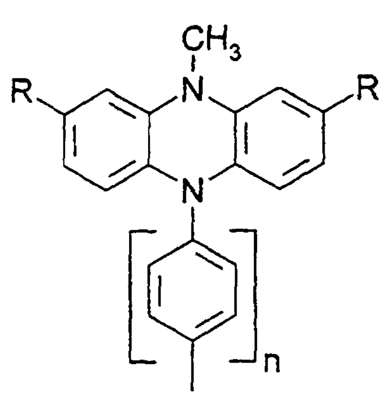

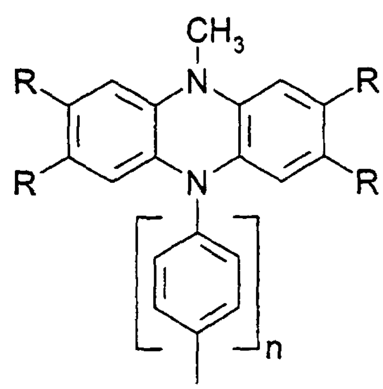

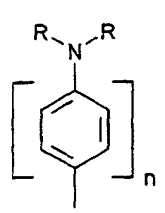

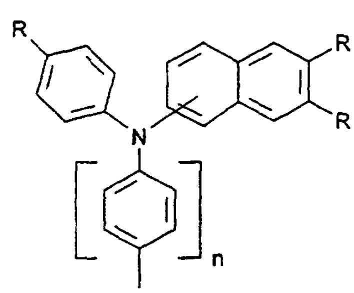

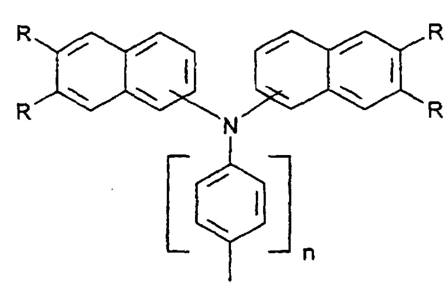

H, COOR, $CH_2OR$

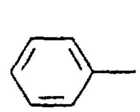

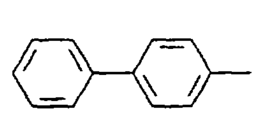

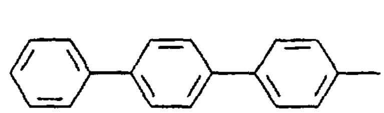

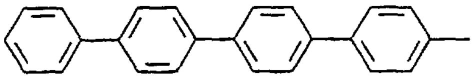
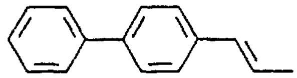
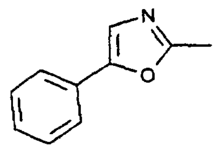

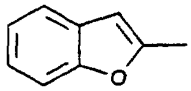
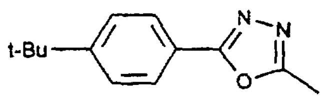
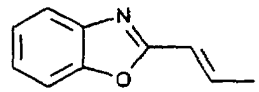

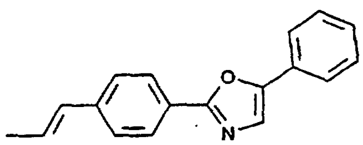
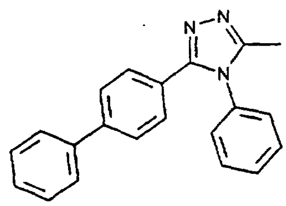
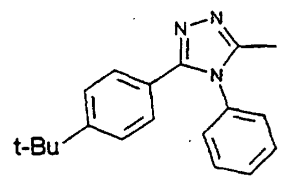

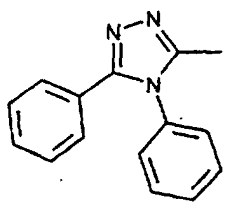
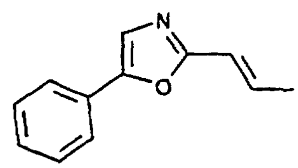
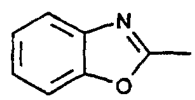

wobei die Symbole und Indizes die oben angegebenen Bedeutungen haben.

**5.** Zelle gemäß Anspruch 4, **dadurch gekennzeichnet, daß** die Symbole in der Formel (IV) folgende Bedeutungen haben:

Ivaa) $K^1 = L = M = N^1$ und ist aus der Gruppe:

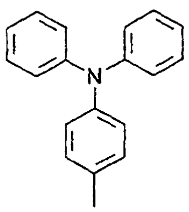
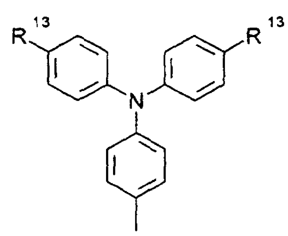
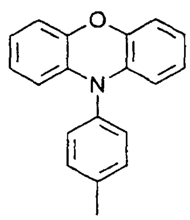
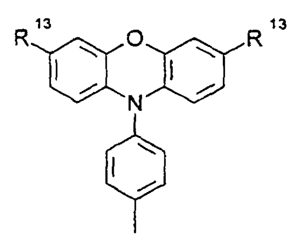

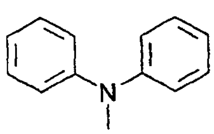
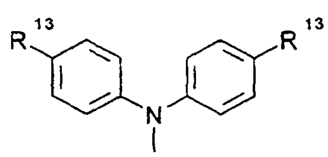
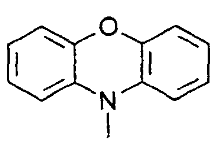
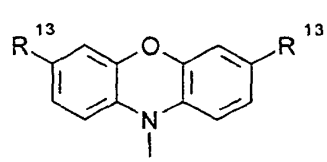

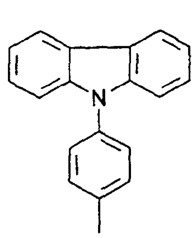 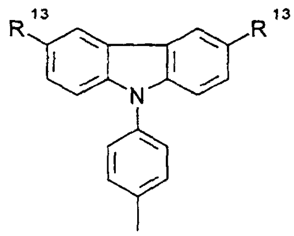 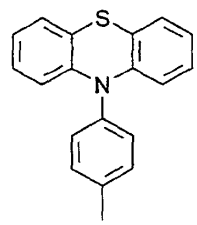 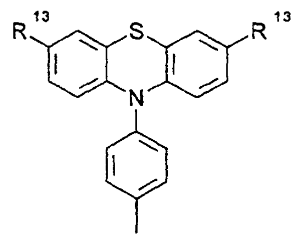

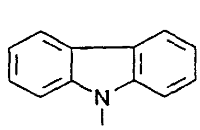 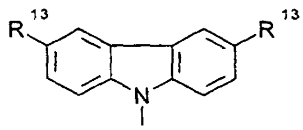 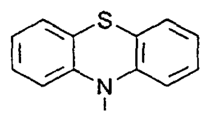 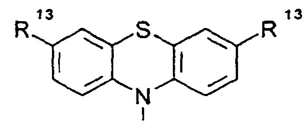

wobei $R^{13}$ $-O-CH_3$, $-O-C_2H_5$, $-S-CH_3$, $-S-C_2H_5$, vorzugsweise $-O-CH_3$, $-S-CH_3$, besonders bevorzugt $-O-CH_3$, bedeutet;
und Q = $P^1$ und ist aus der Gruppe
H, $COOR^{14}$, $CH_2OR^{14}$,

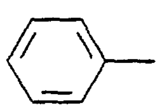 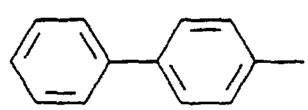 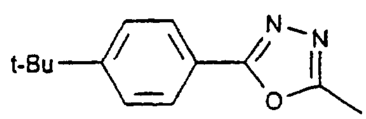

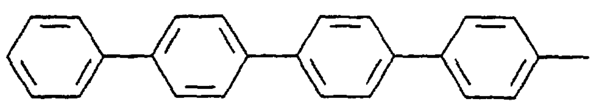 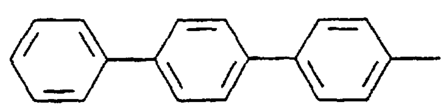

wobei $R^{14}$ eine geradkettige oder verzweigte Alkylgruppe mit 1 bis 12, vorzugsweise 1 bis 4 C-Atomen ist;

IV.ba) $K^1 = L = M = N^1 = Q = P^1$ und ist aus der Gruppe

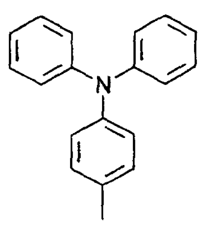 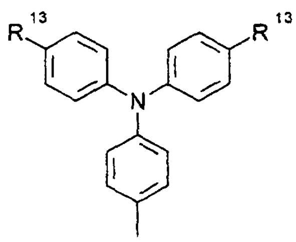 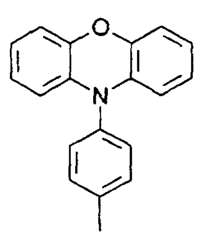 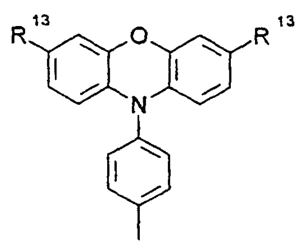

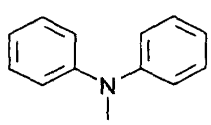 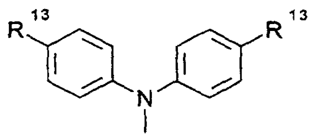 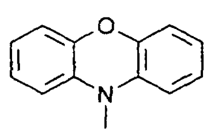 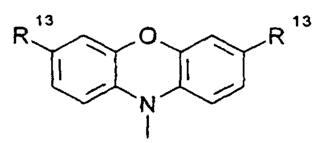

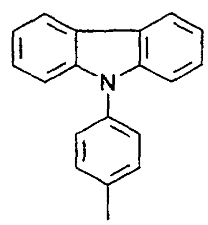 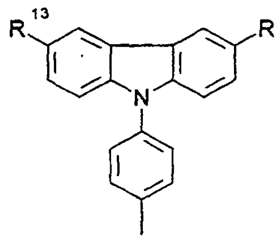 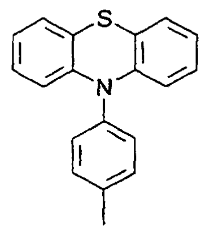 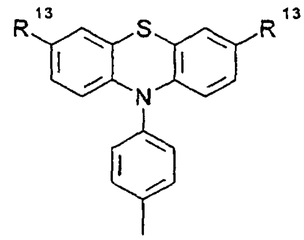

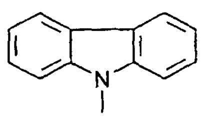 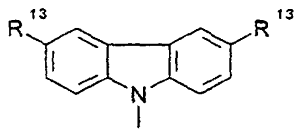 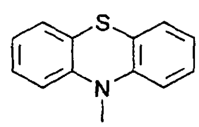 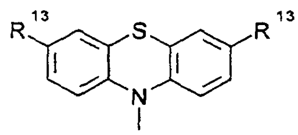

wobei $R^{13}$ die oben angegebenen Bedeutungen hat;

IV.ca) $K^1 = L = M = N^1$ und ist aus der Gruppe

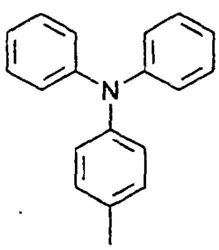 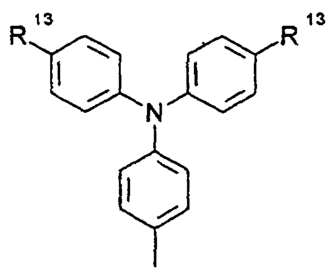 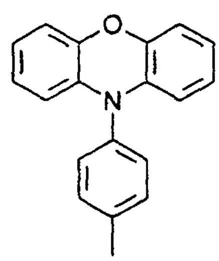 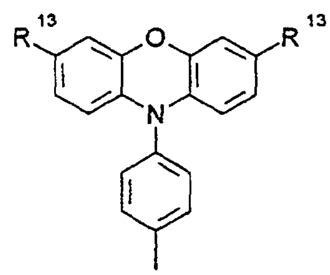

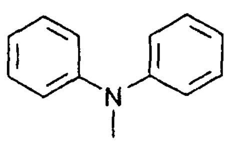 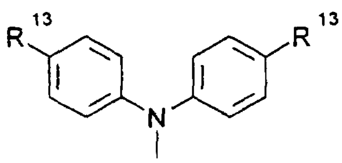 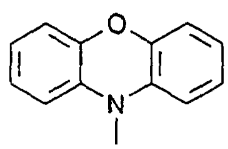 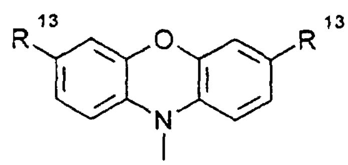

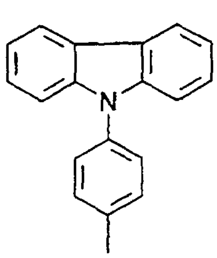 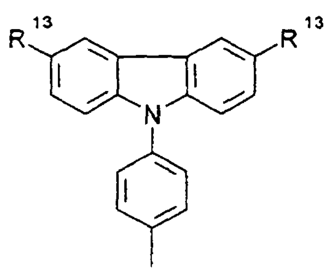 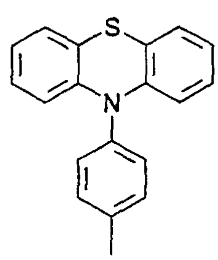 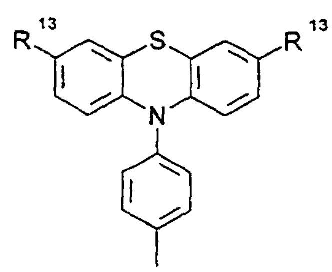

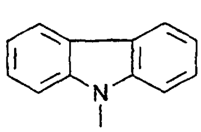 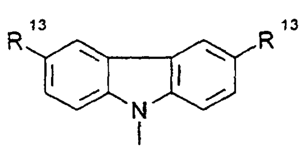 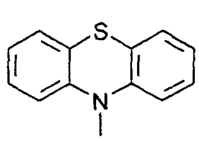 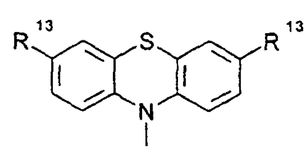

und Q = H und $P^1$ ist aus der Gruppe
H, $COOR^{14}$, $CH_2OR^{14}$,

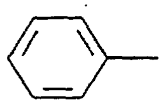
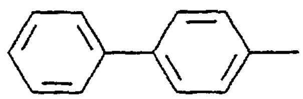
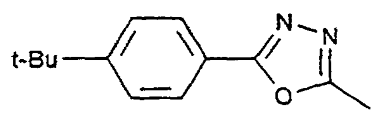

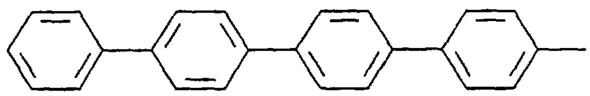
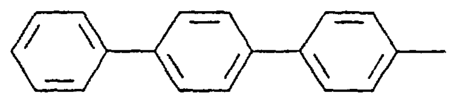

wobei $R^{13}$, $R^{14}$ die oben angegebenen Bedeutungen haben.

6. Zelle gemäß einem oder mehreren der Ansprüche 1 bis 5, **dadurch gekennzeichnet, daß** das anodische Grenzpotential der Elektrolytflüssigkeit (14) gleich oder über 2,5 V liegt.

7. Zelle gemäß Anspruch 6, **dadurch gekennzeichnet, daß** die Elektrolytflüssigkeit (14) eine Verbindung aus der Gruppe Acetonitril, Glutarodinitril, Ethylencarbonat, Propylencarbonat, Chlorbenzol und 3-Methyl-2-oxazilidinon enthält.

8. Zelle gemäß einem oder mehreren der vorhergehenden Ansprüche 1 bis 7, **dadurch gekennzeichnet, daß** der Elektrolyt (14) ein Leitsalz enthält.

9. Zelle gemäß einem oder mehreren der vorgehenden Ansprüche 1 bis 8, **dadurch gekennzeichnet, daß** sie eine lichtabsorbierende Schicht (12), die ein Halbleitermaterial mit einer Bandlücke von mindestens 3 eV enthält, aufweist.

10. Photovoltaische Zelle gemäß Anspruch 9, **dadurch gekennzeichnet, daß** das Halbleitermaterial (12) ein Metalloxid ist.

11. Photovoltaische Zelle nach Anspruch 9 oder 10, **dadurch gekennzeichnet, daß** die Halbleiteroberfläche (12) einen Rauhigkeitsfaktor von > 20 aufweist.

12. Photovoltaische Zelle nach einem oder mehreren der vorhergehenden Ansprüche 1 bis 11, **dadurch gekennzeichnet, daß** sie eine lichtabsorbierende Schicht mit einem Farbstoff als Sensibilisator enthält.

13. Verwendung einer Lochleiterverbindung der Formel (I)

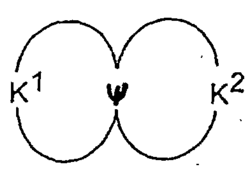
(I)

wobei

| | |
|---|---|
| $\psi$ | C, Si, Ge oder Sn und |
| $K^1$ und $K^2$ | unabhängig voneinander konjugierte Systeme bedeuten, |

als Redoxsystem in einer Elektrolytflüssigkeit (14).

**Claims**

**1.** Photo-voltaic cell (10) **characterised by** an electrolyte (14) which contains a dissolved spiro- or heterospiro hole conductor compound as a redox system having the Formula (I)

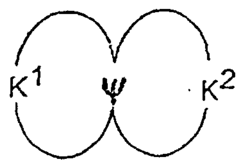

(I)

where ψ signifies C, Si, Ge or Sn and
$K^1$ and $K^2$ independently of one another signify conjugated systems

**2.** Cell in accordance with claim 1, **characterised in that** the spiro- or heterospiro compound is a spirofluorene derivative having the Formula (II)

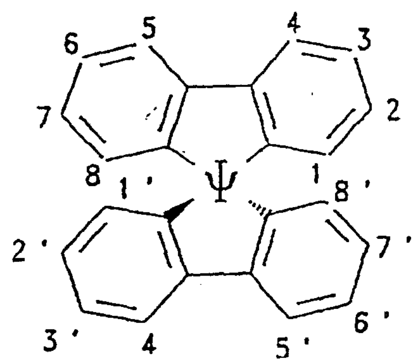

(II)

where ψ stands for C, Si, Ge or Sn and where the benzo-groups independently of one another may be substituted and / or anellated

**3.** Cell in accordance with claim 2, **characterised in that** the spiroflourene derivative is a compound having the Formula (III)

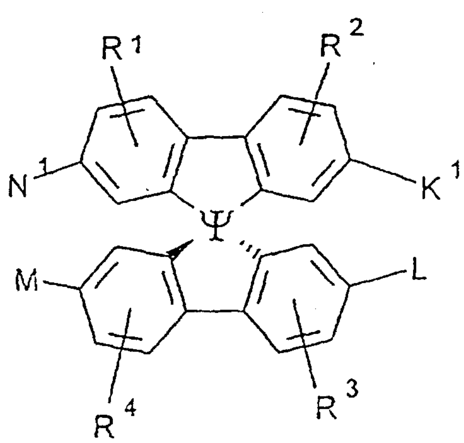

(III)

whereby the symbols and indices have the following significance:

ψ is C, Si, Ge or Sn
$K^1$, L, M, $N^1$, $R^1$, $R^2$ , $R^3$, $R^4$ are the same or different and signify

a) hydrogen, $NO_2$, -CN, -F or -Cl,

b) a straight-chain-or branched alkyl residue with 1 to 20 atoms, where

b1) one or more non-adjacent $CH_2$-groups may be replaced with -O-, -S-, -CO-O-, -O-CO-, -O-CO-O-, $NR^5$ or $-Si(CH_3)_2-$ and / or

b2) one or several $CH_2$-groups may be replaced by CH=CH-, -C≡C-, 1,4-phenylene, 1,4-cyclohexylene or 1,3-cyclopentylene and / or

b3) one or several H atoms may be replaced by F and / or Cl and or

c) one of the following groups

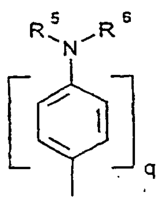

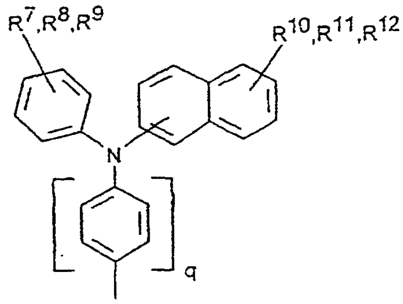

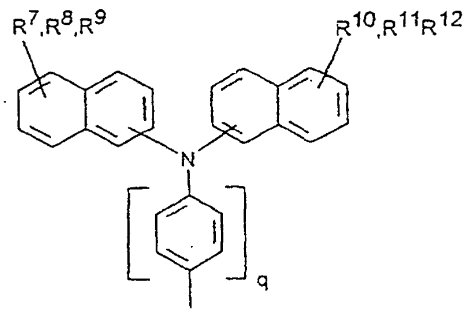

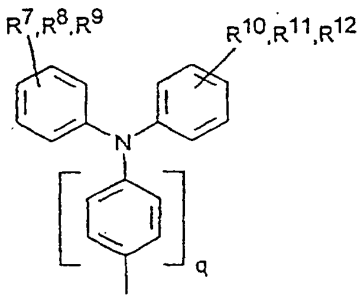

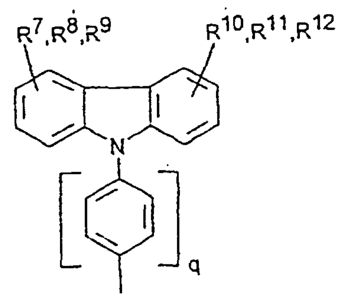

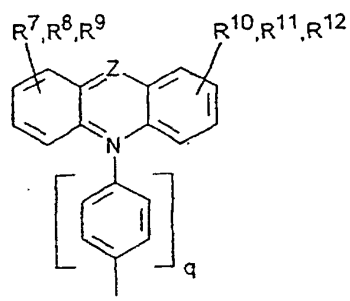

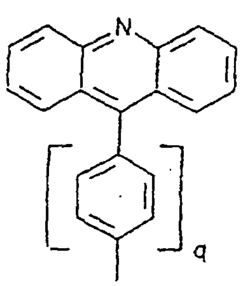

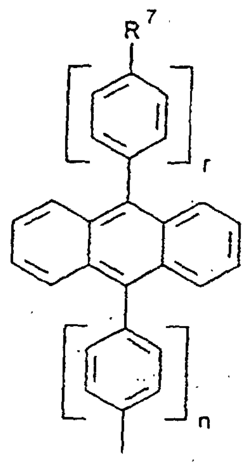

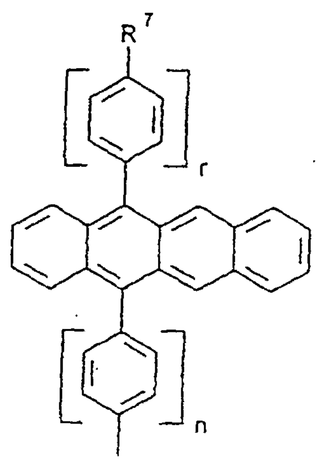

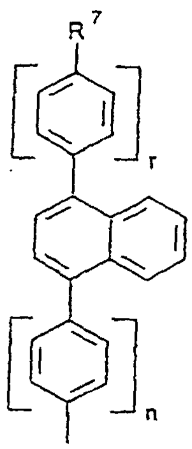

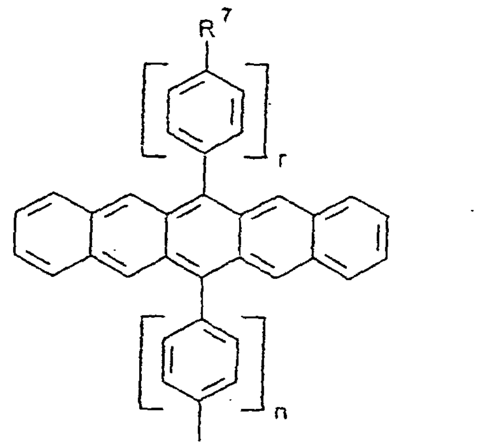

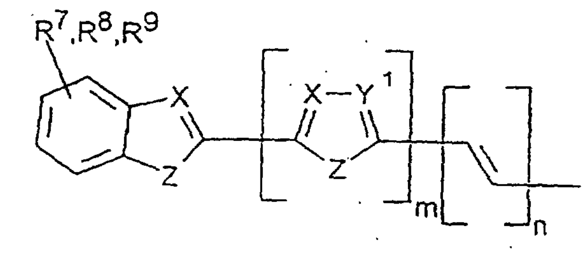

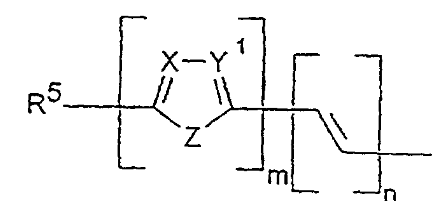

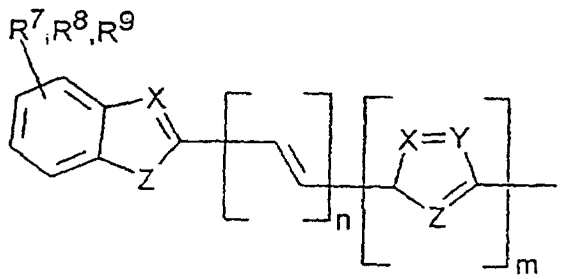

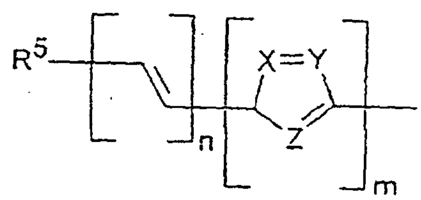

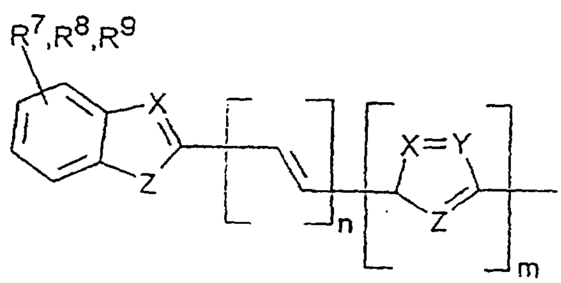

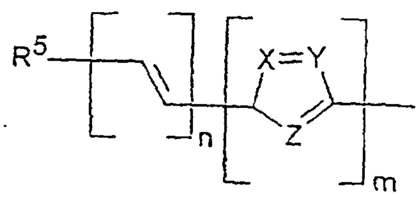

| | |
|---|---|
| X, $Y^1$ | are the same or different and are $=CR^7-$ or $=N-$; |
| Z | is -O-, -S-, $-NR^5-$, -CRR-, -CR=CR- or -CR=N-, |
| $R^5$, $R^6$ | are the same or different members of the following |

a) hydrogen
b) a straight-chain or a branched alkyl residue having 1 to 20 C-atoms where

b1) one or several $CH_2$- groups which are non-adjacent and not attached to nitrogen can be replaced by -O-, -S-, -CO-O-, -O-CO-, -O-CO-O- or $-Si(CH_3)_2$ and / or

b2) one or several $CH_2$-groups can be replaced with -CH=CH-, -C≡C-, cyclopropane-1,2-diyl, 1,4-phenylene, 1,4-cyclohexylene or 1,3-cyclopentylene and / or

b3) one or several H atoms can be replaced by F and / or Cl and / or

b4) $R^5$ and $R^6$ together can also build a ring

c) Phenyl, biphenyl 1,1-naphthyl, 2-naphthyl, 2-thienyl, 2-furanyl;

$R^7$, $R^8$, $R^9$, $R^{10}$, $R^{11}$, $R^{12}$ are the same or different

a) hydrogen, -CN, -F, $NO_2$ or -Cl

b) a straight-chain or a branched alkyl residue with 1 to 20 C-atoms, where

b1) one or several non-adjacent $CH_2$-groups can be replaced by -O-, -S-, -CO-O-, -O-CO-, O-CO-O-, $-NR^5$ or $-Si(CH_3)_2$

b2) one or several $CH_2$-groups can be replaced by -CH=CH-, -C≡C-, cyclopropane-1,2-diyl, 1,4-phenylene, 1,4-cyclohexylene or 1,3-cyclopentylene and / or

b3) one or more H-atoms can be replaced by F and / or Cl;

c) phenyl, biphenyl, 1-naphthyl, 2-naphthyl, 2-thienyl, 2-furanyl, -O-phenyl, - O-biphenyl, -O-1-naphthyl, -O-2-naphthyl, -O-2-thienyl, -O-2-furanyl;

m, n, p, q, and r are the same or different members of 0, 1, 2, 3, 4, 5 or 6.

**4.** Cell in accordance with claim 3, **characterised in that** the 9,9'-spirofluorene derivative is a compound having the formula (IV)

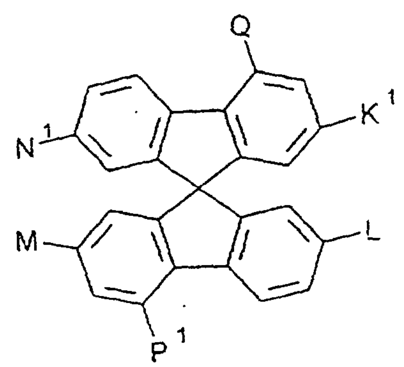

(IV)

where the symbols have the following significance:

IVa) $K^1$ =L=M=$N^1$

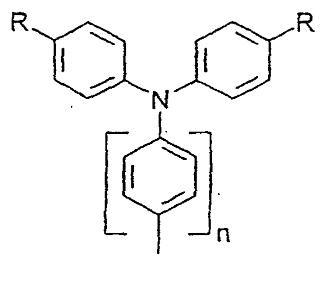
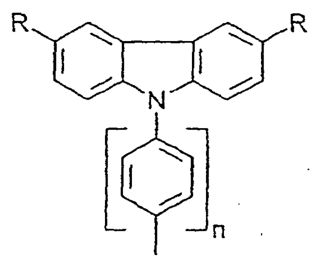
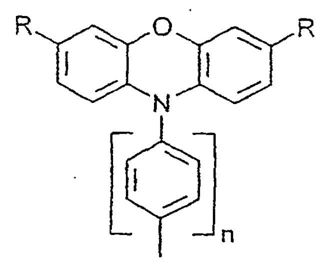

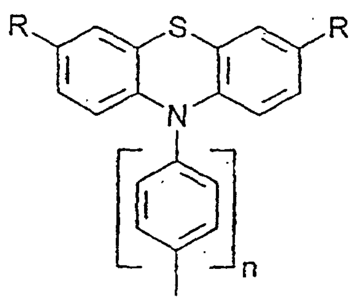
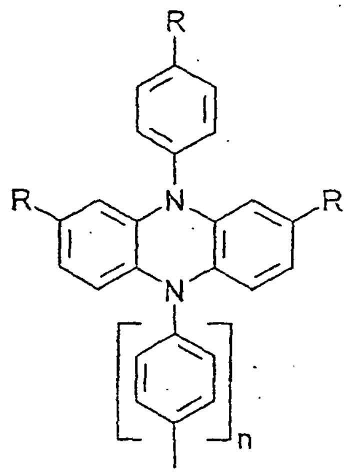
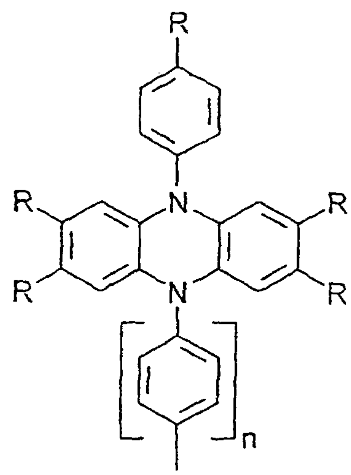

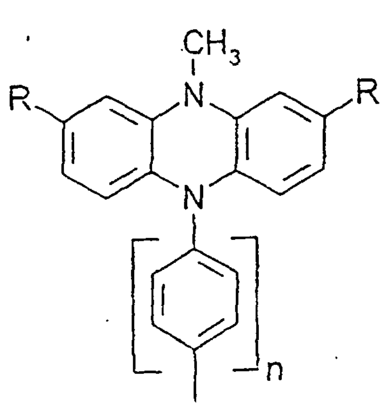
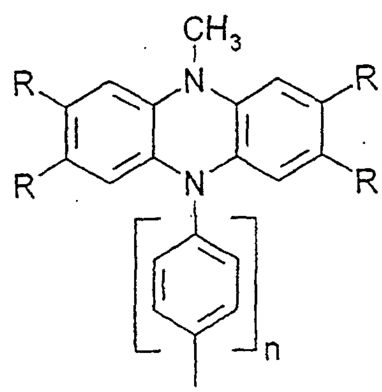

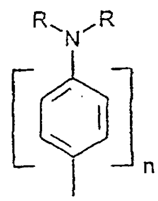
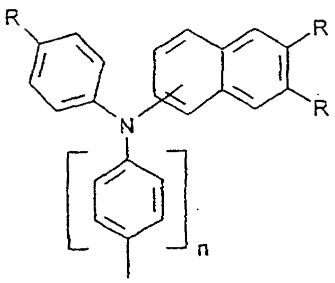
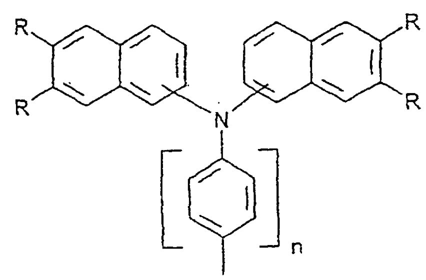

R is the same member or different members of H, alkyl, -O-alkyl, -S-alkyl with in each case 1 to 20 C-atoms, phenyl biphenyl 1-naphthyl, 2-naphthyl, 2-thienyl., 2-furanyl, -O-phenyl, -O-biphenyl, -O-1-naphthyl, -O-2-naphthyl, -O-2-thienyl,-O- 2-furanyl where -O-alkyl/ aryl, -S-alkyl / aryl CN, $NR_2$ must not be bonded to nitrogen,

n = 0, 1, 2, 3, 4

and Q, $P^1$ are the same or different and selected from the group
H, COOR, $CH_2OR$,

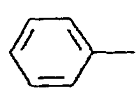
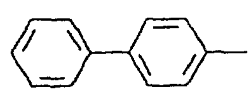
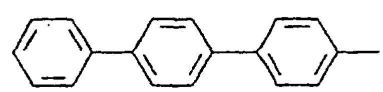

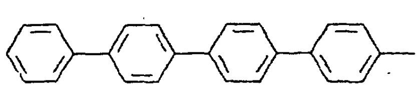
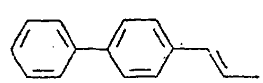
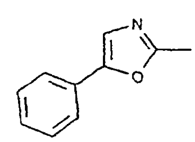

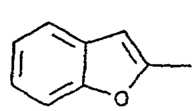
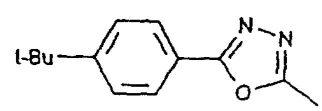
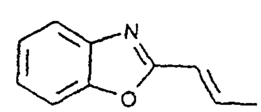

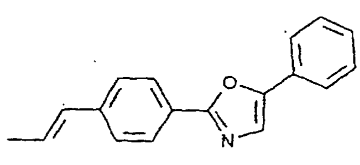
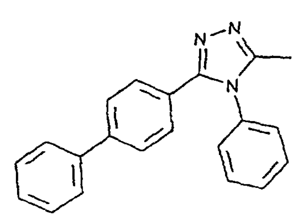
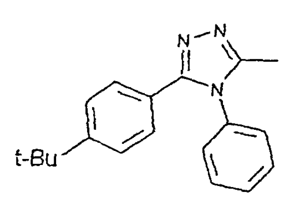

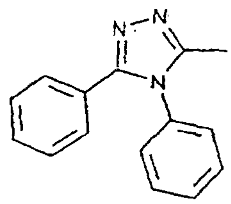
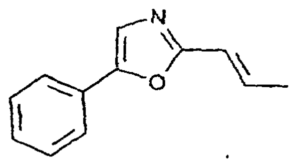
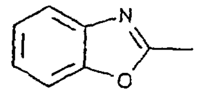

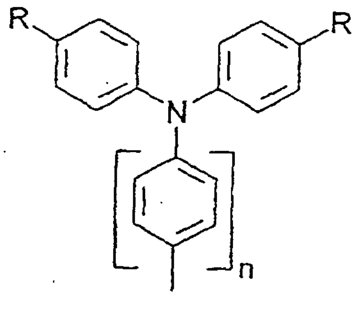
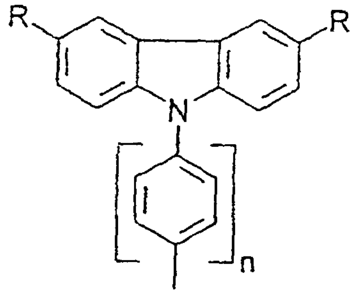
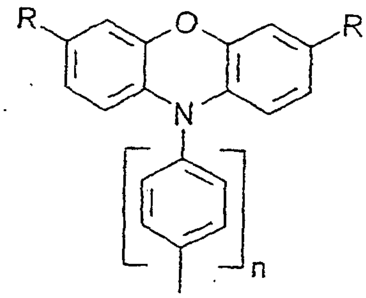

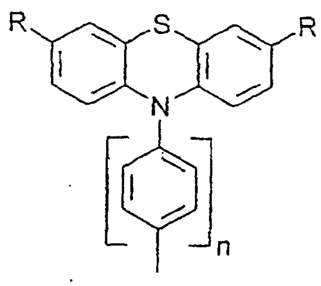
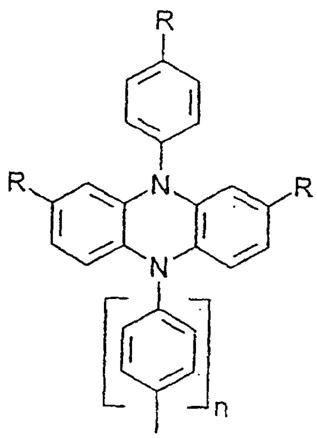
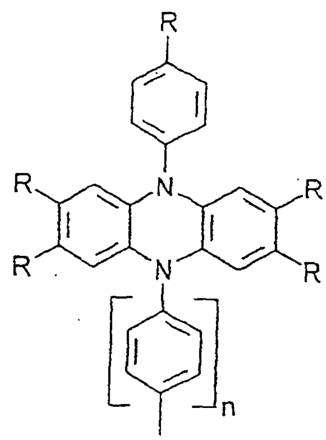

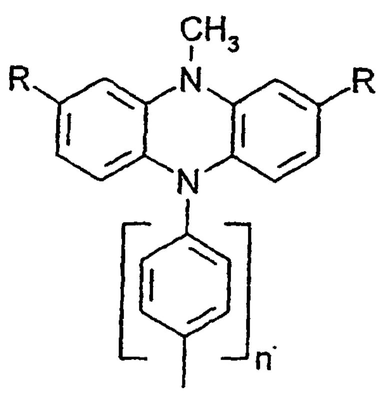
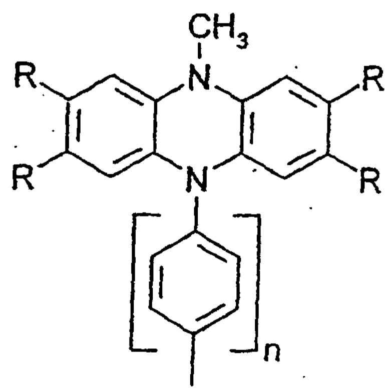

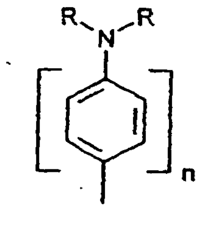

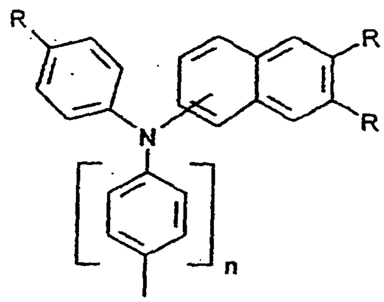

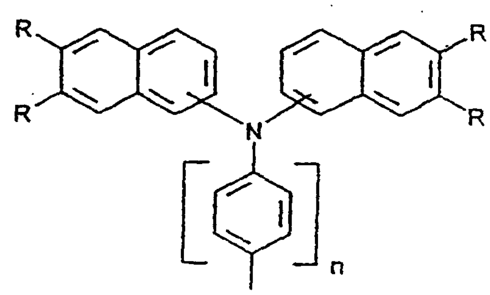

where the symbols and indices have the significance specified above.

IV.b. $K^1$ and $N^1$ and is selected from the group

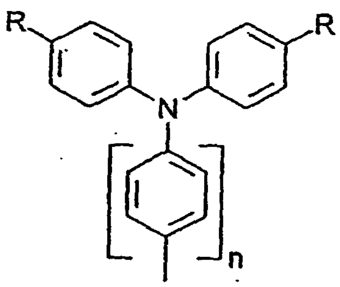

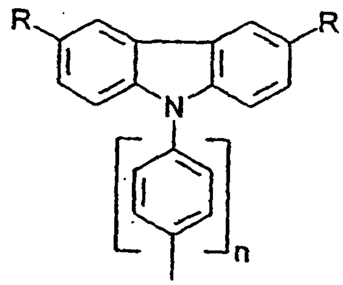

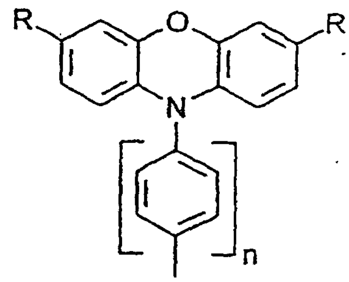

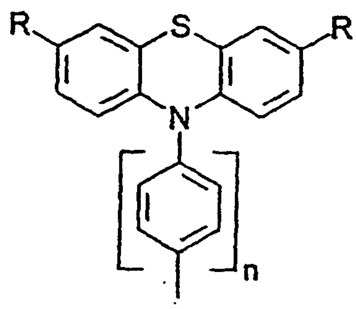

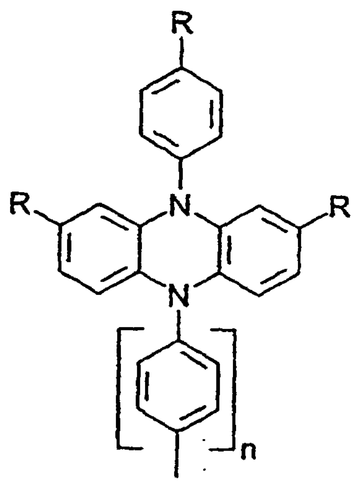

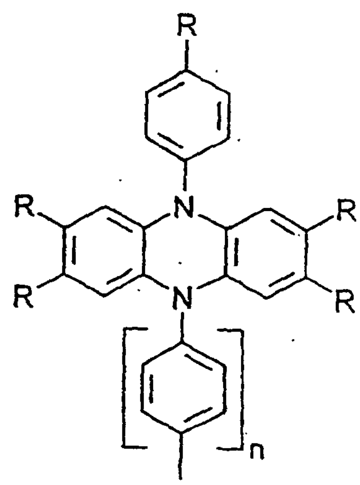

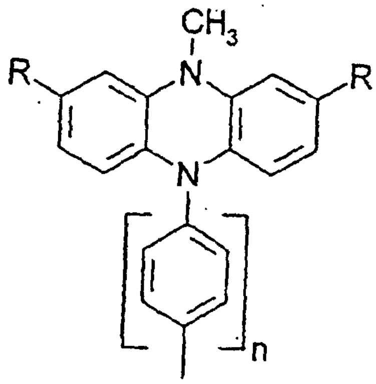

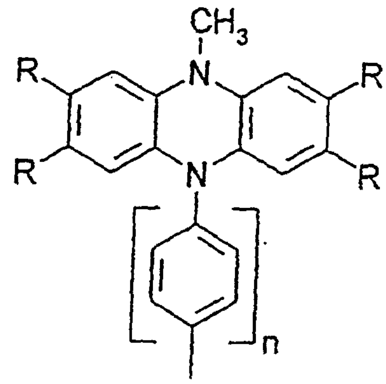

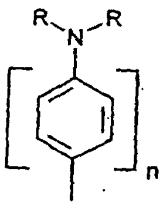

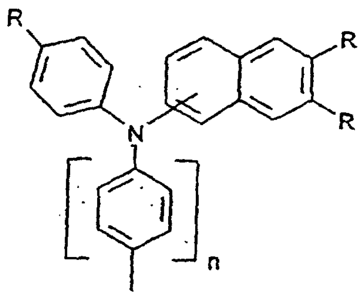

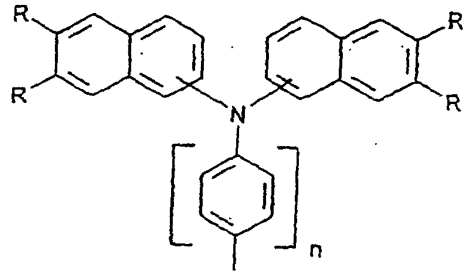

and L = M and is selected from the group
H, COOR, $CH_2OR$,

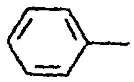

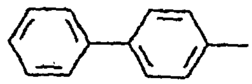

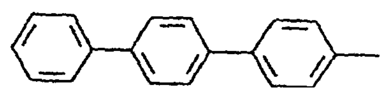

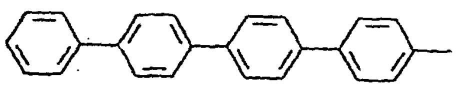

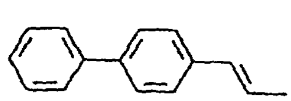

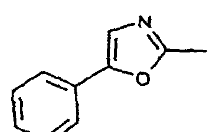

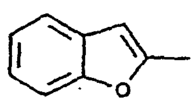

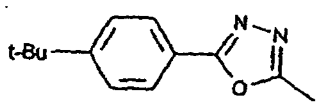

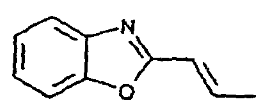

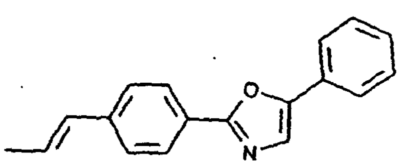

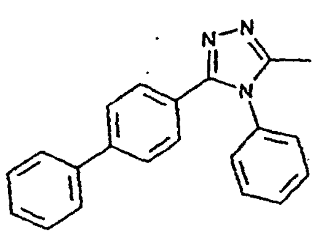

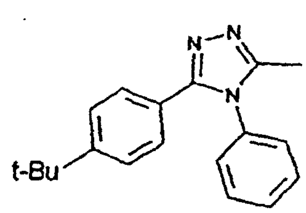

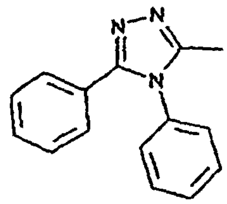

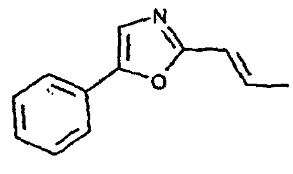

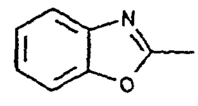

and Q, $P^1$ are the same or different and selected from the group

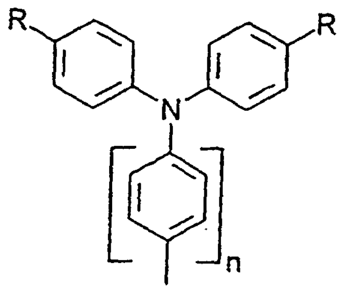

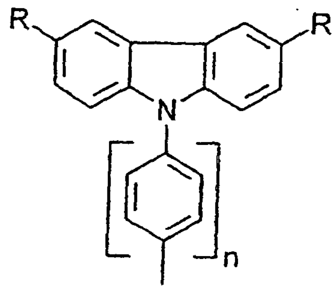

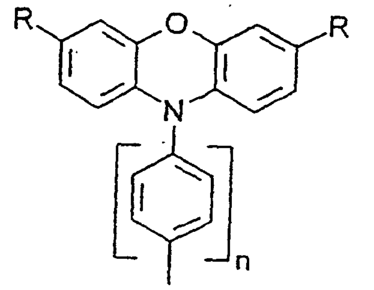

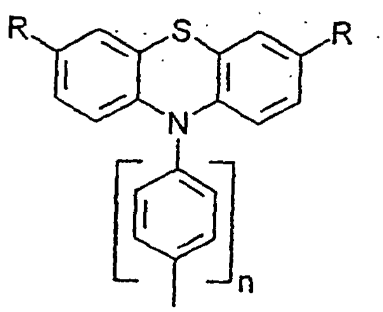

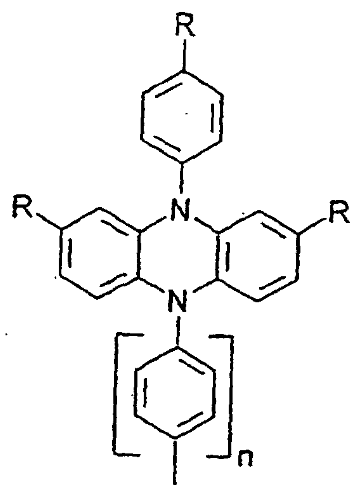

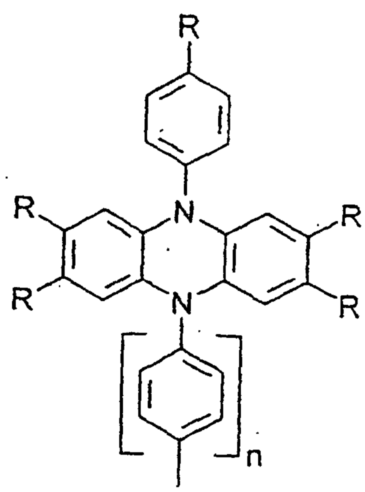

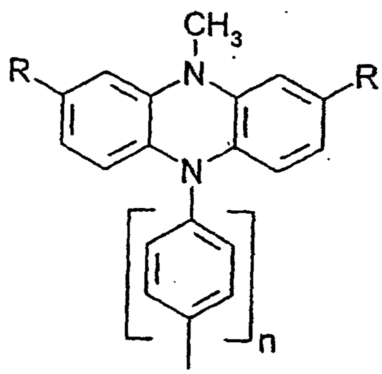

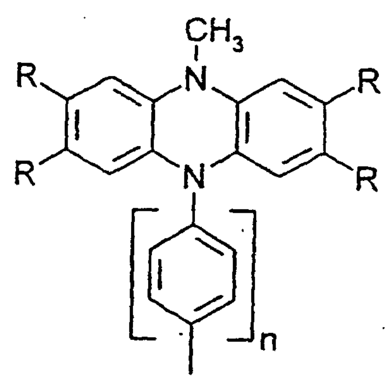

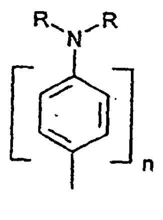
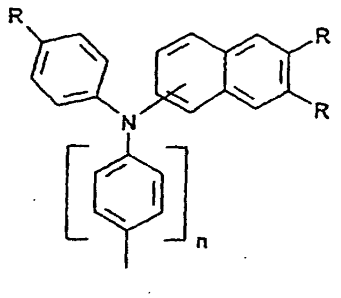
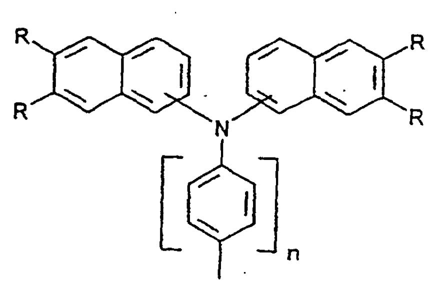

H, COOR $CH_2OR$,

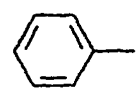
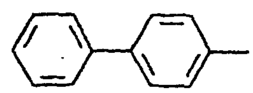
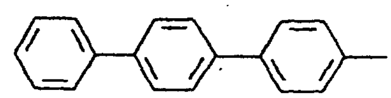

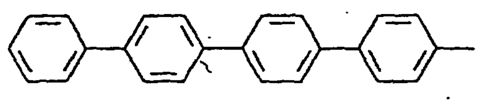
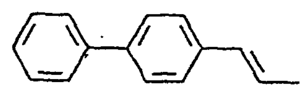
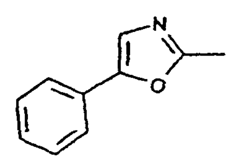

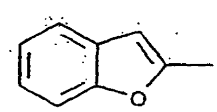
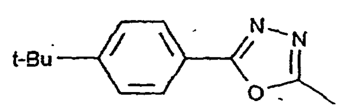
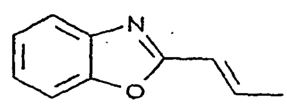

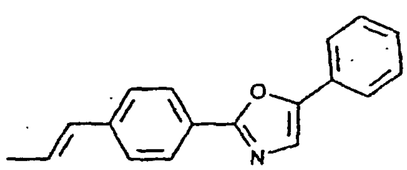
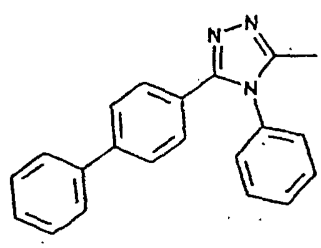
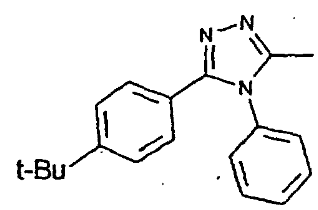

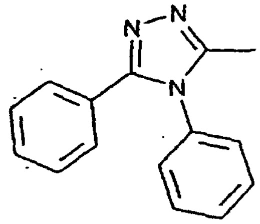
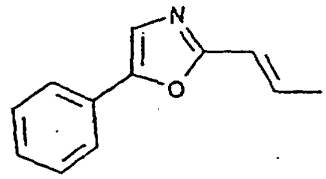
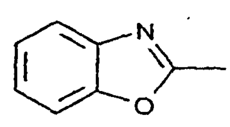

where the symbols and indices have the significance specified above.

IV.c. $K^1$ = M and is selected from the group

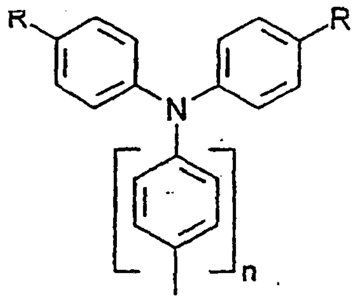
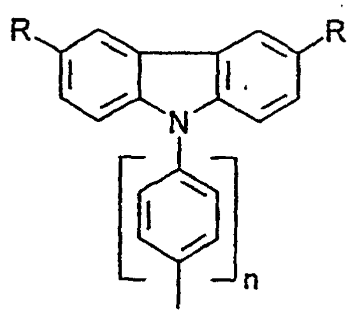
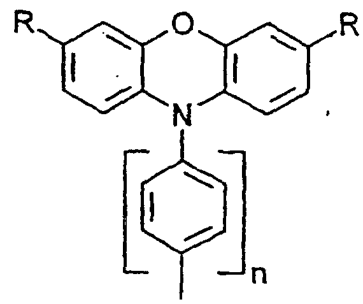
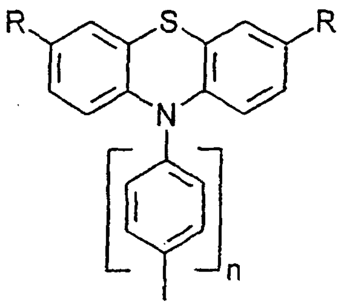
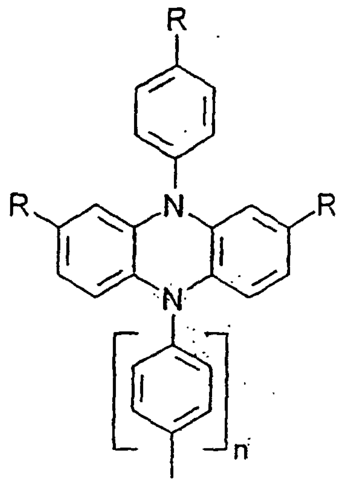
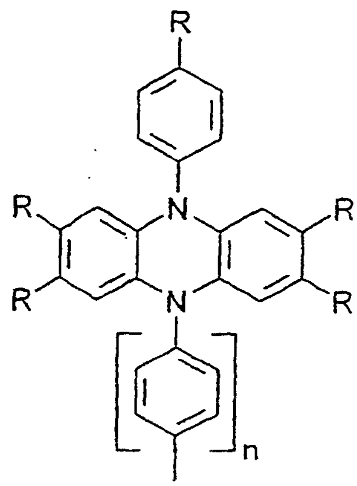
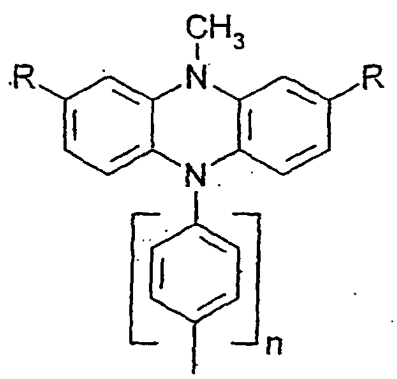
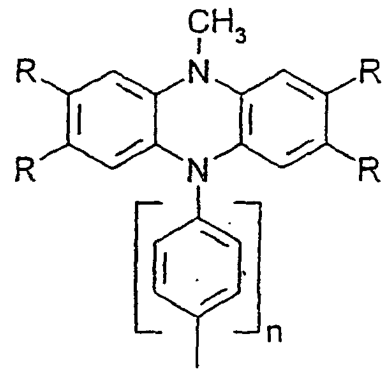

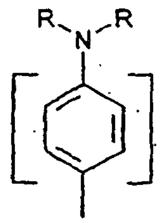 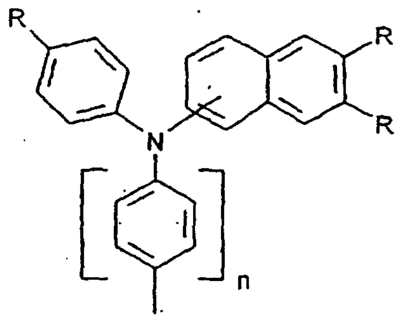 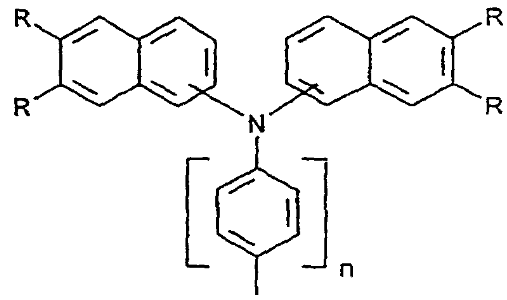

and M = $N^1$ and is selected from the group
H, COOR, $CH_2OR$,

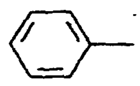 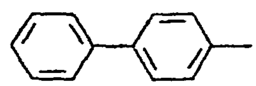 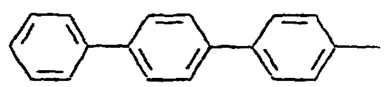

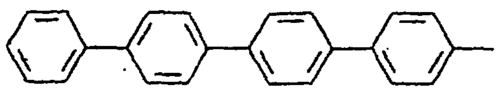 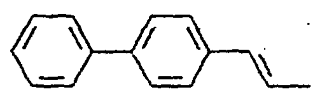 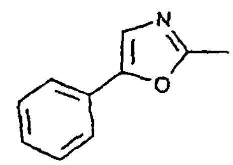

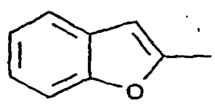 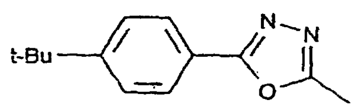 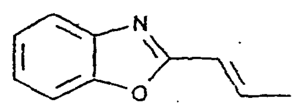

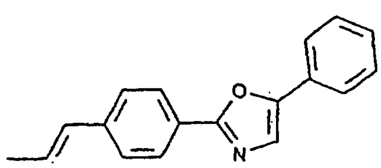 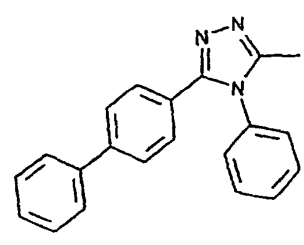 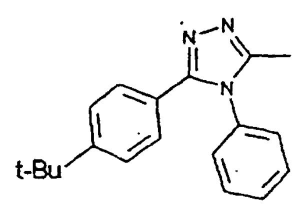

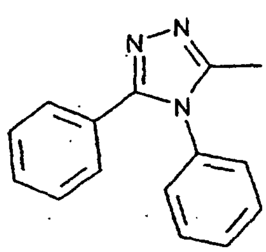 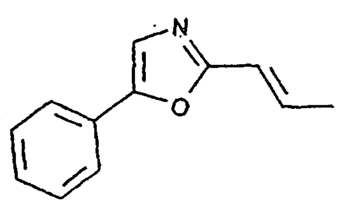 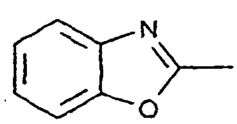

and Q $P^1$ are the same or different and selected from the group

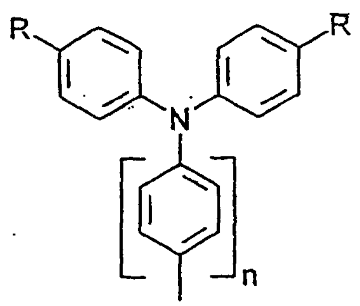
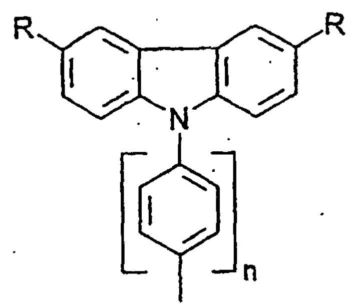
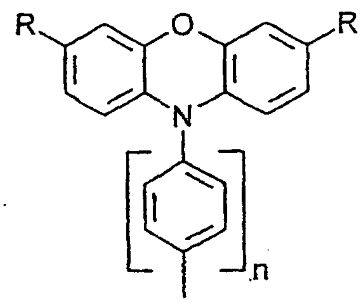

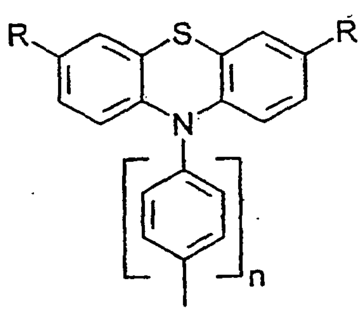
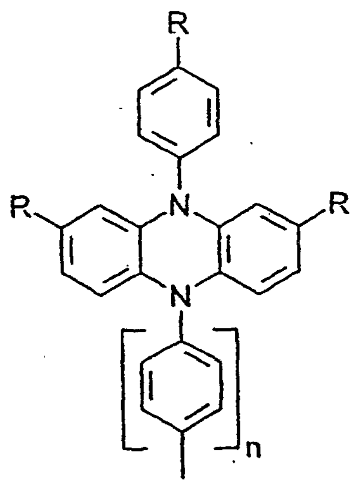
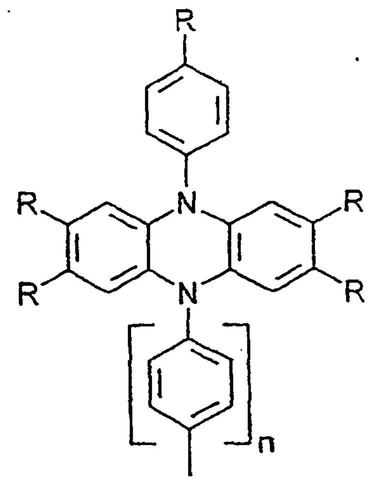

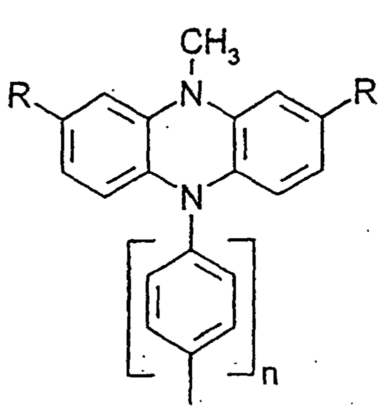
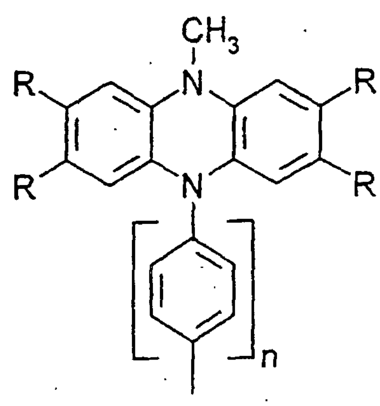

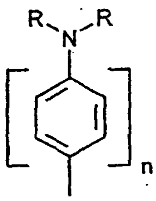 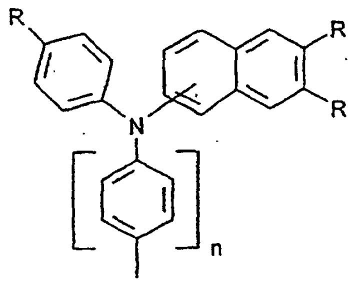 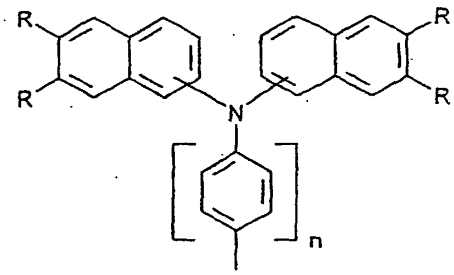

H, COOR, $CH_2OR$,

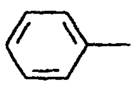 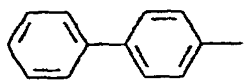 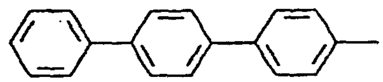

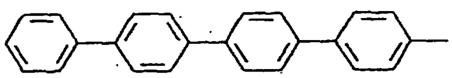 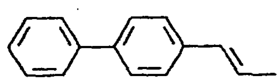 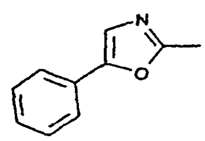

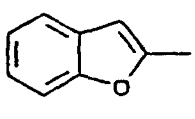 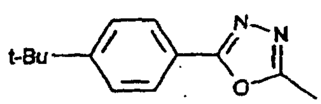 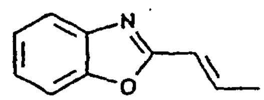

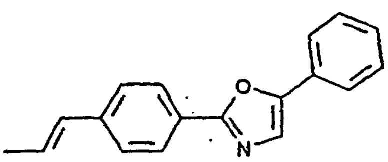 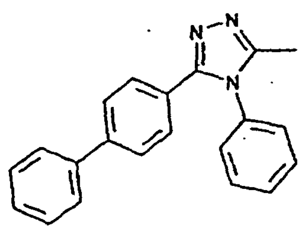 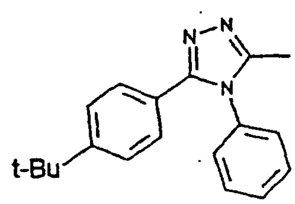

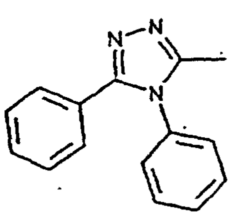 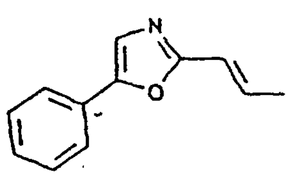 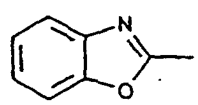

where the symbols and indices have the significance specified above.

**5.** Cell in accordance with claim 4, **characterised in that** the symbols in Formula (IV) have the following significance:

Ivaa) $K^1 = L = M = N^1$ and is selected from the following group

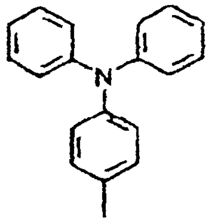 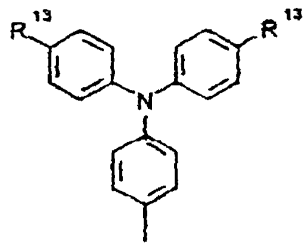 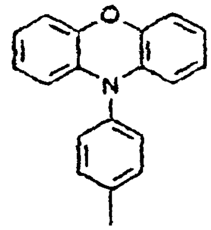 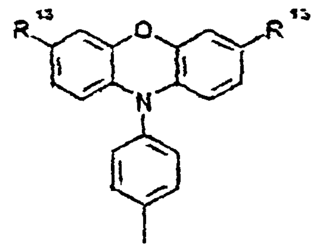

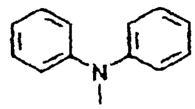 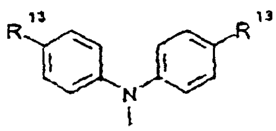 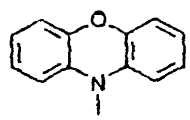 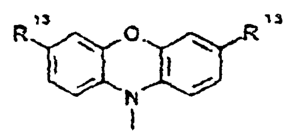

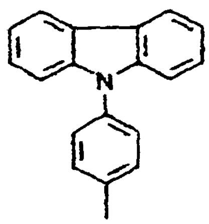 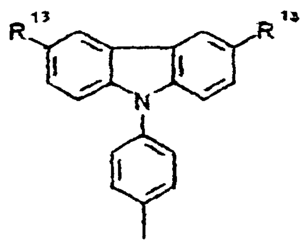 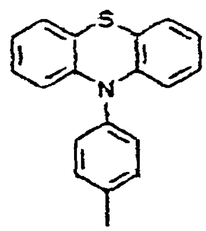 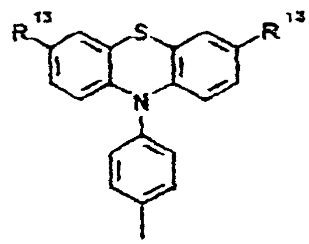

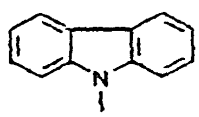 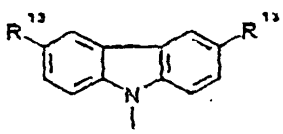 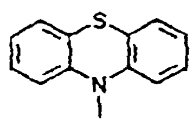 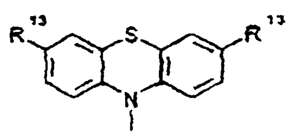

where $R^{13}$ stands for $-O-CH_3$ , $-O-C_2H_5$ , $-S-CH_3$ , $-S-C_2H_5$ , preferentially for $-O-CH_3$ , $-S-CH_3$ and with a special preference for $-O-CH_3$ ,
and $Q = P^1$ and is selected from the group
H, $COOR^{14}$, $CH_2\ OR^{14}$

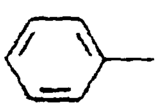 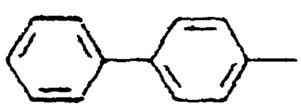 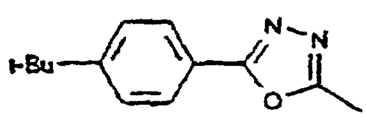

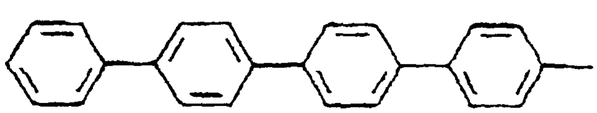 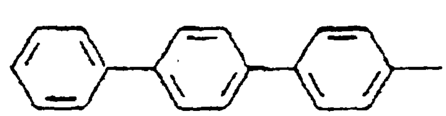

where $R^{14}$ is a straight-chain or branched alkyl group with 1 to 12 and, preferably, I to 4 C-atoms.

IV.ba) $K^1 = L = M = N^1 = Q = P^1$ and is selected from the group

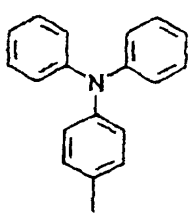
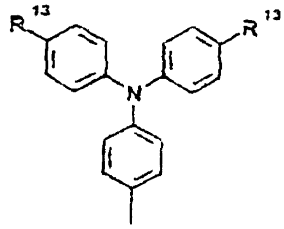
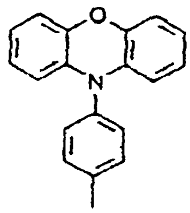
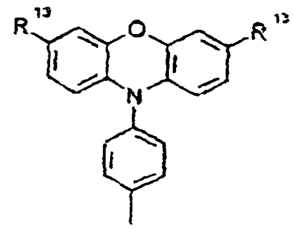

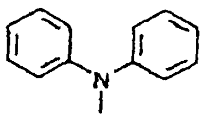
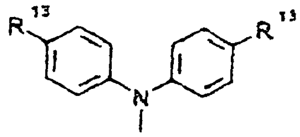
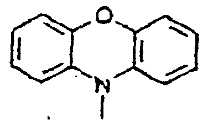
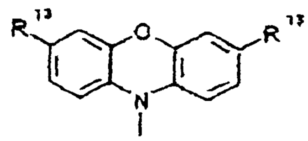

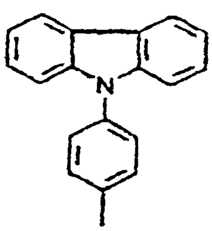
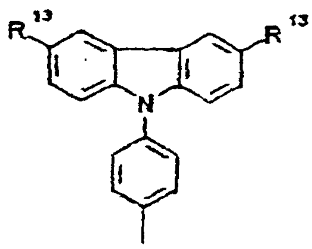
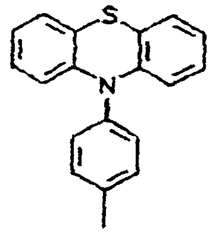
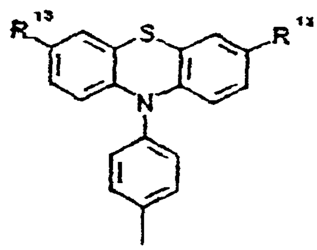

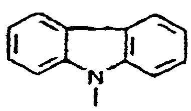
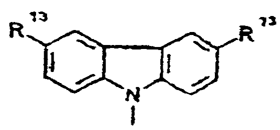
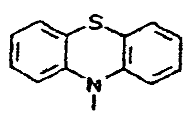
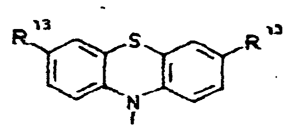

whereby $R^{13}$ has the significance specified above;

IV.ca $K^1 = L = M = N^1$ and is selected from the group

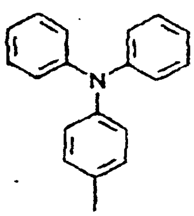
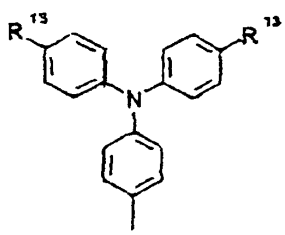
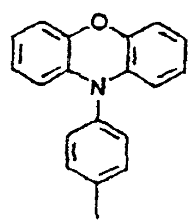
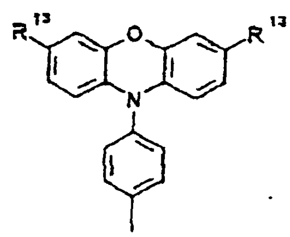

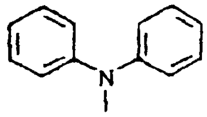
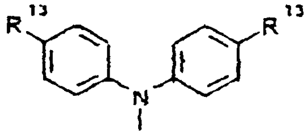
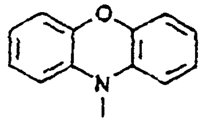
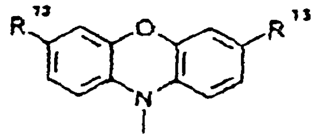

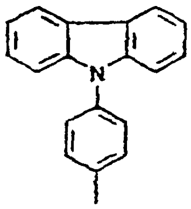
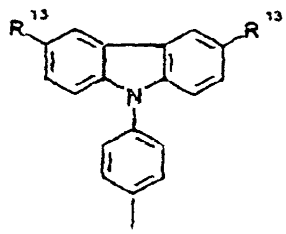
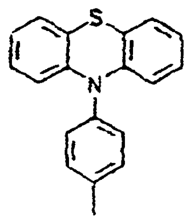
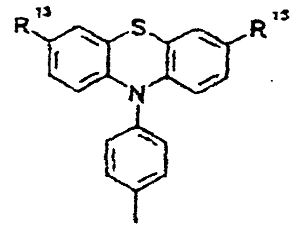

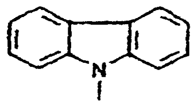
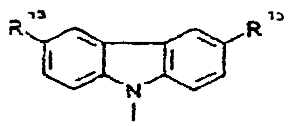
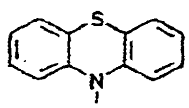
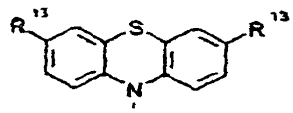

and Q = H and $P^1$ is selected from the group H, $COOR^{14}$, $CH_2OR^{14}$,

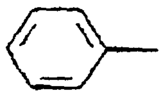
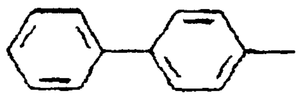
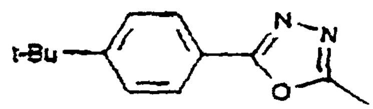

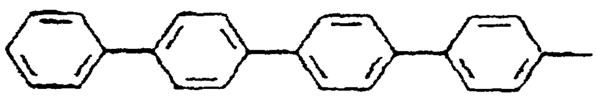
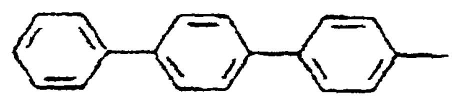

where $R^{13}$, $R^{14}$ have the significance specified above.

**6.** Cell in accordance with one or several of the claims 1 to 5, **characterised in that** the anodic limiting potential of the electrolyte liquid (14) is equal to or greater than 2.5 V.

**7.** Cell in accordance with claim 6, **characterised in that** the electrolyte liquid (14) contains a compound selected from the group of acetonitrile, ethylene carbonate, propylene carbonate, chlorobenzene and 3-methyl-2-oxazilidinone.

**8.** Cell in accordance with one or several of the foregoing claims 1 to 7, **characterised in that** the electrolyte (14) contains a conductive salt.

**9.** Cell in accordance with one or several of the foregoing claims 1 to 8 **characterised in that** it exhibits a light-absorbing layer (12) which contains a semi-conductive material with a band gap of at least 3 eV.

**10.** Photovoltaic cell in accordance with claim 9, **characterised in that** the semi-conductive material (12) is a metallic oxide.

**11.** Photovoltaic cell in accordance with claim 9 or 10 **characterised in that** the surface of the semi-conductor (12) has a roughness factor of> 20.

**12.** Photovoltaic cell in accordance with one or several of the foregoing claims 1 to 11, **characterised in that** it contains a light-absorbing layer with a dyestuff acting as a sensitising agent.

**13.** Use of a hole conductor compound having the formula (1) as a redox system in an electrolytic fluid (14)

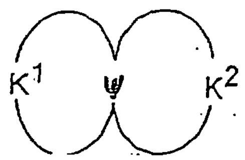

(I)

where

ψ is C, Si, Ge or Sn and
$K^1$ and $K^2$ independently of one another signify conjugated systems

## Revendications

1. Cellule photovoltaïque (10) **caractérisée par** un électrolyte (14), qui renferme un composé spiranique ou hétérospiranique conducteur de trous de formule (I)

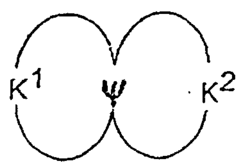

(I)

dissous,
où

Ψ représente C, Si, Ge ou Sn et
$K^1$ et $K^2$ indépendamment l'un de l'autre représentent des systèmes conjugués, en tant que système redox.

2. Cellule selon la revendication 1, **caractérisée en ce que** le composé spiranique ou hétérospiranique est un dérivé du spirofluorène de formule (II)

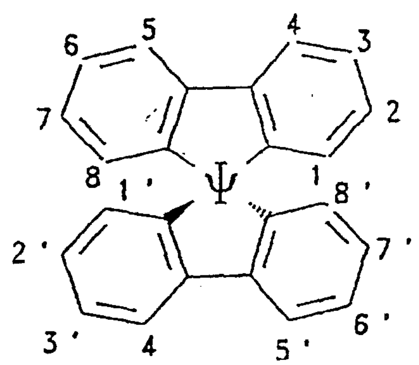

(II)

où Ψ représente C, Si, Ge ou Sn et les groupes benzoïques peuvent être, indépendamment l'un de l'autre, substitués et/ou condensés.

3. Cellule selon la revendication 2, **caractérisée en ce que** le dérivé du spirofluorène est un composé de formule (III)

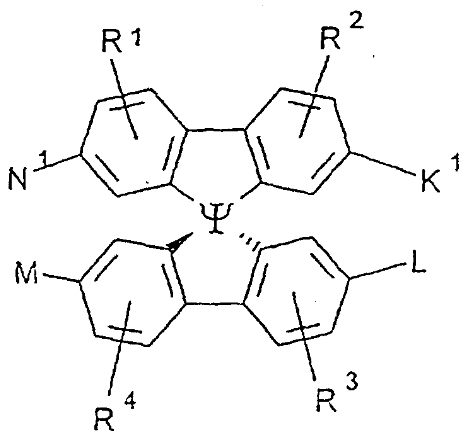

(III)

les symboles et les indices possèdent les significations suivantes :

| | |
|---|---|
| Ψ | représente C, Si, Ge ou Sn, |
| $K^1$, L, M, $N^1$, $R^1$, $R^2$, $R^3$, $R^4$ | sont identiques ou différents et représentent |

a) un atome d'hydrogène, un groupe $-NO_2$, -CN, -F ou - Cl,

b) un reste alkyle linéaire ou ramifié présentant 1 à 20 atomes de carbone,

b1) un ou plusieurs groupes $CH_2$ non adjacents pouvant être remplacés par des groupes -O-, -S-, -CO-O-, -O-CO-, -O-CO-O-, $NR^5$ ou - Si $(CH_3)_2$- et/ou

b2) un ou plusieurs groupes $CH_2$ pouvant être remplacés par des groupes -CH=CH-, -C≡C-, 1,4-phénylène, 1,4-cyclohexylène ou 1,3-cyclopentylène et/ou

b3) un ou plusieurs atomes d'hydrogène pouvant être remplacés par des atomes de F et/ou Cl, et/ou

c) un des groupes suivants :

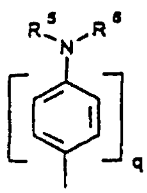
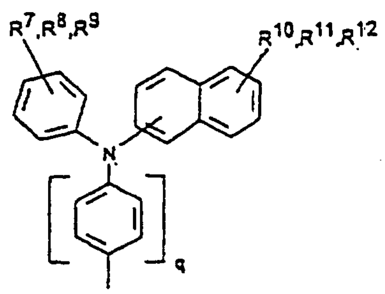
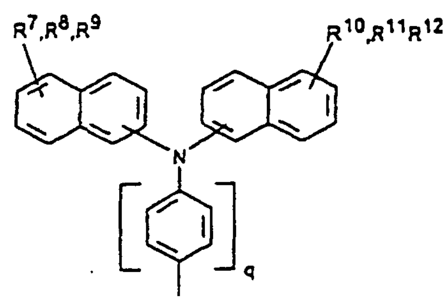

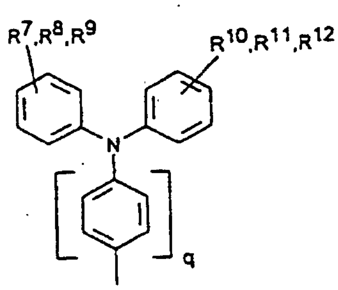
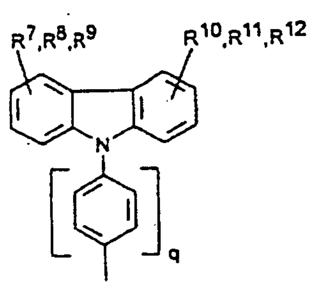
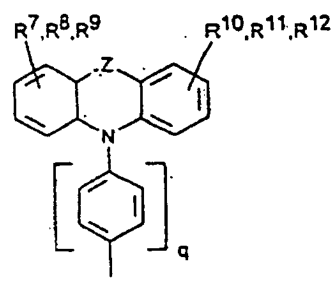

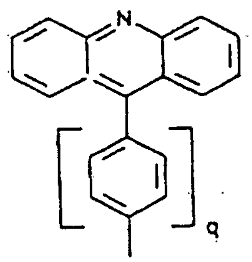

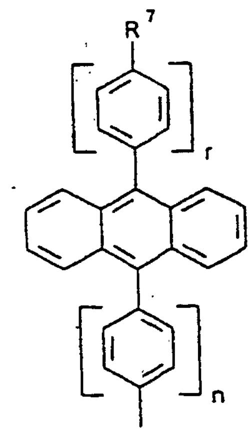

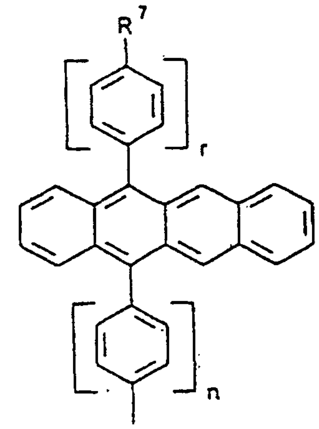

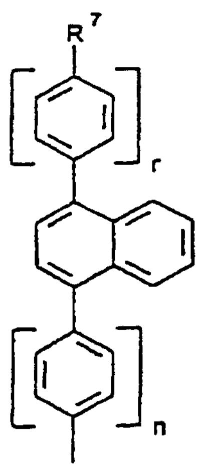

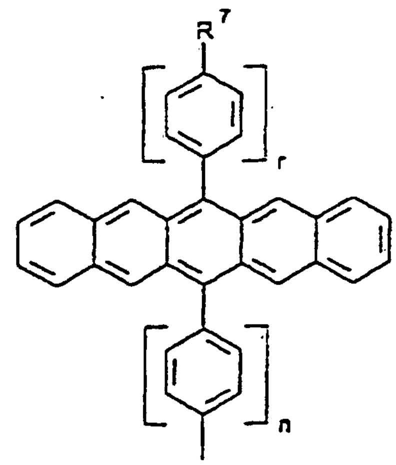

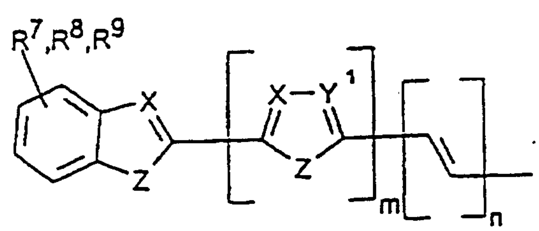

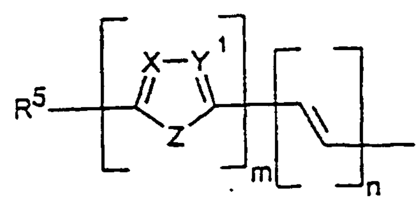

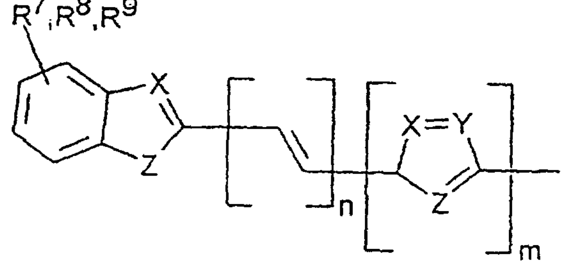

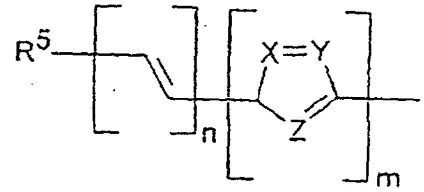

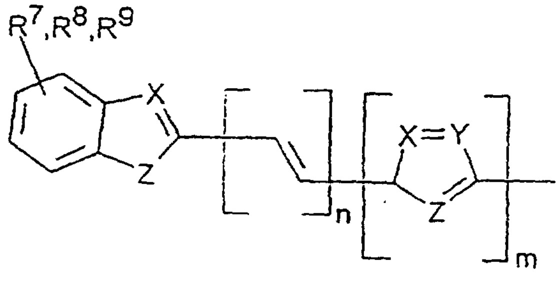

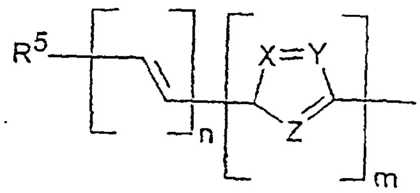

X, $Y^1$ identiques ou différents représentent chacun un groupe $=CR^7-$ ou =N- ;

Z représente un groupe -O-, -S-, $-NR^5-$, -CRR-, - CR=CR- ou -CR=N- ;

$R^5$, $R^6$ identiques ou différents représentent chacun

a) un atome d'hydrogène,

b) un reste alkyle linéaire ou ramifié présentant 1 à 20 atomes de carbone,

b1) un ou plusieurs groupes $CH_2$ non adjacents et non liés à l'atome d'azote pouvant être remplacés par des groupes -O-, -S-, -CO-O-, - O-CO-, -O-CO-O- ou $-Si(CH_3)_2-$ et/ou

b2) un ou plusieurs groupes $CH_2$ pouvant être remplacés par des groupes -CH=CH-, -C≡C-, cyclopropane-1,2-diyle, 1,4-phénylène, 1,4-cyclohexylène ou 1,3-cyclopentylène, et/ou

b3) un ou plusieurs atomes d'hydrogène pouvant être remplacés par des atomes de F et/ou Cl, et/ou

b4) $R^5$ et $R^6$ conjointement peuvent aussi former un cycle ;

c) représente un groupe phényle, biphényle, 1-naphtyle, 2-naphtyle, 2-thiényle, 2-furanyle ;

$R^7$, $R^8$, $R^9$, $R^{10}$, $R^{11}$, $R^{12}$ sont identiques ou différents et représentent

a) un atome d'hydrogène, un groupe -CN, -F, $NO_2$ ou -Cl,

b) un reste alkyle linéaire ou ramifié présentant 1 à 20 atomes de carbone,

b1) un ou plusieurs groupes $CH_2$ non adjacents pouvant être remplacés par des groupes -O-, -S-, -CO-O-, -O-CO-, -O-CO-O-, $-NR^5$ ou $-Si(CH_3)_2-$ et/ou

b2) un ou plusieurs groupes $CH_2$ pouvant être remplacés par des groupes -CH=CH-, -C≡C-, cyclopropane-1,2-diyle, 1,4-phénylène, 1,4-cyclohexylène ou 1,3-cyclopentylène et/ou

b3) un ou plusieurs atomes d'hydrogène pouvant être remplacés par des atomes de F et/ou Cl ;

c) représente un groupe phényle, biphényle, 1-naphtyle, 2-naphtyle, 2-thiényle, 2-furanyle, O-phényle, -O-biphényle, -O-1-naphtyle, -O-2-naphtyle, -O-2-thiényle, -O-2-furanyle,

m, n, p, q, r sont chaque fois identiques ou différents et valent 0, 1, 2, 3, 4, 5 ou 6.

**4.** Cellule selon la revendication 3, **caractérisée en ce que** le dérivé du 9,9'-spirobifluorène est un composé de formule (IV)

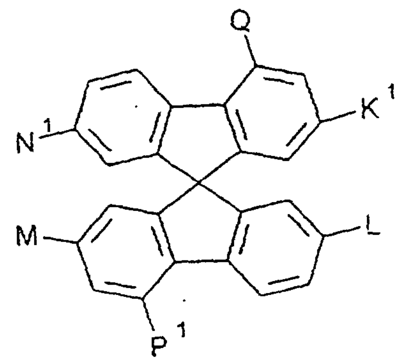

(IV)

dans laquelle les symboles possèdent les significations suivantes :

IVa) $K^1 = L = M = N^1 =$

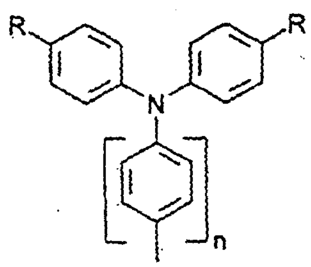

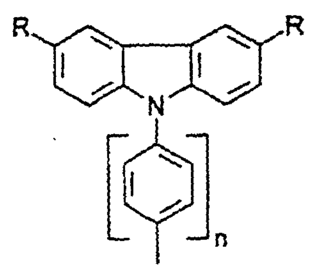

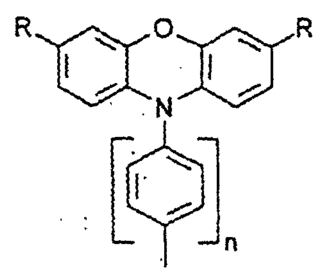

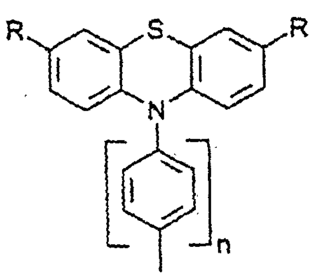

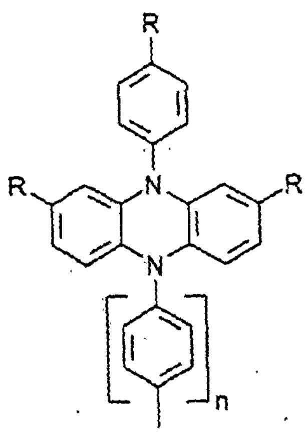

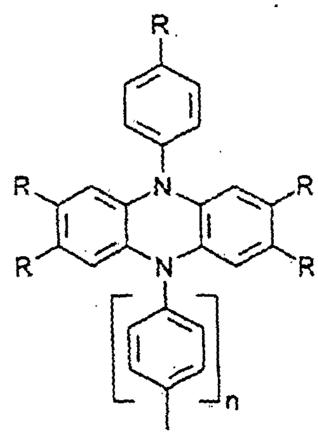

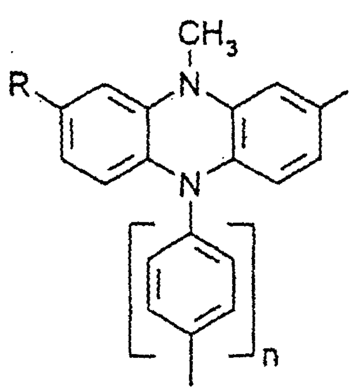

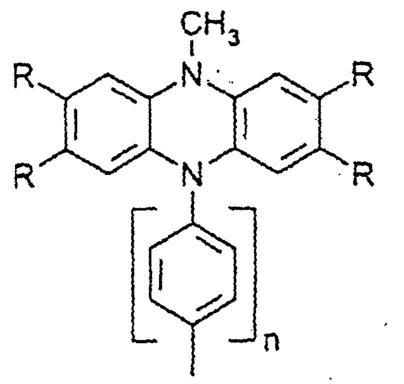

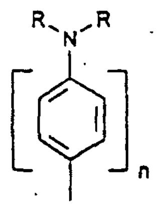

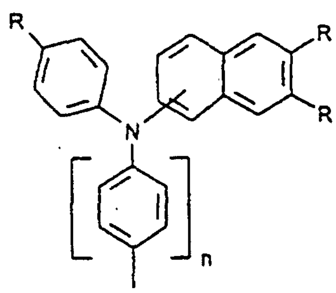

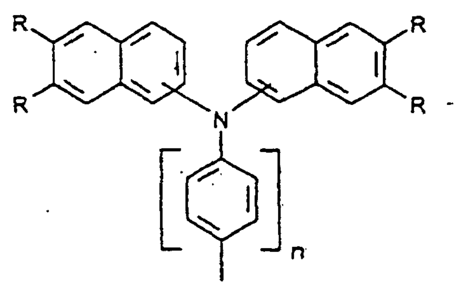

R identiques ou différents représentent un atome d'hydrogène, un groupe alkyle, -O-alkyle, -S-alkyle, chacun présentant 1 à 20 atomes de carbone, phényle, biphényle, 1-naphtyle, 2-naphtyle, 2-thiényle, 2-furanyle, -O-phényle, -O-biphényle, -O-1-naphtyle, -O-2-naphtyle, -O-2-thiényle, -O-2-furanyle, dans ce contexte -O-alkyle/aryle, -S-alkyle/aryle, CN, $NR_2$ ne peuvent pas être liés à l'atome d'azote ;

n = 0, 1, 2, 3, 4 ;

et Q, $P^1$ sont identiques ou différents et sont pris dans le qroupe
H, COOR, $CH_2OR$

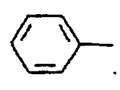

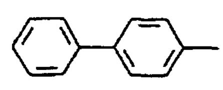

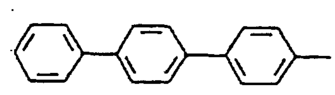

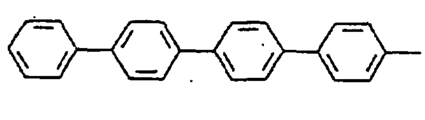

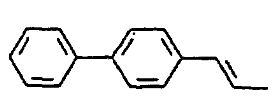

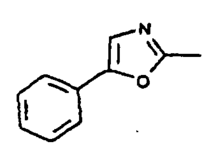

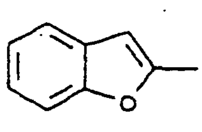

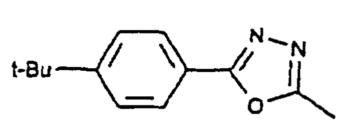

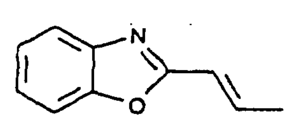

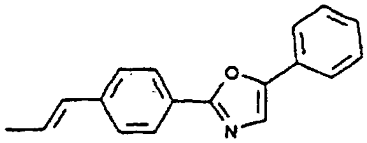

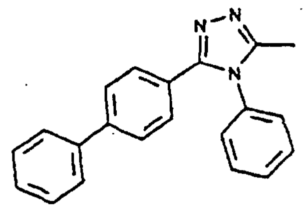

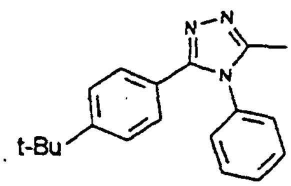

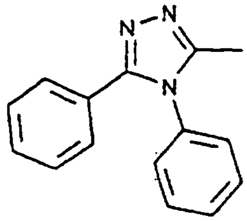

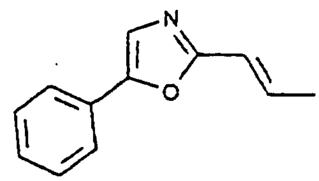

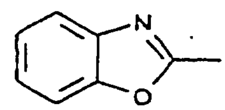

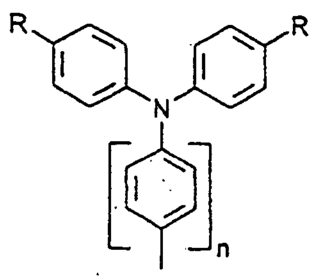

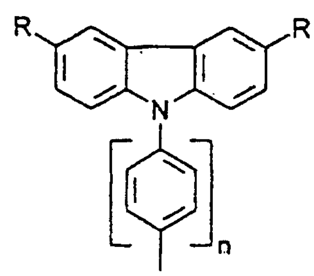

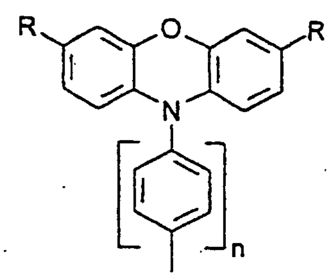

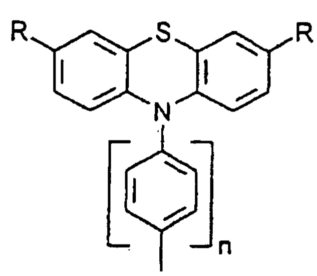

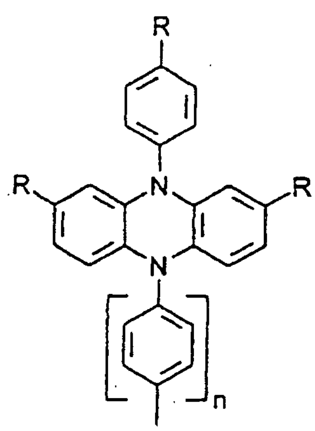

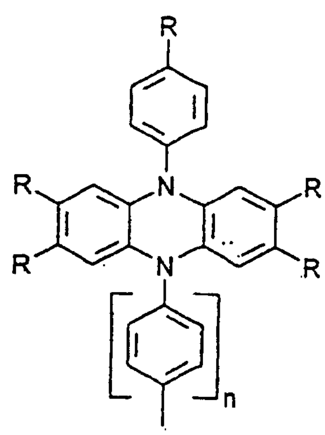

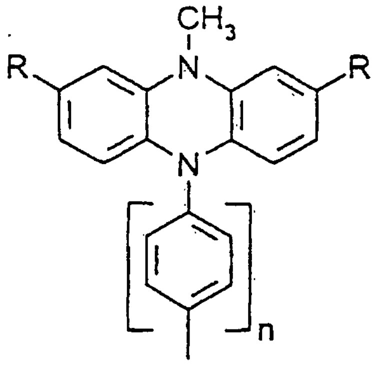

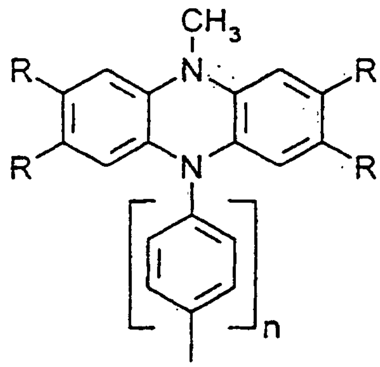

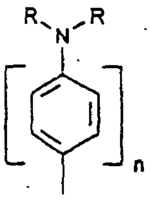

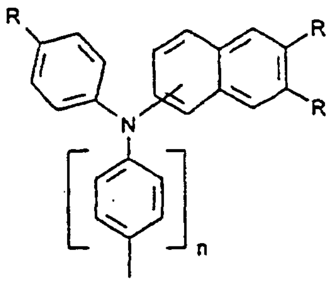

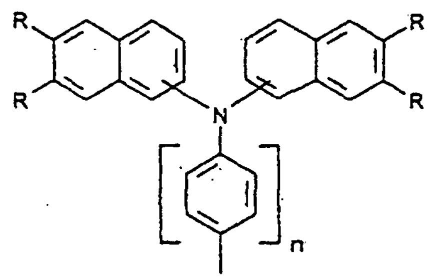

les symboles et les indices possèdent les significations données ci-dessus ;
IVb) $K^1 = N^1$ et est pris dans le groupe

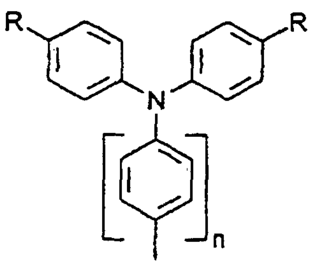

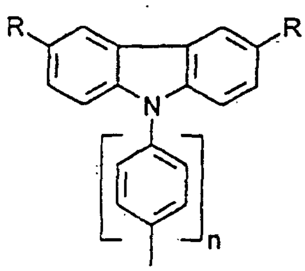

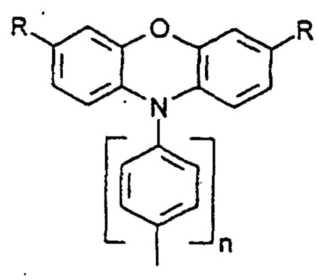

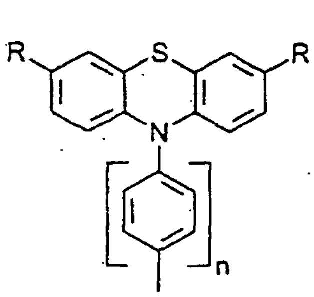

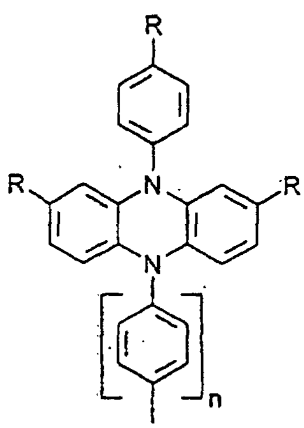

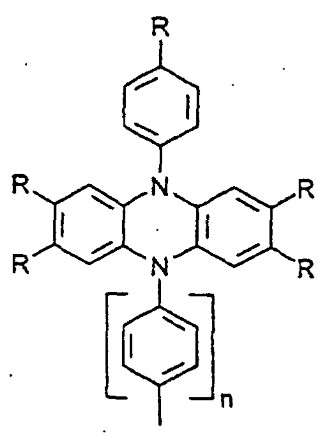

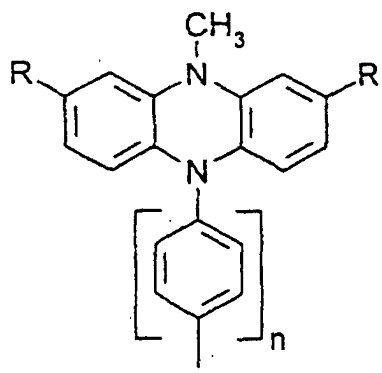

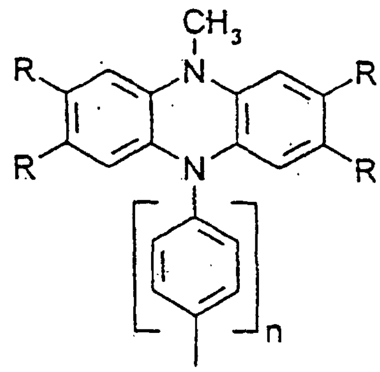

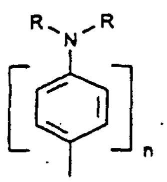

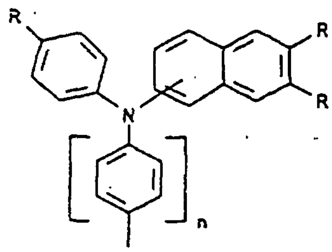

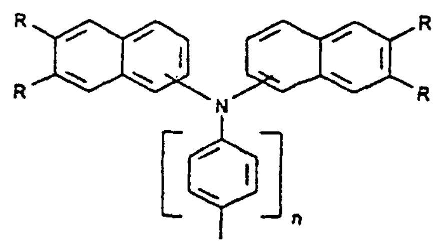

et L = M et est pris dans le groupe
H, COOR, $CH_2OR$,

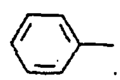

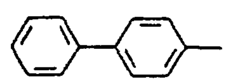

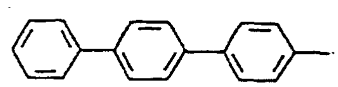

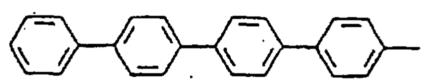

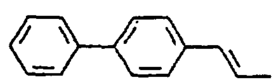

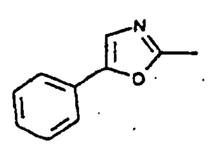

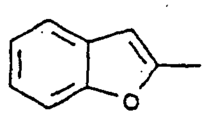

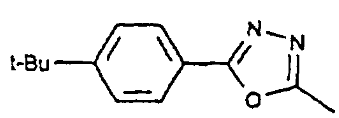

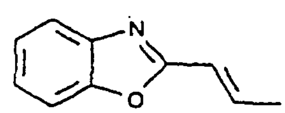

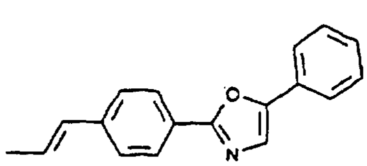

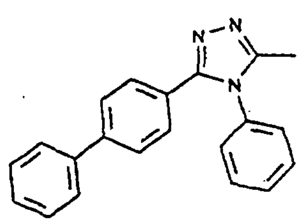

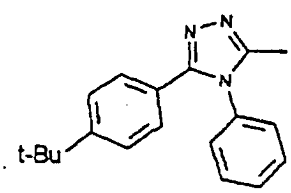

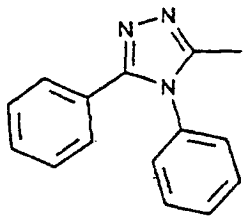
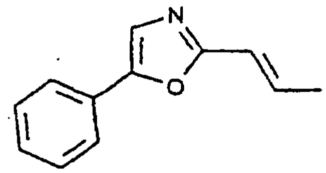
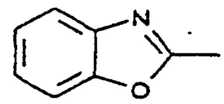

et Q, $P^1$ sont identiques ou différents pris dans le groupe

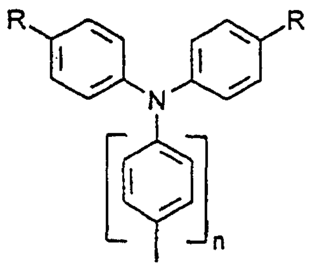
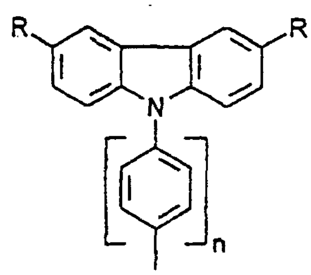
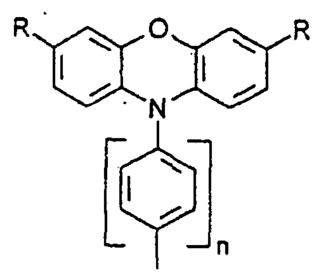

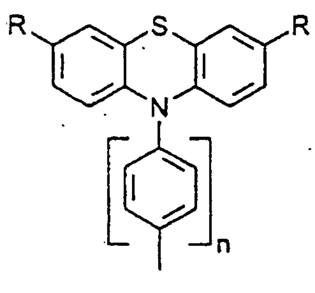
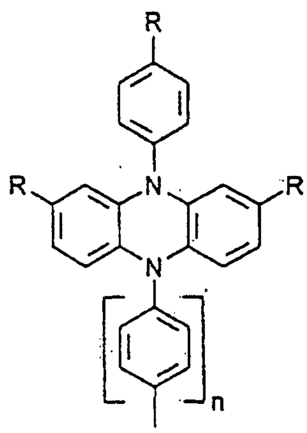
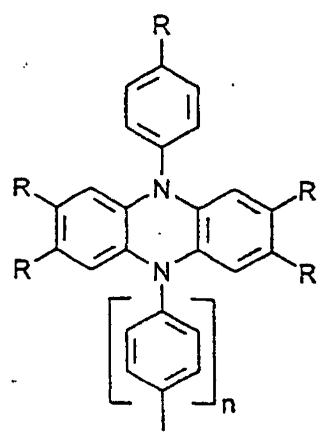

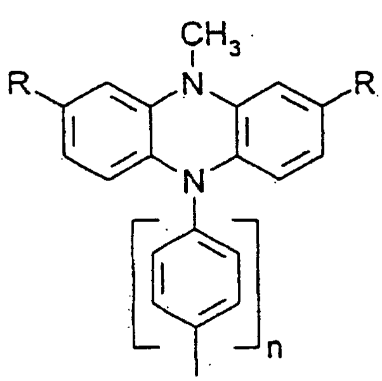
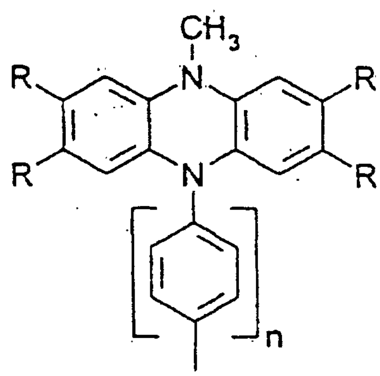

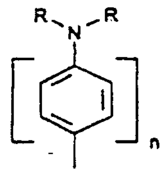 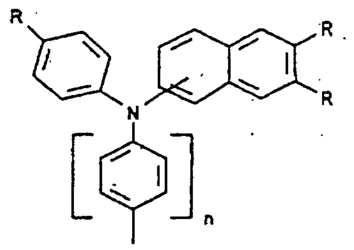 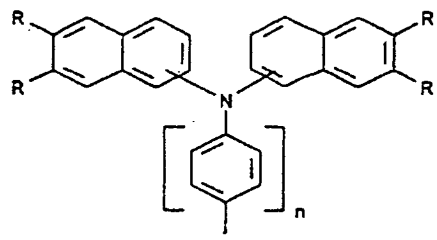

H, COOR, $CH_2OR$,

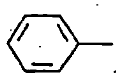 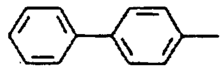 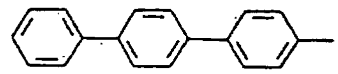

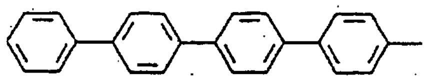 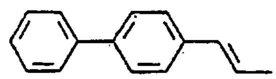 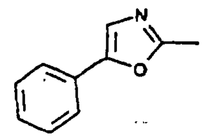

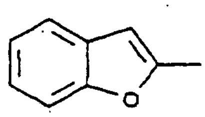 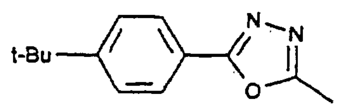 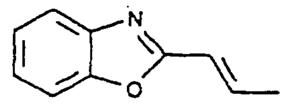

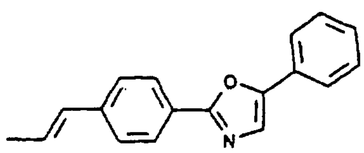 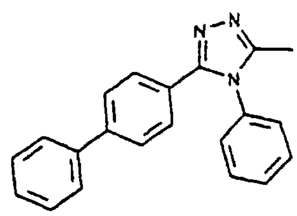 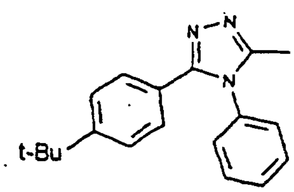

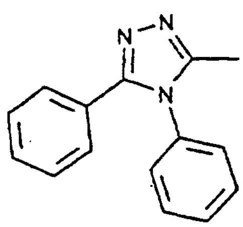 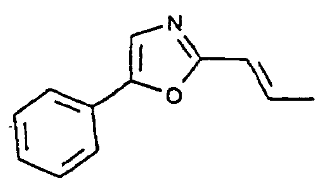 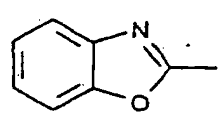

les symboles et les indices possèdent les significations données ci-dessus ;
IVc) $K^1$ = M et est pris dans le groupe

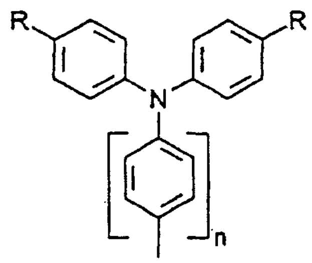
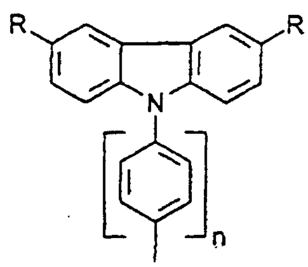
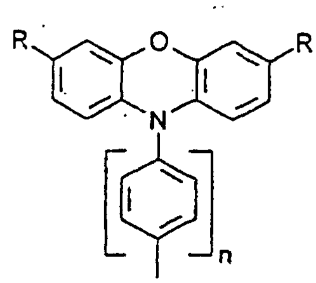

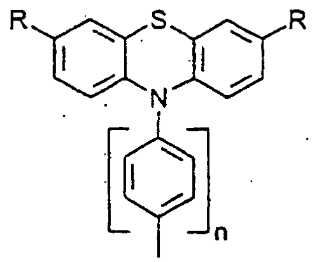
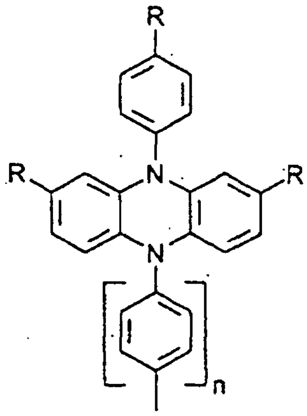
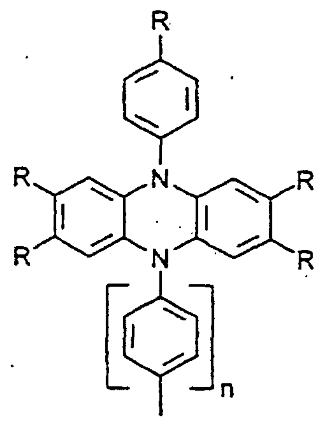

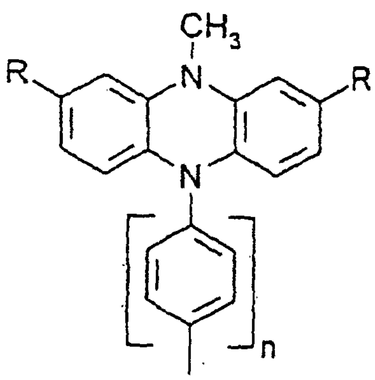
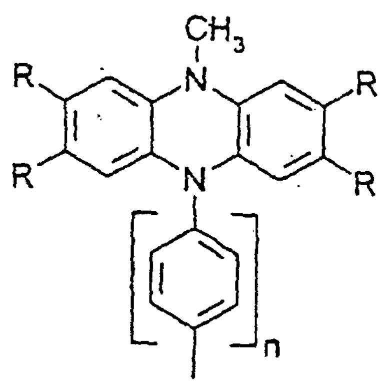

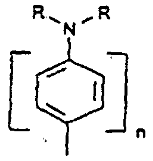
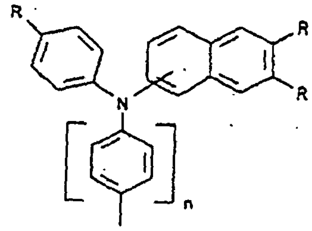
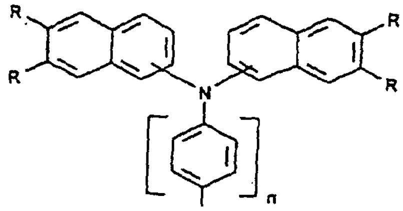

et

M = $N^1$ et est pris dans le groupe

H, COOR, $CH_2OR$,

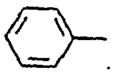
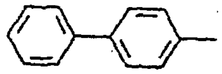
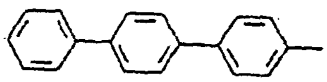

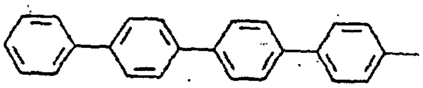
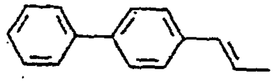
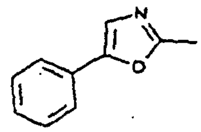

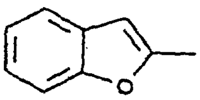
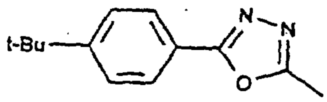
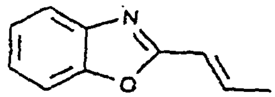

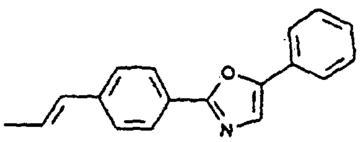
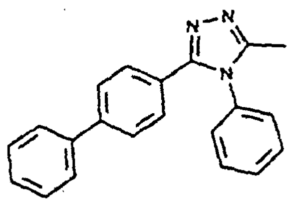
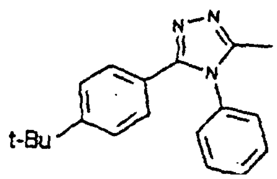

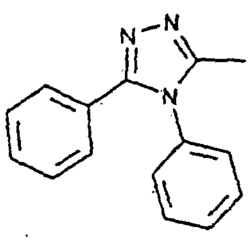
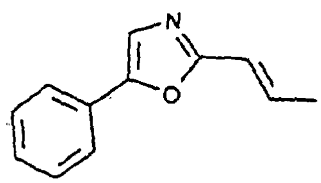
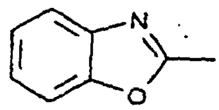

et Q, $P^1$ sont identiques ou différents pris dans le groupe

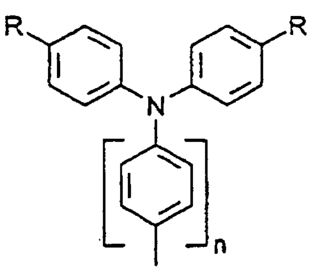
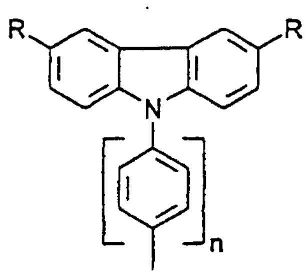
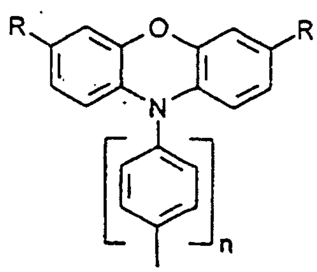

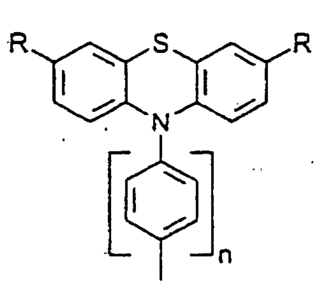
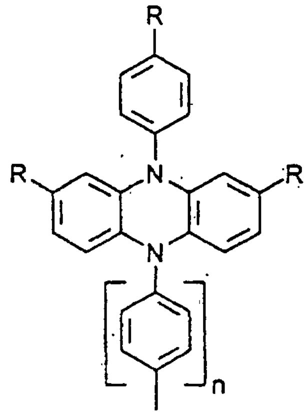
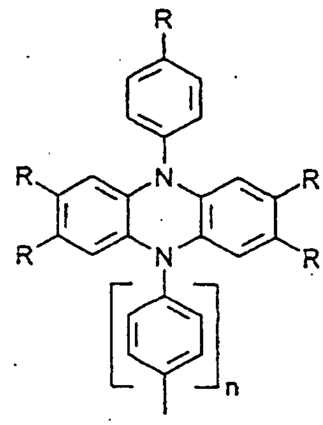

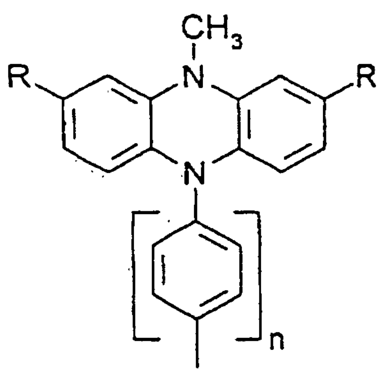
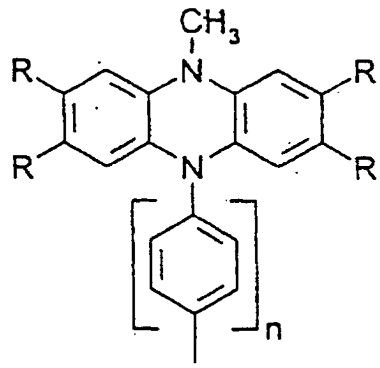

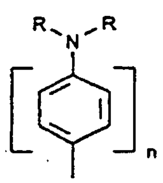
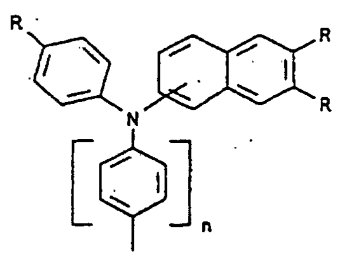
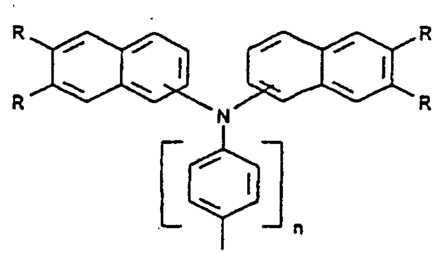

H, $COOR$, $CH_2OR$,

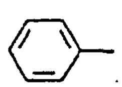
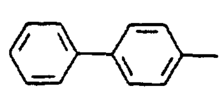
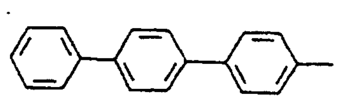

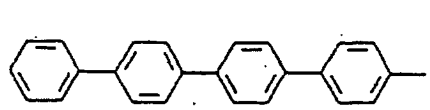
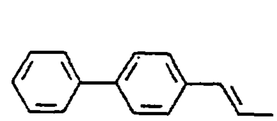
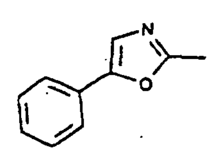

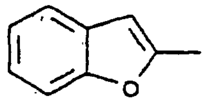
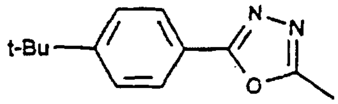
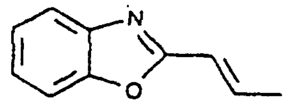

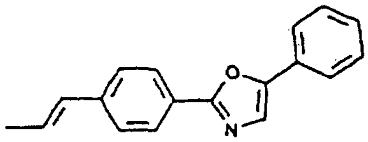
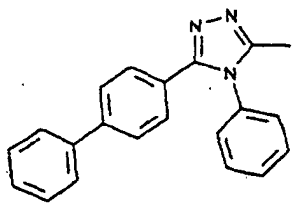
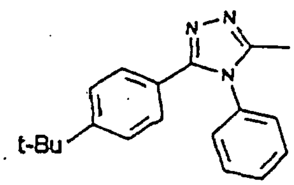

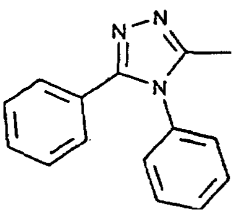
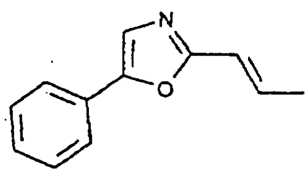
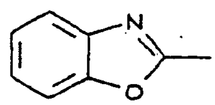

les symboles et les indices possèdent les significations données ci-dessus.

**5.** Cellule selon la revendication 4, **caractérisée en ce que** les symboles dans la formule (IV) possèdent les significations suivantes :

IVaa) $K^1 = L = M = N^1$ et est pris dans le groupe :

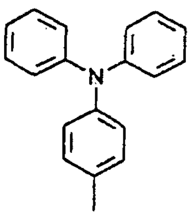
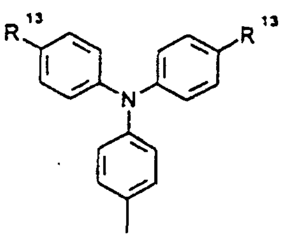
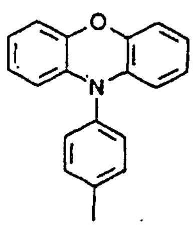
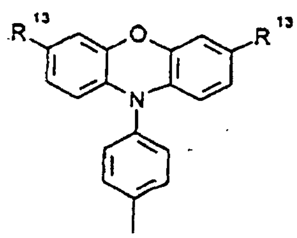

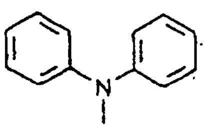
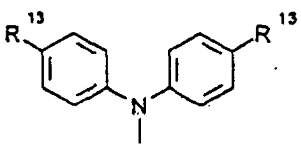
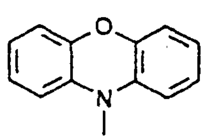
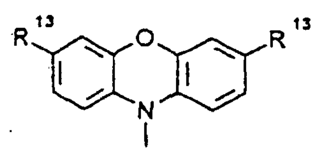

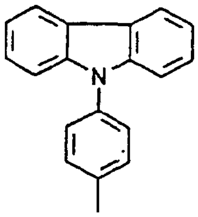
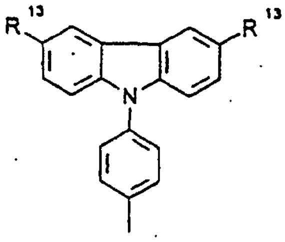
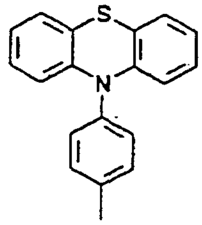
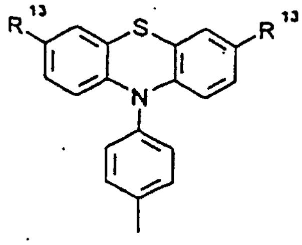

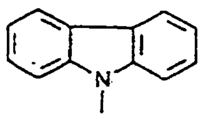 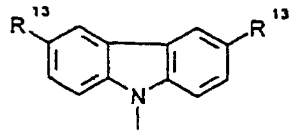 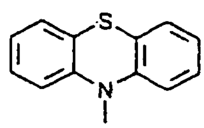 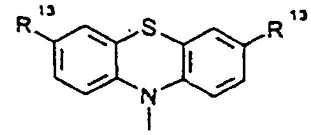

$R^{13}$ représente un groupe $-O-CH_3$, $-O-C_2H_5$, $-S-CH_3$, $-S-C_2H_5$, de préférence $-O-CH_3$, $-S-CH_3$, de manière particulièrement préférée $-O-CH_3$ ;
et Q = $P^1$ et est pris dans le groupe
H, $COOR^{14}$, $CH_2OR^{14}$,

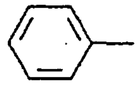 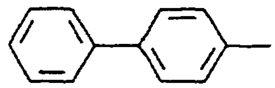 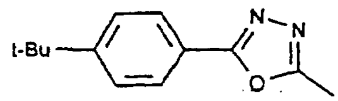

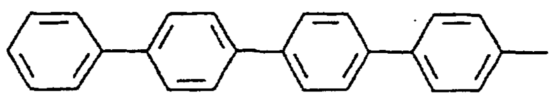 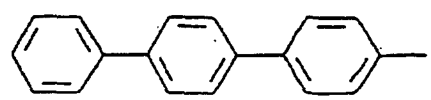

$R^{14}$ représente un groupe alkyle linéaire ou ramifié présentant 1 à 12 atomes de carbone, de préférence 1 à 4 atomes de carbone ;
IVba) $K^1 = L = M = N^1 = Q = P^1$ et est pris dans le groupe

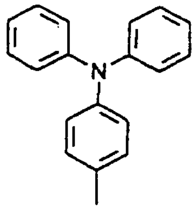 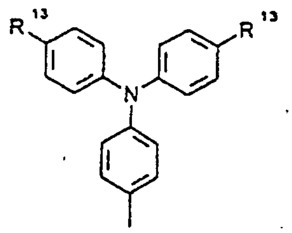 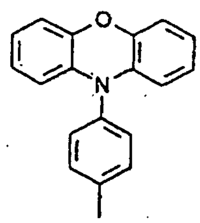 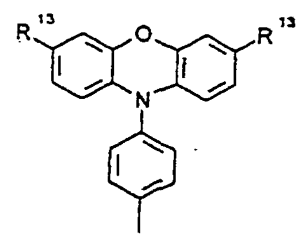

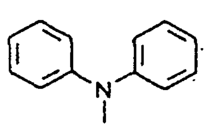 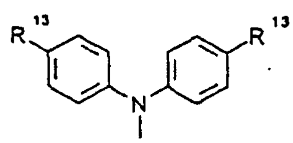 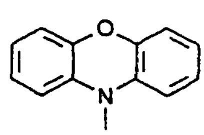 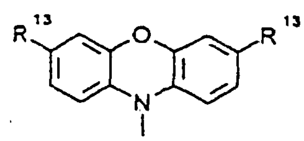

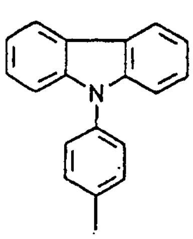 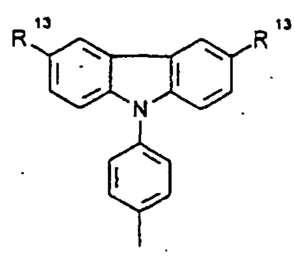 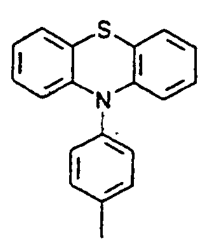 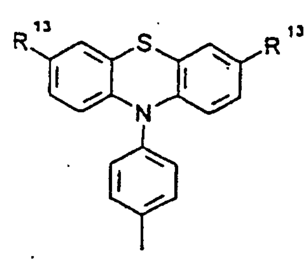

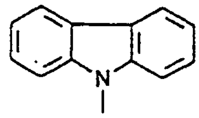 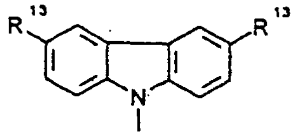 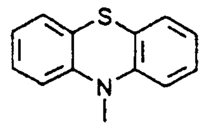 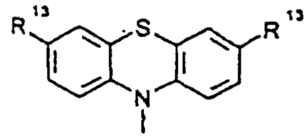

$R^{13}$ possède les significations données ci-dessus ;
IVca) $K^1 = L = M = N^1$ et est pris dans le groupe

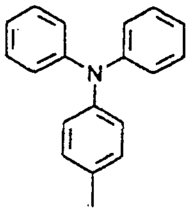 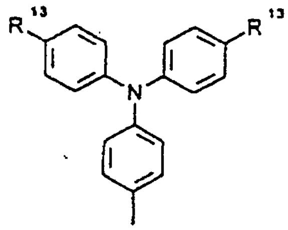 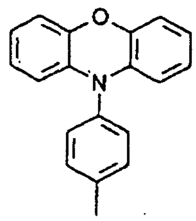 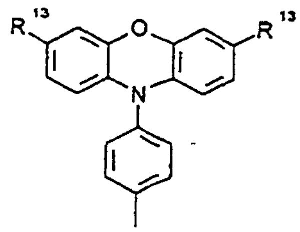

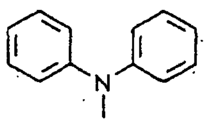 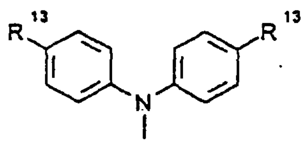 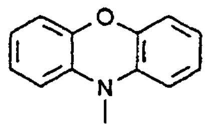 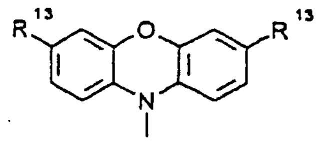

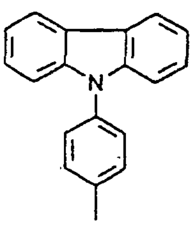 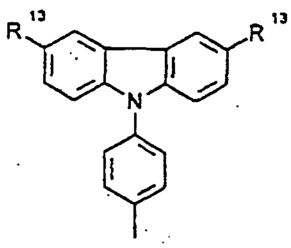 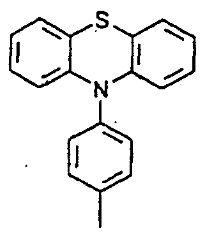 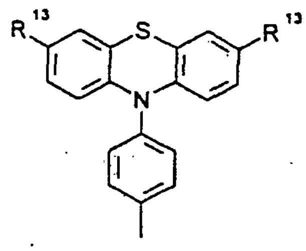

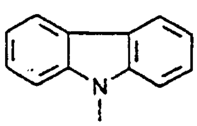 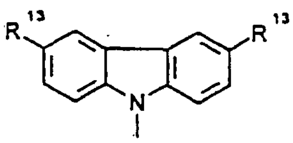 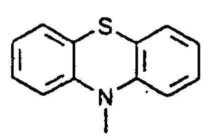 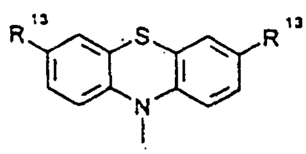

et Q = H et $P^1$ est pris dans le groupe H, $COOR^{14}$, $CH_2OR^{14}$,

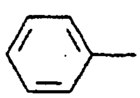 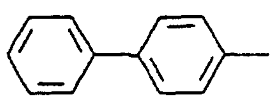 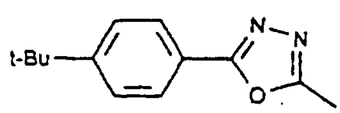

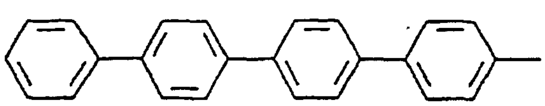 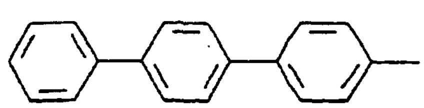

$R^{13}$, $R^{14}$ possèdent les significations données ci-dessus.

**6.** Cellule selon une ou plusieurs des revendications 1 à 5, **caractérisée en ce que** le potentiel de blocage de l'électrolyte liquide (14) est égal ou supérieur à 2,5 volts.

**7.** Cellule selon la revendication 6, **caractérisée en ce que** l'électrolyte liquide (14) renferme un composé pris dans le groupe comprenant l'acétonitrile, le glutarodinitrile, le carbonate d'éthylène, le carbonate de propylène, le chlorobenzène et la 3-méthyl-2-oxazolidinone.

**8.** Cellule selon une ou plusieurs des revendications précédentes 1 à 7, **caractérisée en ce que** l'électrolyte (14) renferme un sel conducteur.

**9.** Cellule selon une ou plusieurs des revendications précédentes 1 à 8, **caractérisée en ce qu'**elle présente une couche photoabsorbante (12) qui renferme une matière semi-conductrice avec une bande interdite d'au moins 3 eV.

**10.** Cellule photovoltaïque selon la revendication 9, **caractérisée en ce que** la matière semi-conductrice (12) est un oxyde métallique.

**11.** Cellule photovoltaïque selon la revendication 9 ou 10, **caractérisée en ce que** la surface semi-conductrice (12) présente un facteur de rugosité >20.

**12.** Cellule photovoltaïque selon une ou plusieurs des revendications précédentes 1 à 11, **caractérisée en ce qu'**elle renferme une couche photoabsorbante avec un colorant comme sensibilisant.

**13.** Utilisation d'un composé conducteur de trous de formule (I)

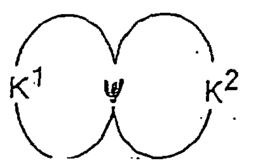

(I)

en tant que système redox dans un électrolyte liquide (14), où

Ψ représente C, Si, Ge ou Sn et
$K^1$ et $K^2$ indépendamment l'un de l'autre représentent des systèmes conjugués.

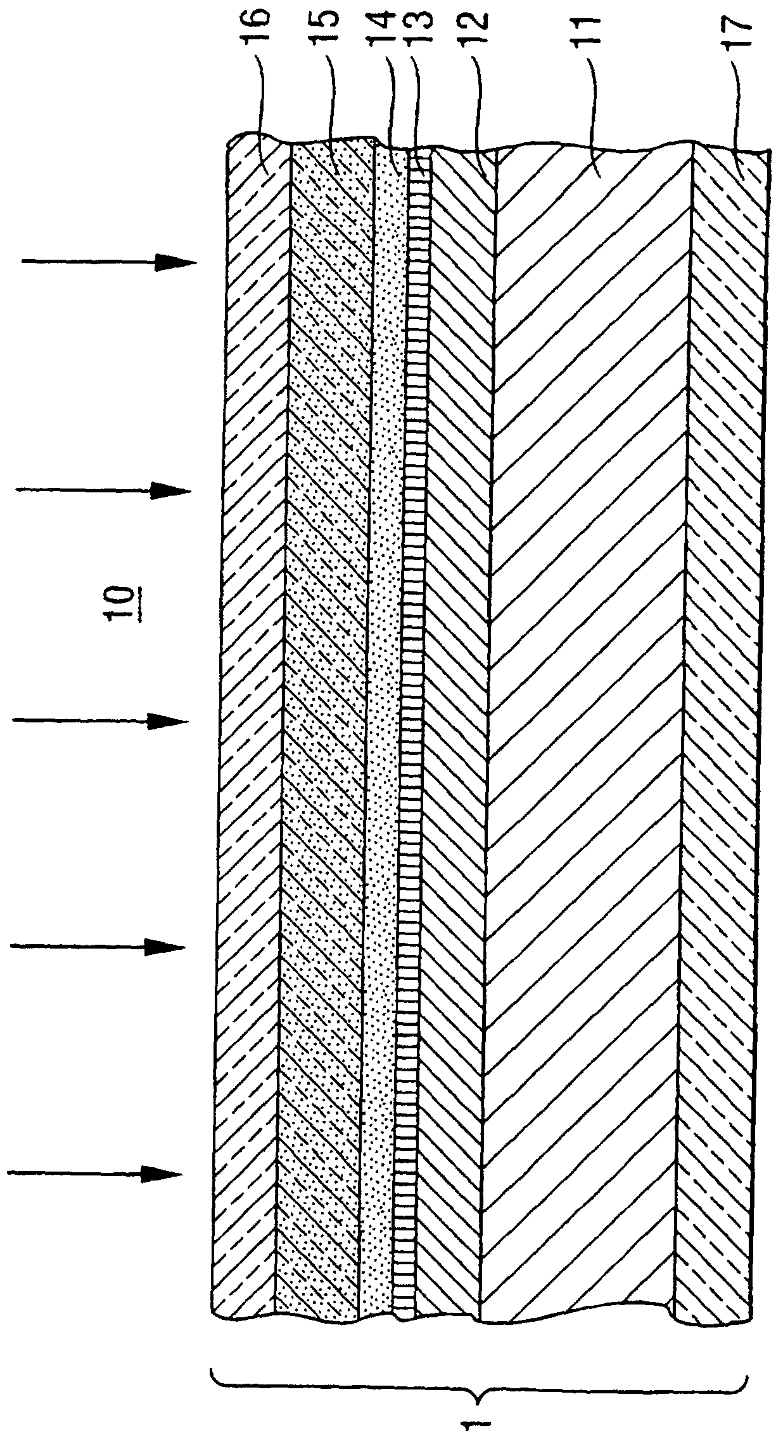


Fig. 1

Fig. 2

IPCE Kurve für die in Beispiel 8 beschriebene Zelle